(19) Europäisches Patentamt
European Patent Office
Office européen des brevets

(11) **EP 2 466 637 A2**

(12) **EUROPEAN PATENT APPLICATION**

(43) Date of publication:
**20.06.2012 Bulletin 2012/25**

(51) Int Cl.:
***H01L 23/473*** (2006.01)

(21) Application number: **11184750.5**

(22) Date of filing: **11.10.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **15.12.2010 JP 2010279575
15.02.2011 JP 2011030215**

(71) Applicant: **Fujitsu Limited
Kawasaki-shi, Kanagawa 211-8588 (JP)**

(72) Inventors:
• **Mizuno, Yoshihiro
Kawasaki-shi, Kanagawa 211-8588 (JP)**
• **Soga, Ikuo
Kawasaki-shi, Kanagawa 211-8588 (JP)**
• **Tsuboi, Osamu
Kawasaki-shi, Kanagawa 211-8588 (JP)**
• **Iwai, Taisuke
Kawasaki-shi, Kanagawa 211-8588 (JP)**

(74) Representative: **Fenlon, Christine Lesley
Haseltine Lake LLP
300 High Holborn
London WC1V 7JH (GB)**

(54) **Semiconductor device, cooling device, and cooling device fabrication method**

(57) A semiconductor device includes a semiconductor chip having an electric circuit; and a cooling device including at least one channel serving as a flow path through which coolant flows, an external surface including projections, and a metallic layer formed over the external surface including the projections. In the semiconductor device, the projections of the external surface of the cooling device are brought into contact with a first surface of the semiconductor chip via the metallic layer such that the semiconductor chip is cooled by allowing the coolant to flow through the channel formed in the cooling device.

FIG.2

**Description**

FIELD

The embodiments discussed herein are related to a semiconductor device, a cooling device and a cooling device fabrication method.

BACKGROUND

A semiconductor device generally includes a semiconductor chip enclosed with a package. Such a packaged semiconductor device appears to generate a large amount of heat due to increased performance, speed and power of the semiconductor chip enclosed in its package.

The heat generated by the semiconductor chip may be controlled by a cooling device such as a fan provided outside the semiconductor device. That is, the fan or the like for cooling the semiconductor chip is arranged outside the package of the semiconductor device. However, this kind of the cooling method of the semiconductor chip may need a large space for arranging a cooling device such as the fan outside the package of the semiconductor device and may also need certain clearances between the fan and the package of the semiconductor device for circulating air flux. As a result, the fabricated semiconductor device as a whole (including the fan) may become large.

Japanese Examined Patent Application Publication No. 07-112036 (hereinafter referred to as "JP-B-07-112036"), Japanese Laid-Open Patent Publication No. 2008-160019 (hereinafter referred to as "JP-A-2008-160019"), and Japanese National Publication of International Patent Application No. 2009-522808 (hereinafter referred to as"JP-T-2009-522808") disclose examples of a technology for cooling the semiconductor chip without utilizing an external cooling device such as a fan arranged outside of the semiconductor device. In these examples, a cooling mechanism for circulating coolant is provided inside the semiconductor device. Such a cooling mechanism may also be called a "microchannel heat sink". With this internal cooling technology, since the cooling mechanism is provided inside the package of the semiconductor device (i.e., the cooling mechanism is provided inside the semiconductor device), the size of the semiconductor device may be reduced compared to the above-described external cooling device example of the semiconductor device utilizing a cooling mechanism (a fan) outside the package of the semiconductor device. Further, in the disclosed examples of the internal cooling technology, the coolant cools the semiconductor chip provided inside the package of the semiconductor device (i.e., the cooling mechanism is arranged close to the semiconductor chip), which exhibits excellent cooling efficiency.

Semiconductor chips for use in semiconductor devices such as high power amplifiers for wireless base stations may be configured to generate higher frequency and higher power of, for example, approximately 50 to 100 W, and hence, such semiconductor chips generally generate large amounts of heat. Since the semiconductor devices containing such semiconductor chips that generate large amounts of heat are not sufficiently cooled by the currently disclosed cooling technologies, high temperatures of the semiconductor chips may not be controlled. As a result, the semiconductor devices exhibit degraded operational efficiency and unstable operations, which may cause the breakdown of the semiconductor devices. For example, in the technology disclosed in JP-A-2008-160019, the cooling mechanism is attached to a semiconductor chip via a conductive pattern of metallic bumps. However, interfaces between the metallic bumps and the cooling mechanism or narrow contacting areas between the metallic bumps and the cooling mechanism may serve as blocking layers to inhibit heat transfer. Thus, the semiconductor chip that generates a large amount of heat may not be sufficiently cooled.

SUMMARY

Accordingly, it is an object in one aspect of the invention to provide a semiconductor device including a cooling device that may be capable of efficiently cooling a semiconductor chip that generates a large amount of heat, such a cooling device and a fabrication method of the cooling device.

According to an aspect of an embodiment, a semiconductor device includes a semiconductor chip embodying an electric circuit, and a cooling device including at least one channel inside the cooling device serving as a flow path through which coolant flows, an external surface including projections and a metallic layer formed over the external surface including the projections. In the semiconductor device, the projections of the external surface of the cooling device are brought into contact with a first surface of the semiconductor chip via the metallic layer such that the semiconductor chip is cooled by allowing the coolant to flow through the channel formed inside the cooling device.

The object and advantages of the invention will be realized and attained by means of the elements and combinations particularly pointed out in the appended claims.

BRIEF DESCRIPTION OF THE DRAWINGS

FIGS. 1A and 1B are structural views illustrating a semiconductor device according to a first embodiment;
FIG. 2 is an explanatory view illustrating the semiconductor device according to the first embodiment;
FIG. 3 is an explanatory view illustrating a cooling device according to the first embodiment;
FIG. 4 is a correlation view illustrating a relationship between the flow rate of coolant and the thermal resistance of coolant;
FIGS. 5A and 5B are first process views illustrating a fabrication method of the semiconductor device according to the first embodiment;
FIGS. 6A and 6B are second process views illustrating the fabrication method of the semiconductor device according to the first embodiment;
FIGS. 7A and 7B are third process views illustrating the fabrication method of the semiconductor device according to the first embodiment;
FIGS. 8A and 8B are fourth process views illustrating the fabrication method of the semiconductor device according to the first embodiment;
FIGS. 9A and 9B are fifth process views illustrating the fabrication method of the semiconductor device according to the first embodiment;
FIGS. 10A and 10B are sixth process views illustrating the fabrication method of the semiconductor device according to the first embodiment;
FIGS. 11A and 11B are seventh process views illustrating the fabrication method of the semiconductor device according to the first embodiment;
FIGS. 12A and 12B are eighth process views illustrating the fabrication method of the semiconductor device according to the first embodiment;
FIGS. 13A and 13B are ninth process views illustrating the fabrication method of the semiconductor device according to the first embodiment;
FIGS. 14A and 14B are tenth process views illustrating the fabrication method of the semiconductor device according to the first embodiment;
FIGS. 15A and 15B are eleventh process views illustrating the fabrication method of the semiconductor device according to the first embodiment;
FIGS. 16A to 16C are twelfth process views illustrating the fabrication method of the semiconductor device according to the first embodiment;
FIGS. 17A to 17C are thirteenth process views illustrating the fabrication method of the semiconductor device according to the first embodiment;
FIGS. 18A to 18C are fourteenth process views illustrating the fabrication method of the semiconductor device according to the first embodiment;
FIGS. 19A to 19C are fifteenth process views illustrating the fabrication method of the semiconductor device according to the first embodiment;
FIGS. 20A to 20C are sixteenth process views illustrating the fabrication method of the semiconductor device according to the first embodiment;
FIGS. 21A to 21C are seventeenth process views illustrating the fabrication method of the semiconductor device according to the first embodiment;
FIGS. 22A to 22C are eighteenth process views illustrating the fabrication method of the semiconductor device according to the first embodiment;
FIGS. 23A to 23C are nineteenth process views illustrating the fabrication method of the semiconductor device according to the first embodiment;
FIG. 24 is an explanatory view illustrating a cooling device according to a second embodiment;
FIG. 25 is an explanatory view illustrating a cooling device according to a third embodiment;
FIG. 26 is another explanatory view illustrating the cooling device according to the third embodiment;
FIGS. 27A and 27B are explanatory views illustrating a semiconductor device according to a fourth embodiment;
FIG. 28 is a top view looking inside the semiconductor device according to the fourth embodiment;
FIG. 29 is a perspective view illustrating a cooling device according to the fourth embodiment;
FIGS. 30A to 30C are explanatory views illustrating the cooling device according to the fourth embodiment;
FIGS. 31A to 31C are first process views illustrating a fabrication method of the semiconductor device according to the fourth embodiment;
FIGS. 32A to 32D are second process views illustrating the fabrication method of the semiconductor device according to the fourth embodiment;

**EP 2 466 637 A2**

FIGS. 33A to 33D are third process views illustrating the fabrication method of the semiconductor device according to the fourth embodiment;

FIGS. 34A to 34D are fourth process views illustrating the fabrication method of the semiconductor device according to the fourth embodiment;

FIGS. 35A to 35D are fifth process views illustrating the fabrication method of the semiconductor device according to the fourth embodiment;

FIGS. 36A to 36D are sixth process views illustrating the fabrication method of the semiconductor device according to the fourth embodiment;

FIGS. 37A to 37D are seventh process views illustrating the fabrication method of the semiconductor device according to the fourth embodiment;

FIGS. 38A to 38D are eighth process views illustrating the fabrication method of the semiconductor device according to the fourth embodiment;

FIGS. 39A to 39D are ninth process views illustrating the fabrication method of the semiconductor device according to the fourth embodiment;

FIGS. 40A to 40D are tenth process views illustrating the fabrication method of the semiconductor device according to the fourth embodiment;

FIGS. 41A to 41D are eleventh process views illustrating the fabrication method of the semiconductor device according to the fourth embodiment;

FIGS. 42A to 42C are twelfth process views illustrating the fabrication method of the semiconductor device according to the fourth embodiment;

FIGS. 43A to 43C are thirteenth process views illustrating the fabrication method of the semiconductor device according to the fourth embodiment;

FIGS. 44A to 44C are fourteenth process views illustrating the fabrication method of the semiconductor device according to the fourth embodiment;

FIGS. 45A to 45C are fifteenth process views illustrating the fabrication method of the semiconductor device according to the fourth embodiment;

FIGS. 46A and 46B are sixteenth process views illustrating the fabrication method of the semiconductor device according to the fourth embodiment;

FIGS. 47A and 47B are seventeenth process views illustrating the fabrication method of the semiconductor device according to the fourth embodiment;

FIG. 48 is an eighteenth process view illustrating the fabrication method of the semiconductor device according to the fourth embodiment;

FIG. 49 is a structural view illustrating a cooling device according to a fifth embodiment;

FIGS. 50A to 50C are first process views illustrating a fabrication method of the semiconductor device according to the fifth embodiment;

FIGS. 51A to 51C are second process views illustrating the fabrication method of the semiconductor device according to the fifth embodiment;

FIGS. 52A to 52C are third process views illustrating the fabrication method of the semiconductor device according to the fifth embodiment;

FIGS. 53A to 53C are fourth process views illustrating the fabrication method of the semiconductor device according to the fifth embodiment;

FIGS. 54A to 54C are fifth process views illustrating the fabrication method of the semiconductor device according to the fifth embodiment;

FIGS. 55A to 55C are sixth process views illustrating the fabrication method of the semiconductor device according to the fifth embodiment;

FIGS. 56A to 56D are seventh process views illustrating the fabrication method of the semiconductor device according to the fifth embodiment;

FIGS. 57A to 57D are eighth process views illustrating the fabrication method of the semiconductor device according to the fifth embodiment;

FIGS. 58A to 58C are ninth process views illustrating the fabrication method of the semiconductor device according to the fifth embodiment;

FIGS. 59A to 59C are tenth process views illustrating the fabrication method of the semiconductor device according to the fifth embodiment;

FIG. 60 is a structural view illustrating modification of the cooling device according to the fifth embodiment;

FIG. 61 is a structural view illustrating a cooling device according to a sixth embodiment;

FIGS. 62A to 62C are first process views illustrating a fabrication method of the semiconductor device according to the sixth embodiment;

FIGS. 63A to 63C are second process views illustrating the fabrication method of the semiconductor device according

4

to the sixth embodiment;

FIGS. 64A to 64C are third process views illustrating the fabrication method of the semiconductor device according to the sixth embodiment;

FIGS. 65A to 65C are fourth process views illustrating the fabrication method of the semiconductor device according to the sixth embodiment;

FIGS. 66A to 66C are fifth process views illustrating the fabrication method of the semiconductor device according to the sixth embodiment;

FIGS. 67A to 67C are sixth process views illustrating the fabrication method of the semiconductor device according to the sixth embodiment;

FIGS. 68A to 68C are seventh process views illustrating the fabrication method of the semiconductor device according to the sixth embodiment;

FIG. 69 is a structural view illustrating modification of the cooling device according to the sixth embodiment;

FIG. 70 is a structural view illustrating a cooling device according to a seventh embodiment;

FIGS. 71A to 71C are first process views illustrating a fabrication method of the semiconductor device according to the seventh embodiment;

FIGS. 72A to 72C are second process views illustrating the fabrication method of the semiconductor device according to the seventh embodiment;

FIGS. 73A to 73C are third process views illustrating the fabrication method of the semiconductor device according to the seventh embodiment;

FIGS. 74A to 74C are fourth process views illustrating the fabrication method of the semiconductor device according to the seventh embodiment;

FIGS. 75A to 75C are fifth process views illustrating the fabrication method of the semiconductor device according to the seventh embodiment;

FIGS. 76A to 76C are sixth process views illustrating the fabrication method of the semiconductor device according to the seventh embodiment;

FIGS. 77A to 77C are first structural views illustrating another cooling device according to the seventh embodiment;

FIGS. 78A and 78B are second structural views illustrating another cooling device according to the seventh embodiment;

FIGS. 79A and 79B are third structural views illustrating another cooling device according to the seventh embodiment;

FIGS. 80A and 80B are fourth structural views illustrating another cooling device according to the seventh embodiment; and

FIG. 81 is a fifth structural view illustrating another cooling device according to the seventh embodiment.

## DESCRIPTION OF EMBODIMENTS

A description is given, with reference to the accompanying drawings, of embodiments of the present invention. Note that identical components are provided with the same reference numerals and repeated descriptions of the same components are omitted.

[FIRST EMBODIMENT]

(SEMICONDUCTOR DEVICE)

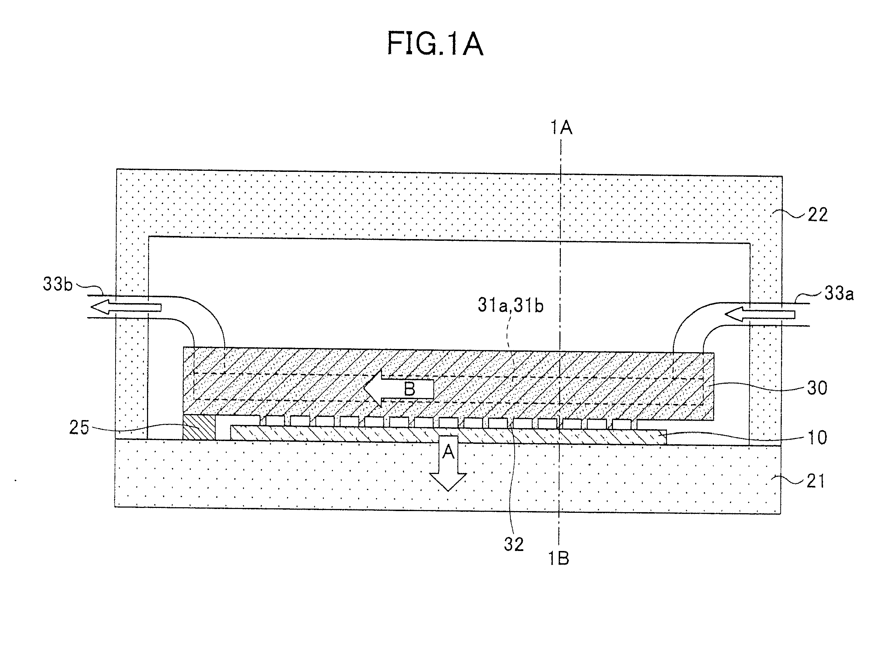

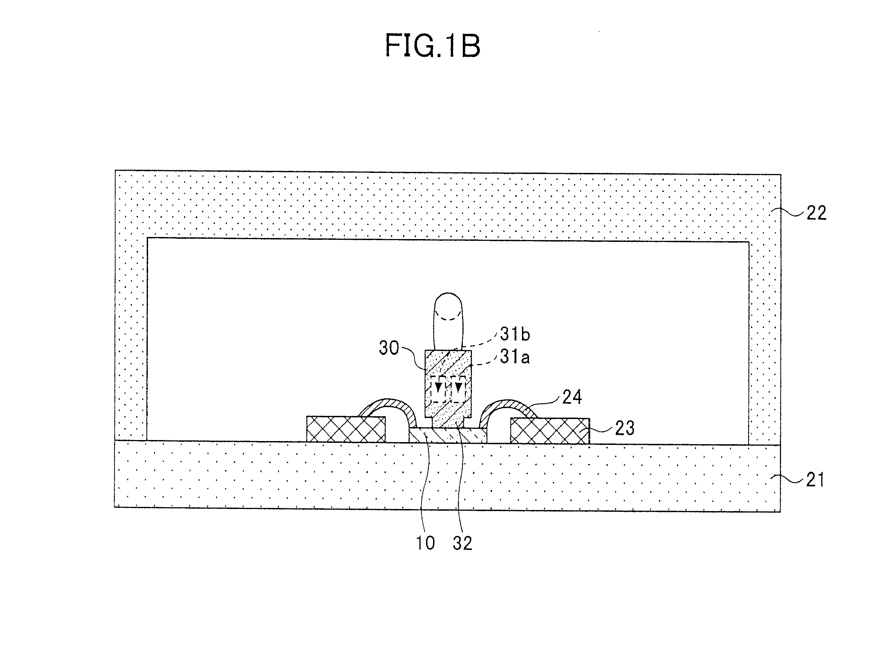

First, a semiconductor device and a cooling device according to a first embodiment are described with reference to FIGS. 1A and 1B. FIG. 1A is a structural view illustrating internal components of the semiconductor device according to the first embodiment, and FIG. 1B is a sectional view taken along a dash-dot line 1A-1B of FIG. 1A of the semiconductor device according to the first embodiment.

The semiconductor device according to the first embodiment includes a semiconductor chip 10 covered with a package 21 and a lid 22 such that one surface of the semiconductor chip 10 comes into contact with the package 21. The package 21 is formed of a metallic material having a three-layered structure (i.e., a Cu-Mo-Cu (copper-molybdenum-copper) layered structure)such that heat generated by the semiconductor chip 10 is partially discharged via the package 21 in a direction indicated by an arrow "A" of FIG. 1A. Note that since the semiconductor chip 10 embodies an electronic circuit (not illustrated), operations of the electronic circuit cause the semiconductor chip 10 to generate heat. That is, if the semiconductor chip 10 is for use in a high power amplifier for a wireless base station and the like, the semiconductor chip 10 generates high temperatures by operations of the electronic circuit. Examples of such a semiconductor chip 10 include those having output power of several W or more, those having output power of 10 W or more, and those having output power of 50 W or more. The higher the output power of the semiconductor chip 10 is, the greater amount of heat the semiconductor chip 10 may generate, and the higher temperature the semiconductor chip 10 may become. In the semiconductor device according to the first embodiment, the lid 22 is formed of a metallic material such as copper (Cu) and the like. Note that the package 21 and the lid 22 may be formed of materials other than such metallic materials. The package 21 and the lid 22 may be formed of ceramic materials such as alumina or resin materials having high heat transfer.

Further, a microchannel heat sink 30 serving as a cooling device according to the first embodiment is arranged on the other surface of the semiconductor chip 10. The microchannel heat sink 30 includes flow paths formed of two channels 31a and 31b configured to allow coolant, such as water, having fluidity to flow in a direction indicated by an arrow B of FIG. 1A inside the semiconductor device according to the first embodiment. The coolant flowing through the two channels 31a and 31b is supplied from a supply port 33a provided outside the lid 22. The coolant supplied via the supply port 33a flows through the channels 31a and 31b provided in the microchannel heat sink 30 and the coolant having flowed through the channels 31a and 31b is then discharged from a discharge port 33b provided outside the lid 22. Further, the microchannel heat sink 30 includes a surface that comes into contact with the semiconductor chip 10, and projections 32 are formed on that surface of the microchannel heat sink 30 at positions corresponding to later-described source electrodes formed on the semiconductor chip 10. Moreover, a gold-plated layer (not illustrated) is formed on the surface of the microchannel heat sink 30 on which the projections 32 are formed (i.e., the gold-plated layer is formed on the "projection 32 formed surface" of the microchannel heat sink 30). Accordingly, the gold-plated layer formed on the projection 32 formed surface of the microchannel heat sink 30 is also brought into contact with a grounding terminal 25 arranged on the package 21.

Note that in the semiconductor device according to the first embodiment, the package 21 includes matching circuits 23 such that electrode terminals (not illustrated) provided on the other surface (or outer edges of the surface) of the semiconductor chip 10 and electrode terminals (not illustrated) provided on the matching circuits 23 are connected with bonding wires 24.


(COOLING DEVICE)

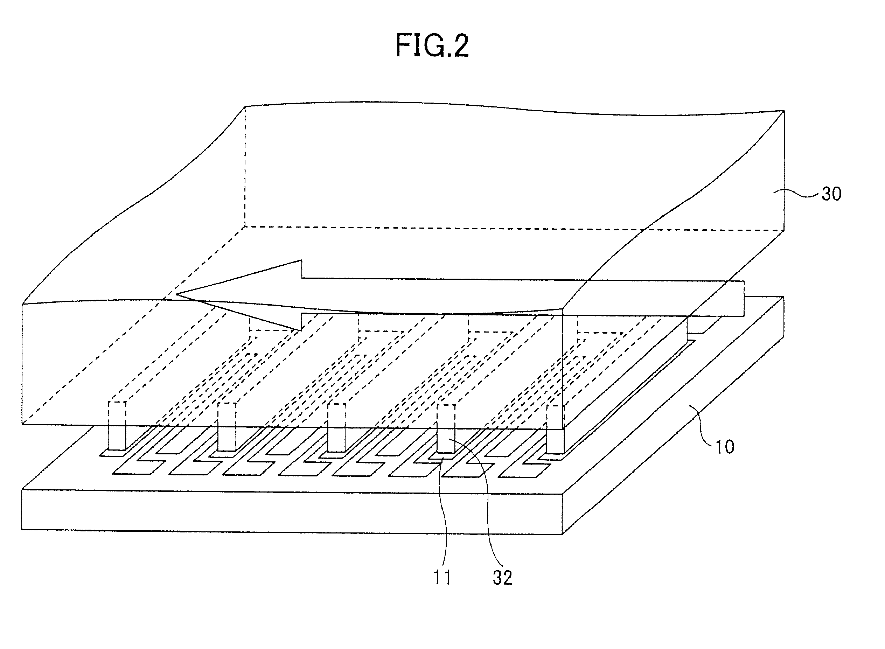

Next, a cooling device according to a first embodiment is described. As illustrated in FIG. 2, the microchannel heat sink 30 utilized as the cooling device according to the first embodiment is made of silicon. As described earlier, the microchannel heat sink 30 includes the surface that comes into contact with the semiconductor chip 10, and the plural projections 32 are formed on that surface of the microchannel heat sink 30. The projections 32 are formed on the surface of the microchannel heat sink 30 at the positions corresponding to electrodes 11 formed on the semiconductor chip 10 in the following manner. The projections 32 are initially aligned with the source electrodes 11 formed on the semiconductor chip 10, and the projections 32 formed on the microchannel heat sink 30 and the source electrodes 11 formed on the semiconductor chip 10 are then brought into contact with one another. As a result, heat generated by the semiconductor chip 10 is transferred from the source electrodes 11 via the projections 32 of the microchannel heat sink 30 to the interior of the microchannel heat sink 30, and further to coolant flowing through the channels 31a and 31b of the microchannel heat sink 30. The coolant is discharged from the discharge port 33b. While the coolant is discharged from the discharge port 33b, the heat transferred to the coolant is also discharged together with the coolant. Accordingly, the semiconductor chip 10 may be efficiently cooled by the discharge of the coolant with the heat. In the cooling device according to the first embodiment, the projections 32 are formed as part of the microchannel heat sink 30. Accordingly, there are no blocking layers for inhibiting heat transfer between the projections 32 and the microchannel heat sink 30. As a result, the semiconductor chip 10 may be effectively and efficiently cooled without inhibitors in heat transfer.

Note that the microchannel heat sink 30 serving as the cooling device according to the first embodiment is made of silicon. However, the microchannel heat sink 30 may be formed of semiconductor materials such as silicon carbide (SiC), metallic materials such as copper (Cu) and aluminum (Al) insofar as the materials may form the channels 31a and 31b. Further, in the cooling device according to the first embodiment, water is utilized as the coolant. However, the coolant may be any fluids insofar as the fluids have fluidity. Examples of the fluid utilized as the coolant include liquids including water, methanol, ethanol, isopropyl alcohol (IPA), and Fluorinert (registered trademark).

Moreover, the microchannel heat sink 30 serving as the cooling device according to the first embodiment includes the surface provided with the projections 32, and the gold-plated layer (not illustrated metallic plated layer) is formed on the projection 32 formed surface of the microchannel heat sink 30. Fore-ends of the projections 32 on which the gold-plated layer is formed are brought into contact with the source electrodes 11 formed on the semiconductor chip 10 such that the gold-plated layer formed on the fore-ends of the projections 32 are electrically coupled with the source electrodes 11 formed on the semiconductor chip 10. Further, as illustrated earlier, the gold-plated layer formed on the surface of the microchannel heat sink 30 is brought into contact with the grounding terminal 25 provided on the package 21. Thus, the gold-plated layer formed on the surface of the microchannel heat sink 30 is also electrically coupled with the grounding terminal 25 provided on the package 21. As a result, the source electrodes 11 formed on the semiconductor chip 10 and the grounding terminal 25 provided on the package 21 are electrically coupled via the gold-plated layer. That is, in the microchannel heat sink 30 serving as the cooling device according to the first embodiment, the source electrodes 11 formed on the semiconductor chip 10 are electrically coupled with the grounding terminal 25 while the semiconductor chip 10 is being cooled. As described above, the gold-plated layer is formed of a metallic material and the gold-plated layer includes high heat transfer in addition to electrical conductivity. Accordingly, a greater amount of heat generated by the semiconductor chip 10 may be transferred to the surface of the microchannel heat sink 30 on which the projections 32 are formed. That is, since the metallic materials have high electrical conductivity and high heat transfer, heat generated by the semiconductor chip 10 is quickly transferred from the source electrodes 11 formed on the semiconductor chip 10 to the projections 32 of the microchannel heat sink 30 on the surface of which the gold-plated layer is formed. Further, since the gold-plated layer having high heat transfer is formed on the surface of the microchannel heat sink 30 on which the projections 32 are formed (i.e., the gold-plated layer is formed on the projection formed surface of the microchannel heat sink), heat generated by the semiconductor chip 10 may be quickly and uniformly transferred to the surface of the microchannel heat sink 30 on which the projections 32 are formed. Examples of the metallic materials utilized as the metallic plated layer include copper (Cu), silver (Ag) and aluminum (Al), metallic alloys of Cu, Ag and Al, metallic alloys or film stacks of gold (Au) and Cu, Ag, and Al, or other the materials containing gold.

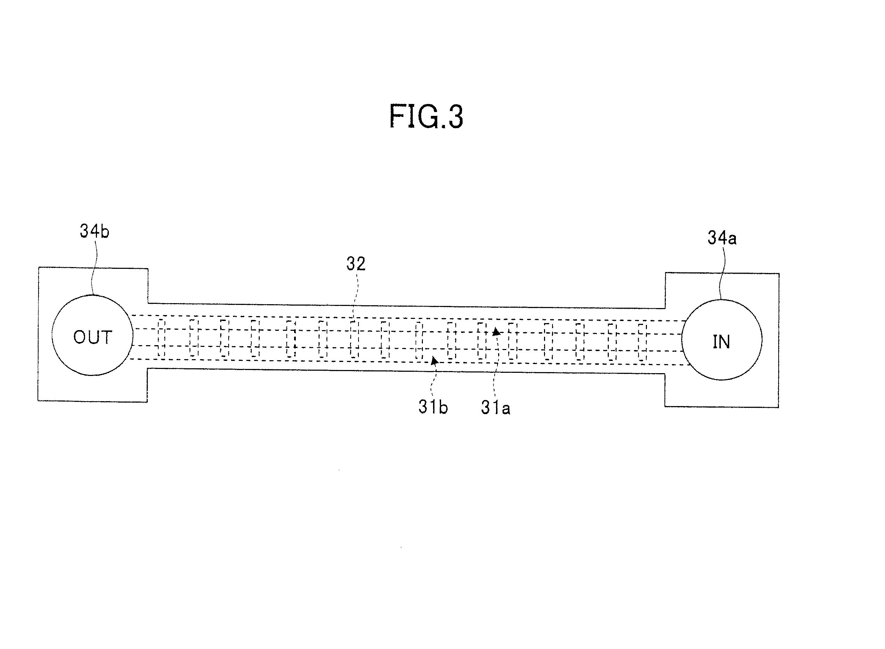

Next, the microchannel heat sink 30 serving as the cooling device according to the first embodiment is described in more detail with reference to FIG. 3. As illustrated earlier, the microchannel heat sink 30 is fabricated by processing silicon, and the two channels 31a and 31b are formed inside the microchannel heat sink 30. Since the two channels 31a and 31b are formed inside the microchannel heat sink 30, the microchannel heat sink 30 may include portions (channels 31a and 31b) having increased cross sectional areas for allowing the coolant to flow while maintaining mechanical strength of the microchannel heat sink 30. With this configuration, the coolant may be running through the channels 31a and 31b at a predetermined flow rate or higher.

Further, a channel inlet 34a and a channel outlet 34b are provided one on each end of the channels 31a and 31b of the microchannel heat sink 30. Thus, the coolant supplied from the supply port 33a provided outside the lid 22 is supplied via the channel inlet 34a of the microchannel heat sink 30 into channels 31a and 31b such that the coolant flows through the channels 31a and 31b formed inside the microchannel heat sink 30. The coolant flowing through the channels 31a and 31b absorbs the heat generated by the semiconductor chip 10 and the coolant absorbing the heat generated by the semiconductor device 10 is then discharged via the channel outlet 34b from the discharge port 33b provided outside the lid 22. As a result, the semiconductor chip 10 may be cooled by allowing the coolant to absorb the heat generated by the semiconductor chip 10 and then discharging the coolant that has absorbed the heat generated by the semiconductor chip 10.

Next, a description is given of a relationship between a flow rate and thermal resistance TR of the coolant that is flowing through the channels 31a and 31b of the microchannel heat sink 30 serving as the cooling device according to the first embodiment. The thermal resistance TR is represented by the following equation (1), where Ta denotes the temperature of the coolant, Tb denotes the temperature of the projection 32 of the microchannel heat sink 30 and P denotes the amount of heat generated by the semiconductor chip 10.

$$TR = (Tb - Ta)/P(C°/W) \cdots\cdots (1)$$

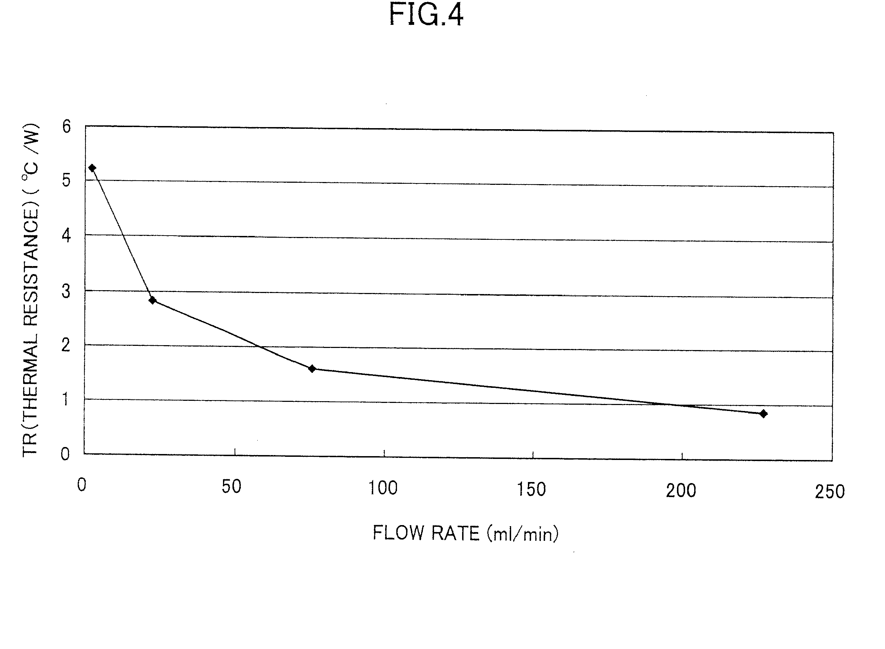

FIG. 4 illustrates a relationship between the flow rate and the thermal resistance TR of the coolant that flows through one channel. As illustrated in FIG. 4, the thermal resistance of the coolant is lowered with an increase in the flow rate of the coolant.

Next, a result of simulation carried out on the semiconductor device according to the first embodiment is described. Note that in this simulation of the semiconductor device according to the first embodiment, the semiconductor chip 10 has an external shape of a width 420 μm * a length 7650 μm * a height 880 μm, and the amount of heat generated by the semiconductor chip 10 is 50 W. Further, the two channels 31a and 31b of the microchannel heat sink 30 each have a width of 60 μm and a height of 350 μm, and 61 projections 32 having a height of 20 μm are provided outside the microchannel heat sink 30. The projections 32 are brought into contact with the source electrodes 11 formed on the semiconductor chip 10, and water serving as the coolant is running through the channels 31a and 31b of the microchannel heat sink 30 at a flow rate of 150 ml/min. As a result, the lowest temperature obtained among the projections 32 of the microchannel heat sink 30 is 44°C and the highest temperature obtained is 99°C. Thus, the difference between the highest temperature and the lowest temperature obtained among the projections 32 of the microchannel heat sink 30 is 55°C.

(FABRICATION METHOD)

Next, a method for fabricating a cooling device according to the first embodiment is described. The microchannel heat sink 30 serving as the cooling device according to the first embodiment may be formed by fabricating a silicon (Si) substrate or the like. The microchannel heat sink 30 is fabricated by initially forming a lower portion 50 and an upper portion 70 separately and then connecting the separately formed lower portion 50 and upper portion 70.

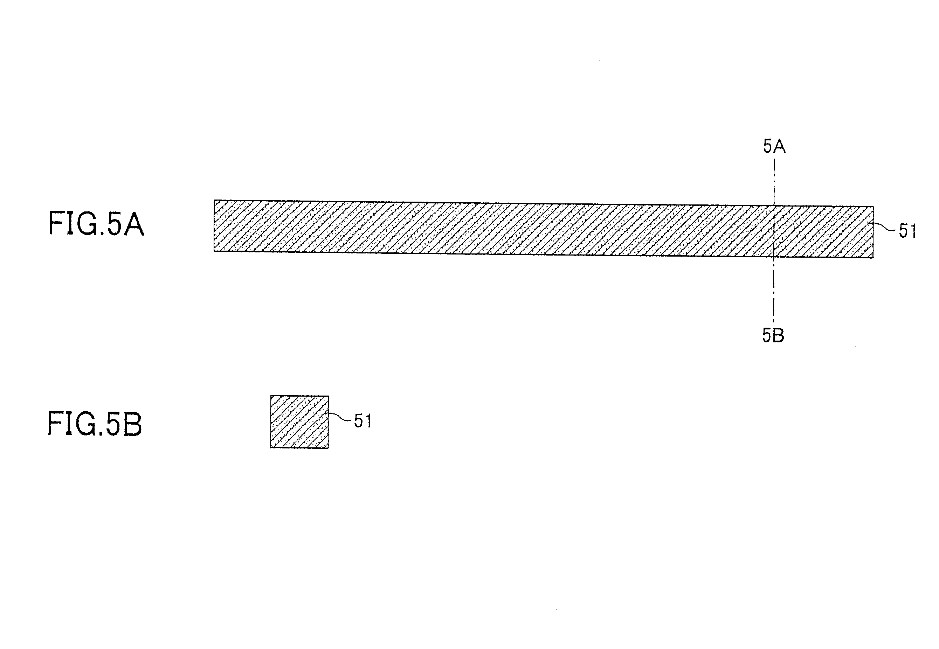

First, the lower portion 50 of the microchannel heat sink 30 is formed. More specifically, a silicon substrate or the like is processed into a quadrangular prism configuration, thereby forming a silicon base 51 as illustrated in FIGS. 5A and 5B. The silicon base 51 may be doped with various impurity elements. For example, the silicon base 51 may be doped with a p-type impurity such as boron (B) or a n-type impurity such as phosphorus (P) or antimony (Sb). In the first embodiment, the silicon base 51 is fabricated by processing a silicon substrate into a quadrangular prism configuration having a thickness range of 200 to 525 $\mu$m. FIG. 5A is a sectional view in a direction of channels to be formed, and FIG. 5B is a sectional view taken along a dash-dot line 5A-5B of FIG. 5A.

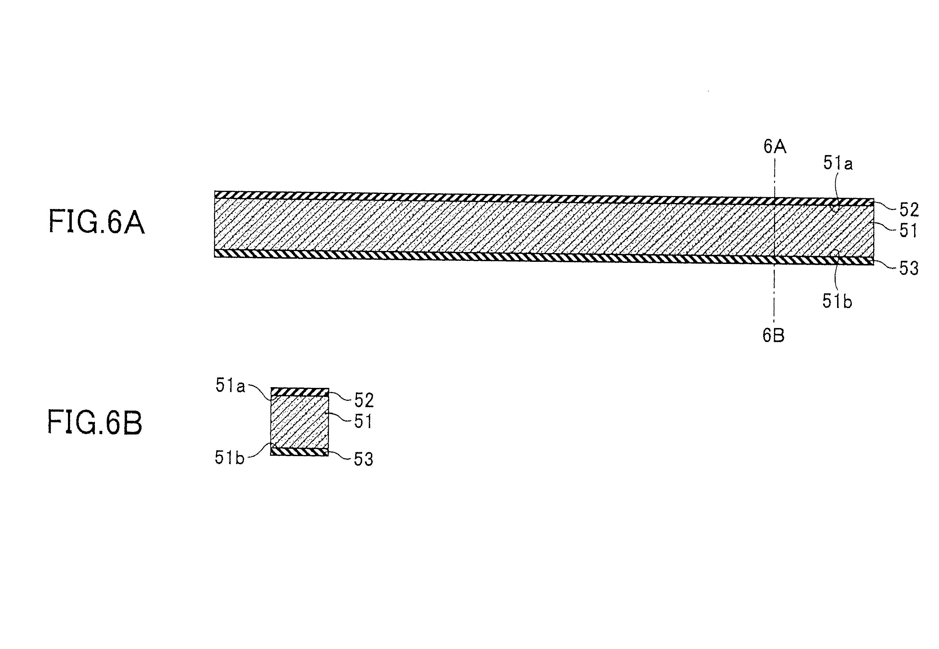

Next, in the silicon base 51, oxide films 52 and 53 are formed by thermally oxidizing a first surface 51a and a second surface 51b opposing the first surface 51a or by depositing an $SiO_2$ film on the first surface 51a and the second 51b as illustrated in FIGS. 6A and 6B. The first surface 51a and the second surface 51b of the silicon base 51 are processed for forming the channels of the microchannel heat sink 30. FIG. 6A is a sectional view in a direction of the channels to be formed, and FIG. 6B is a sectional view taken along a dash-dot line 6A-6B of FIG. 6A.

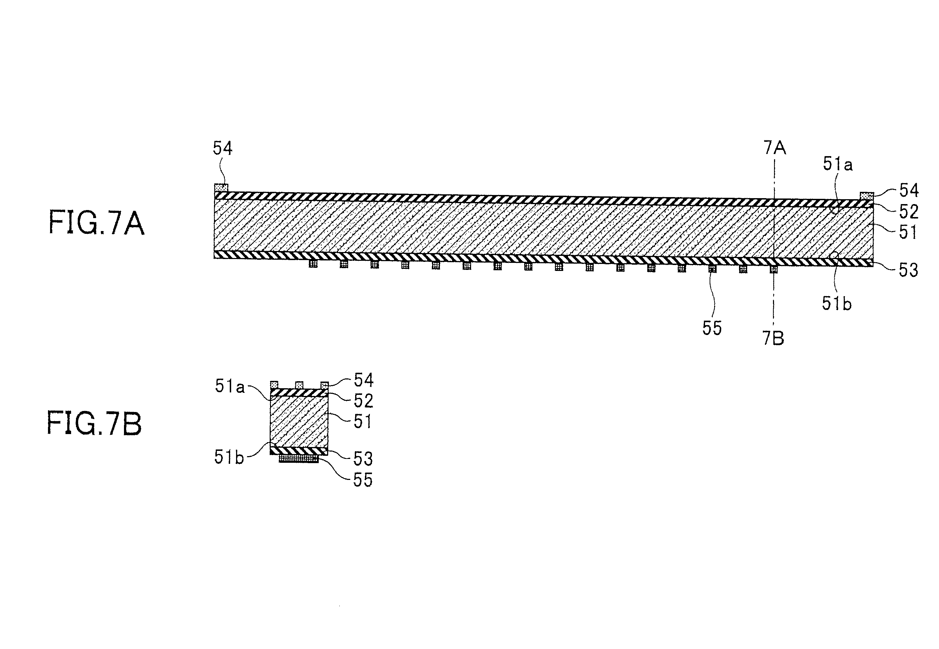

Next, a resist pattern 54 is formed on the oxide film 52 formed on the first surface 51a of the silicon base 51 and a resist pattern 55 is formed on the oxide film 53 formed on the second surface 51b of the silicon base 51 as illustrated in FIGS. 7A and 7B. Specifically, a photoresist is applied to the oxide film 52, and the photoresist applied oxide film 52 is then exposed to light for performing the development utilizing an exposure device, thereby forming the resist pattern 54 having openings corresponding to regions where channels 31a and 31b are formed. Likewise, a photoresist is applied to the oxide film 53, and the photoresist applied oxide film 53 is then exposed to light for performing the development utilizing the exposure device, thereby forming the resist pattern 55 in a region where projections 32 are formed. FIG. 7A is a sectional view in a direction of the channels to be formed, and FIG. 7B is a sectional view taken along a dash-dot line 7A-7B of FIG. 7A.

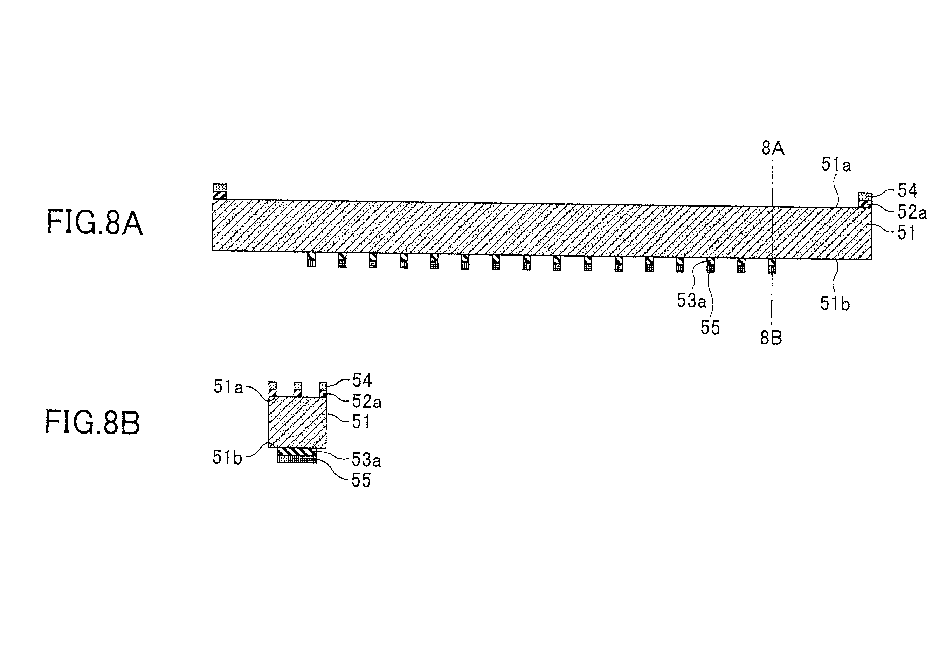

Next, the oxide film 52 corresponding to the openings of the resist pattern 54 and the oxide film 53 corresponding to openings of the resist pattern 55 are removed by reactive ion etching (RIE) as illustrated in FIGS. 8A and 8B. As a result, the silicon base 51 is exposed from the opening regions of the resist patterns 54 and 55 and oxide film patterns 52a and 53a are formed in the regions where the resist patterns 54 and 55 are formed. Note that FIG. 8A is a sectional view in a direction of the channels to be formed, and FIG. 8B is a sectional view taken along a dash-dot line 8A-8B of FIG. 8A.

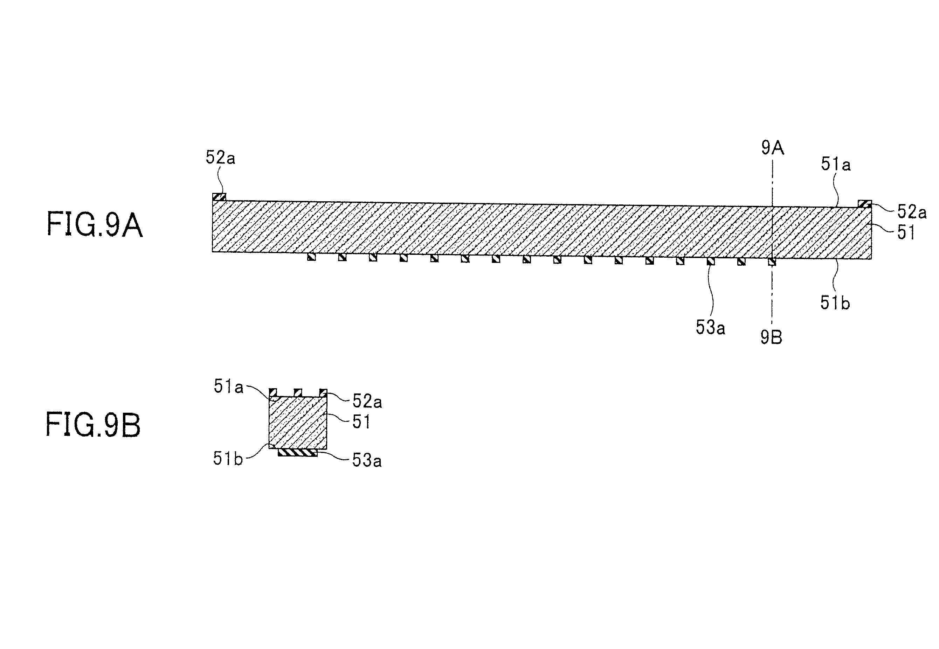

Next, the resist patterns 54 and 55 are removed with an organic solvent, or the like as illustrated in FIGS. 9A and 9B. As a result, the oxide film pattern 52a formed on the first surface 51a of the silicon base 51 and the oxide pattern 53a formed on the second surface 51b of the silicon base 51 are exposed. FIG. 9A is a sectional view in a direction of the channels to be formed, and FIG. 9B is a sectional view taken along a dash-dot line 9A-9B of FIG. 9A.

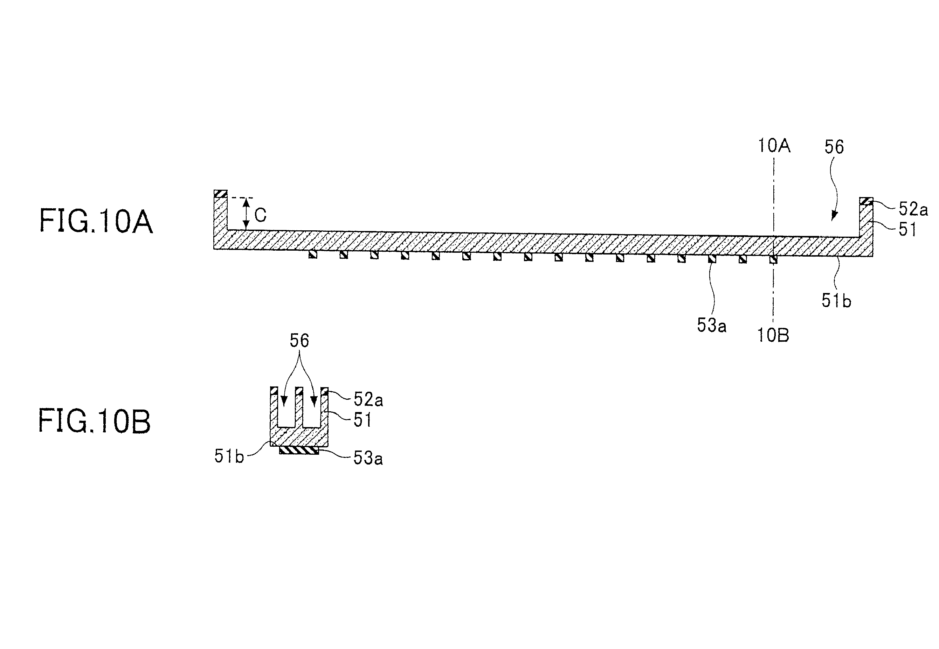

Next, opening regions 56 forming the channels 31a and 31b are formed in the first surface 51a of the silicon base 51 by deep reactive ion etching (DRIE) utilizing the oxide film pattern 52a as a mask as illustrated in FIGS. 10A and 10B. In the DRIE, an etching process where the silicon base 51 is etched by introducing a sulfur hexafluoride ($SF_6$) gas, and a protection process where a side wall of the etched region is protected by introducing an octafluorocyclobutane ($C_4F_8$) gas are repeatedly carried out. Hence, high rate anisotropic etching may be carried out by the DRIE. Note that the DRIE may also be called a Bosch process. Thus, the opening regions 56 are formed by removing portions of the silicone base 51 on which the oxide film pattern 52a is not formed in a direction approximately perpendicular to the first surface 51a of the silicon base 51. In the first embodiment, the opening regions 56 are formed in the silicon base 51 such that the opening regions 56 include a depth of 350 $\mu$m. Note that FIG. 10A is a sectional view in a direction of the channels to be formed, and FIG. 10B is a sectional view taken along a dash-dot line 10A-10B of FIG. 10A.

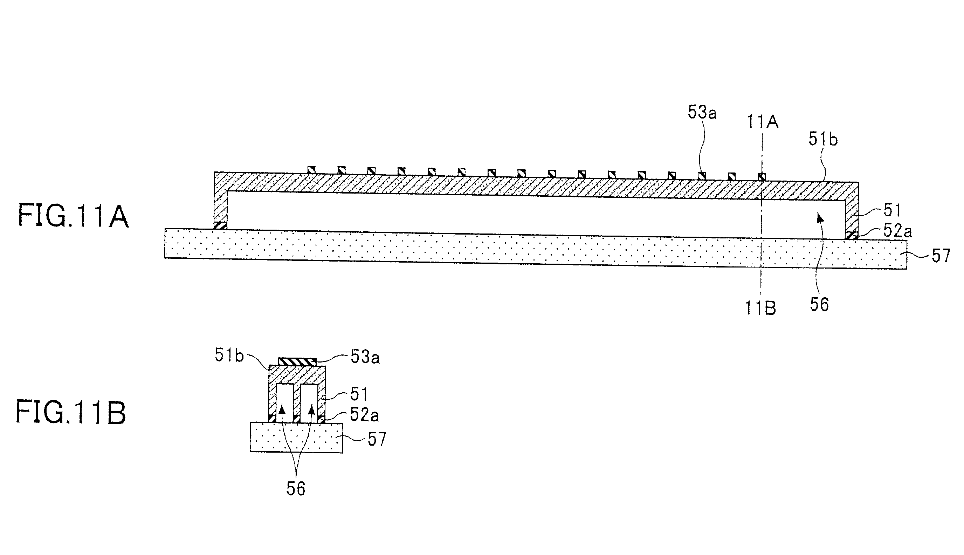

Next, a thermal ablation sheet 57 is adhered to the oxide film pattern 52a on the opening region 56 side of the silicon base 51 as illustrated in FIGS. 11A and 11B. As a result, a portion of the opening regions 56 forming the channels 31a and 31b are provided with protection. Note that FIG. 11A is a sectional view in a direction of the channels to be formed, and FIG. 11B is a sectional view taken along a dash-dot line 11A-11B of FIG. 11A.

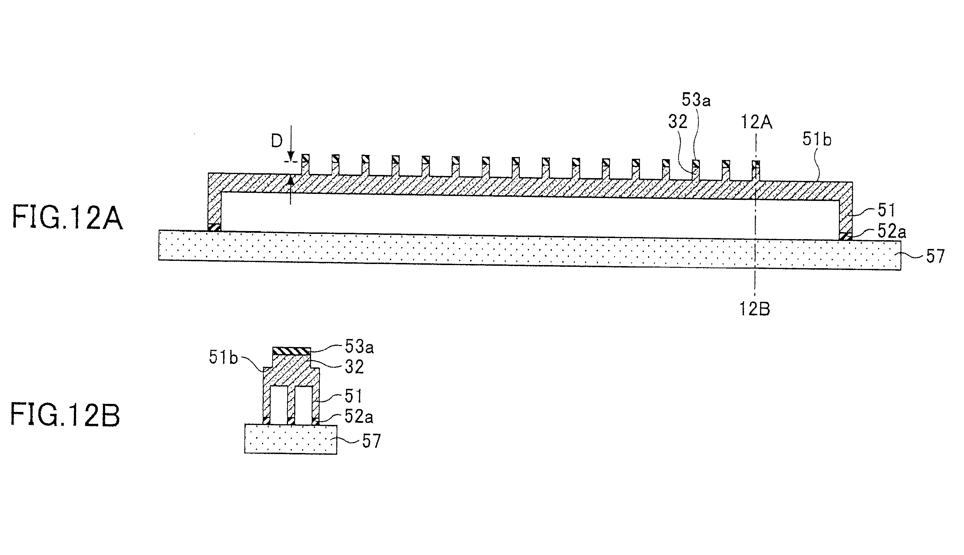

Next, projections 32 are formed on the second surface 51b of the silicon base 51 by deep reactive ion etching (DRIE) utilizing the oxide film pattern 53a as a mask as illustrated in FIGS. 12A and 12B. Specifically, the projections 32 are formed on the second surface 51b of the silicon base 51 by removing portions of the silicon base 51 where the oxide film pattern 53a is not formed. Since the portions of the silicon base 51 to be removed have a thickness of approximately 20 $\mu$m in this case, the projections having a height of 20 $\mu$m are formed on the second surface 51b of the silicon base 51. Note that FIG. 12A is a sectional view in a direction of the channels to be formed, and FIG. 12B is a sectional view taken along a dash-dot line 12A-12B of FIG. 12A.

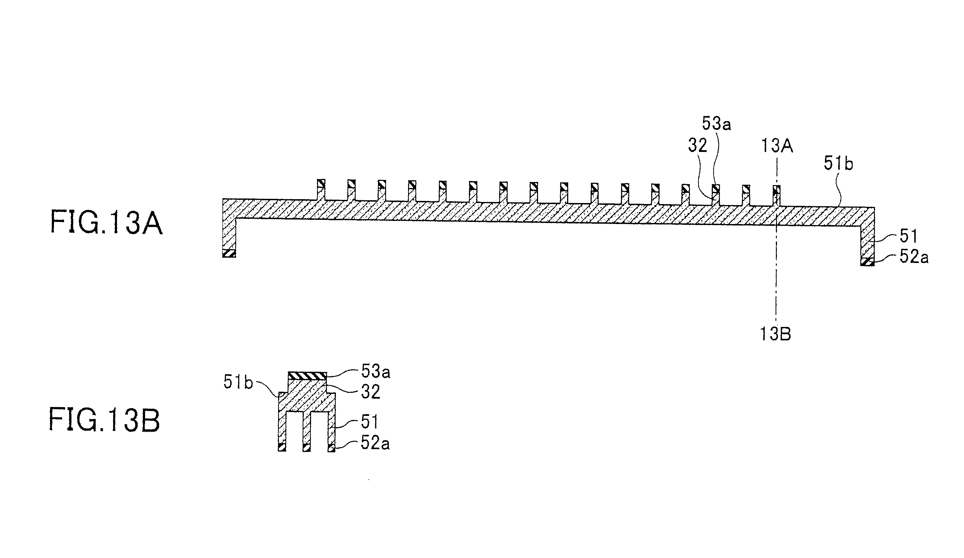

Next, the thermal ablation sheet 57 is removed by heating as illustrated in FIGS. 13A and 13B. Note that FIG. 13A is a sectional view in a direction of the channels to be formed, and FIG. 13B is a sectional view taken along a dash-dot line 13A-13B of FIG. 13A.

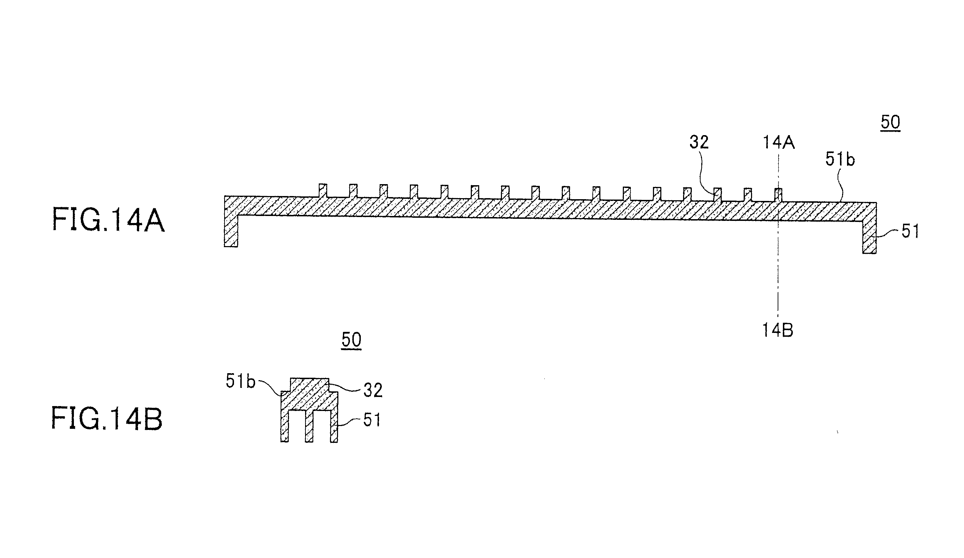

Next, the oxide film patterns 52a and 53a are removed as illustrated in FIGS. 14A and 14B. Thus, the lower portion 50 of the microchannel heat sink 30 is formed. Note that FIG. 14A is a sectional view in a direction of the channels to be formed, and FIG. 14B is a sectional view taken along a dash-dot line 14A-14B of FIG. 14A.

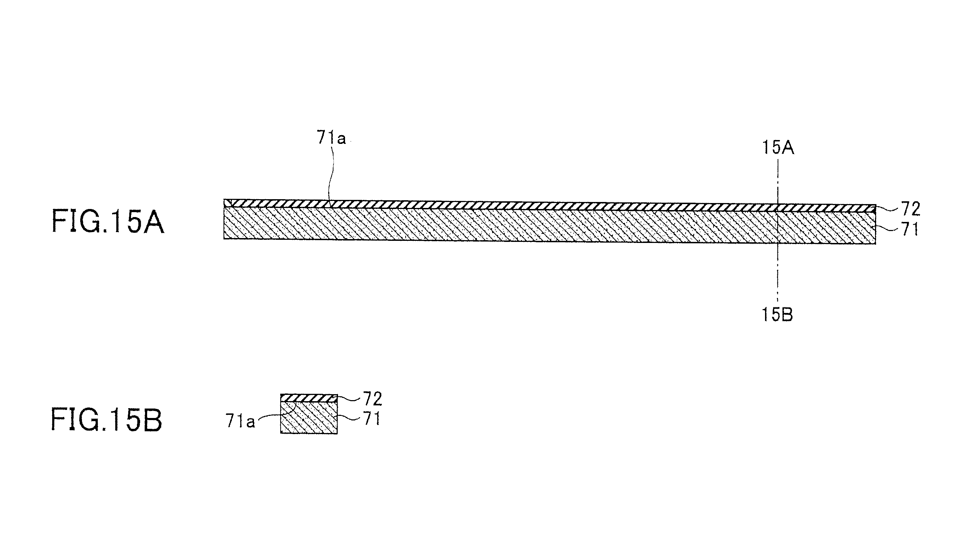

Next, an upper portion 70 of the microchannel heat sink 30 serving as the cooling device according to the first embodiment is formed. Specifically, an oxide film 72 is formed by depositing a thermally-oxidized film or a $SiO_2$ film on a first surface 71a of a silicon base 71 in which the channels 31a and 31b are formed as illustrated in FIGS. 15A and 15B. Note that FIG. 15A is a sectional view in a direction of the channels to be formed, and FIG. 15B is a sectional view taken along a dash-dot line 15A-15B of FIG. 15A.

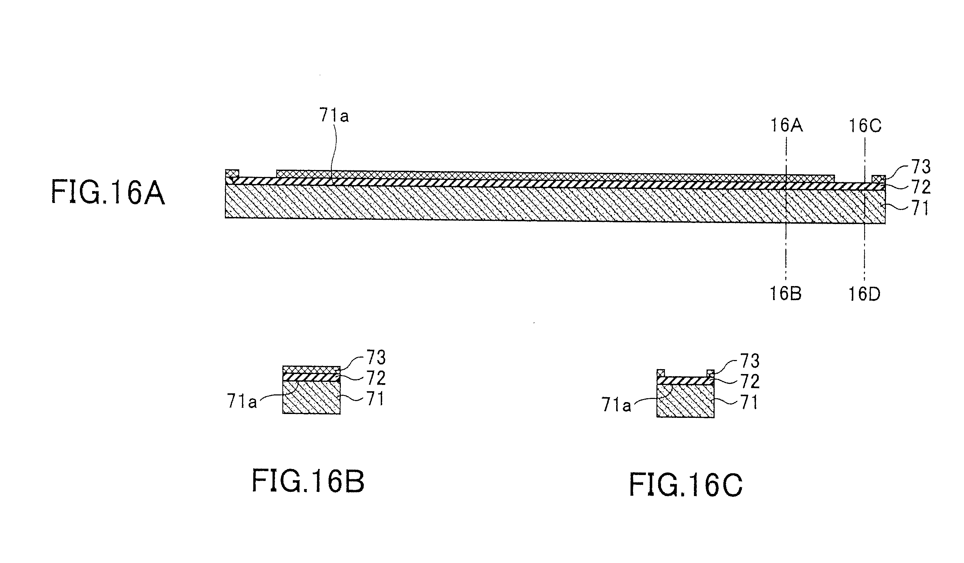

Next, a resist pattern 73 is formed on the oxide film 72 as illustrated in FIGS. 16A to 16C. Specifically, a photoresist is applied to the oxide film 72, and the photoresist applied oxide film 72 is then exposed to light for performing the development utilizing an exposure device, thereby forming the resist pattern 73 having openings corresponding to regions in which a channel inlet 34a and a channel outlet 34b are formed. Note that FIG. 16A is a sectional view in a direction of the channels to be formed, FIG. 16B is a sectional view taken along a dash-dot line 16A-16B of FIG. 16A, and FIG. 16C is a sectional view taken along a dash-dot line 16C-16D of FIG. 16A.

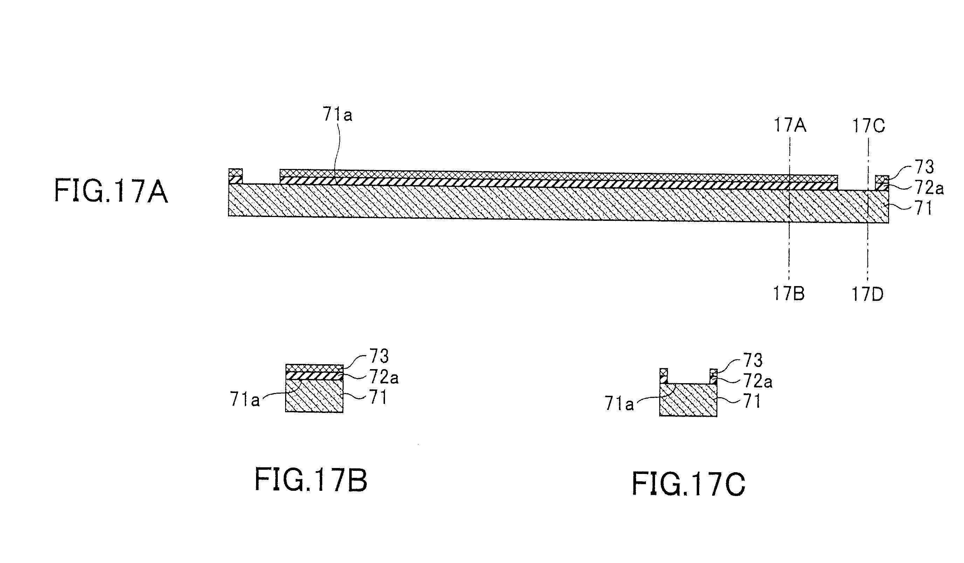

Next, the oxide film 72 formed in the openings of the resist pattern 73 is removed by reactive ion etching (RIE) to expose the silicon base 71, thereby forming an oxide film pattern 72a in a region in which the resist pattern 73 is formed as illustrated in FIGS. 17A to 17C. Note that FIG. 17A is a sectional view in a direction of the channels to be formed, FIG. 17B is a sectional view taken along a dash-dot line 17A-17B of FIG. 17A, and FIG. 17C is a sectional view taken along a dash-dot line 17C-17D of FIG. 17A.

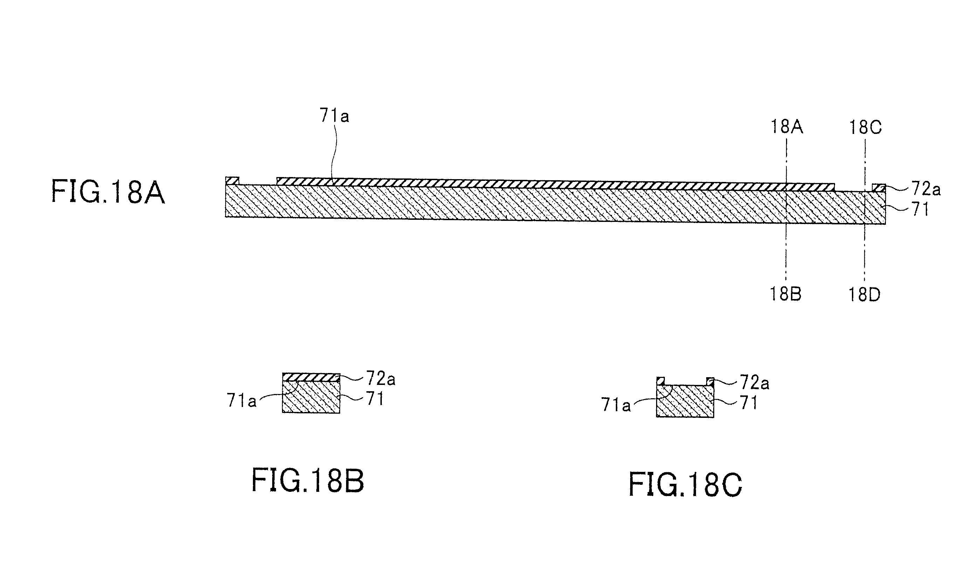

Next, the resist pattern 73 is removed with an organic solvent, or the like as illustrated in FIGS. 18A to 18C. Accordingly, the oxide film pattern 72a formed on the first surface 71a of the silicon base 71 is exposed. Note that FIG. 18A is a sectional view in a direction of the channels to be formed, FIG. 18B is a sectional view taken along a dash-dot line 18A-18B of FIG. 18A, and FIG. 18C is a sectional view taken along a dash-dot line 18C-18D of FIG. 18A.

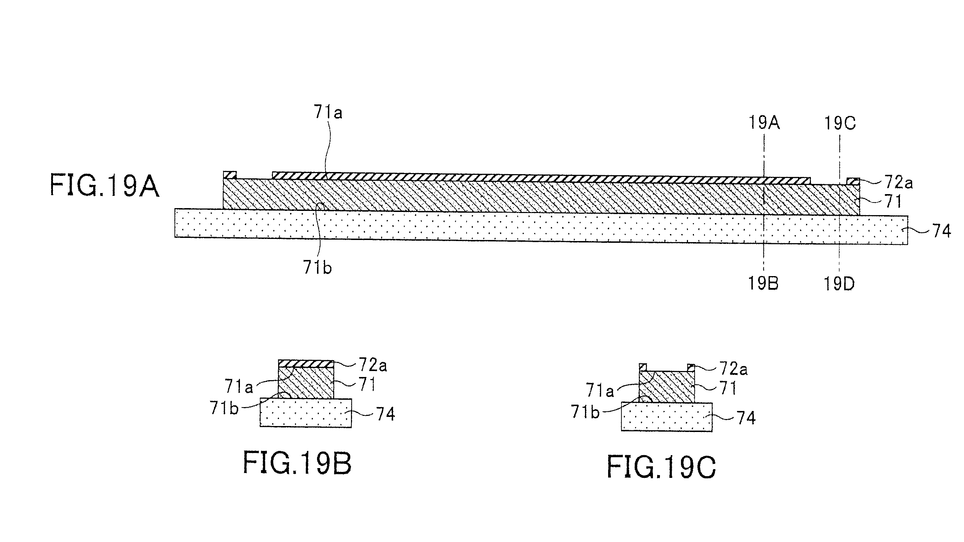

Next, a thermal ablation sheet 74 is adhered to a second surface 72b opposing the first surface 71a on which the oxide film pattern 72a is formed as illustrated in FIGS. 19A to 19C. Note that FIG. 19A is a sectional view in a direction of the channels to be formed, FIG. 19B is a sectional view taken along a dash-dot line 19A-19B of FIG. 19A, and FIG. 19C is a sectional view taken along a dash-dot line 19C-19D of FIG. 19A.

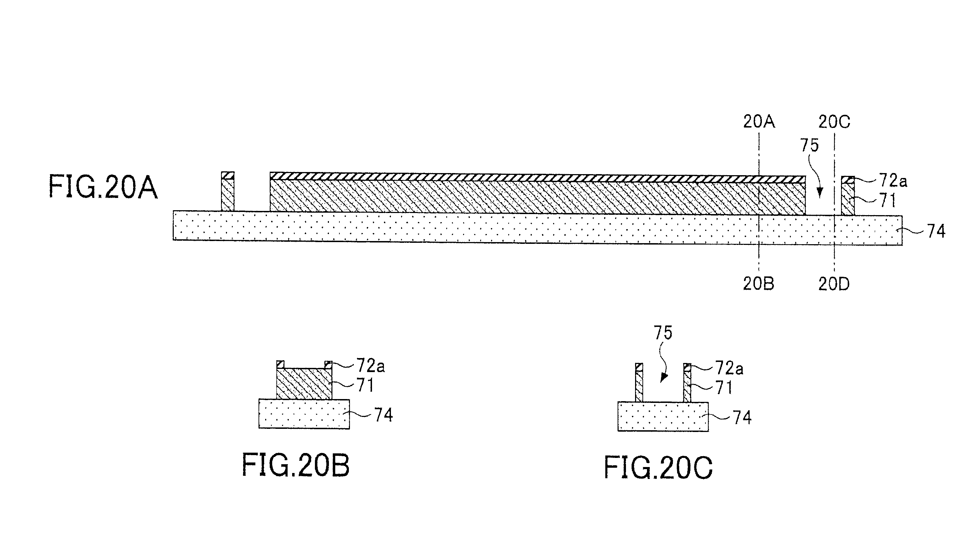

Next, opening regions 75 are formed in the first surface 71a of the silicon base 71, on which the oxide film pattern 72a is formed, by deep reactive ion etching (DRIE) utilizing the oxide film pattern 72a as a mask as illustrated in FIGS. 20A to 20C. Specifically, the opening regions 75 are formed by deep reactive ion etching (DRIE) to remove portions of the silicon base 71 where the oxide film pattern 72a is not formed. As a result, the opening regions 75 penetrate the silicon base 71. Note that FIG. 20A is a sectional view in a direction of the channels to be formed, FIG. 20B is a sectional view taken along a dash-dot line 20A-20B of FIG. 20A, and FIG. 20C is a sectional view taken along a dash-dot line 20C-20D of FIG. 20A.

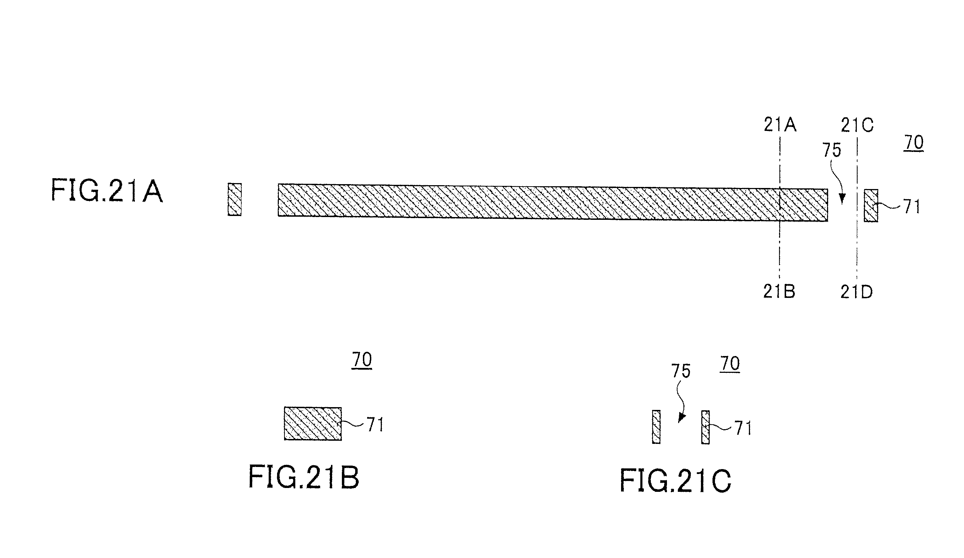

Next, the thermal ablation sheet 74 is removed by heating, and further, the oxide film pattern 72a is removed as illustrated in FIGS. 21A to 21B. Thus, the upper portion 70 of the microchannel heat sink 30 is formed. Note that FIG. 21A is a sectional view in a direction of the channels to be formed, FIG. 21B is a sectional view taken along a dash-dot line 21A-21B of FIG. 21A, and FIG. 21C is a sectional view taken along a dash-dot line 21C-21D of FIG. 21A.

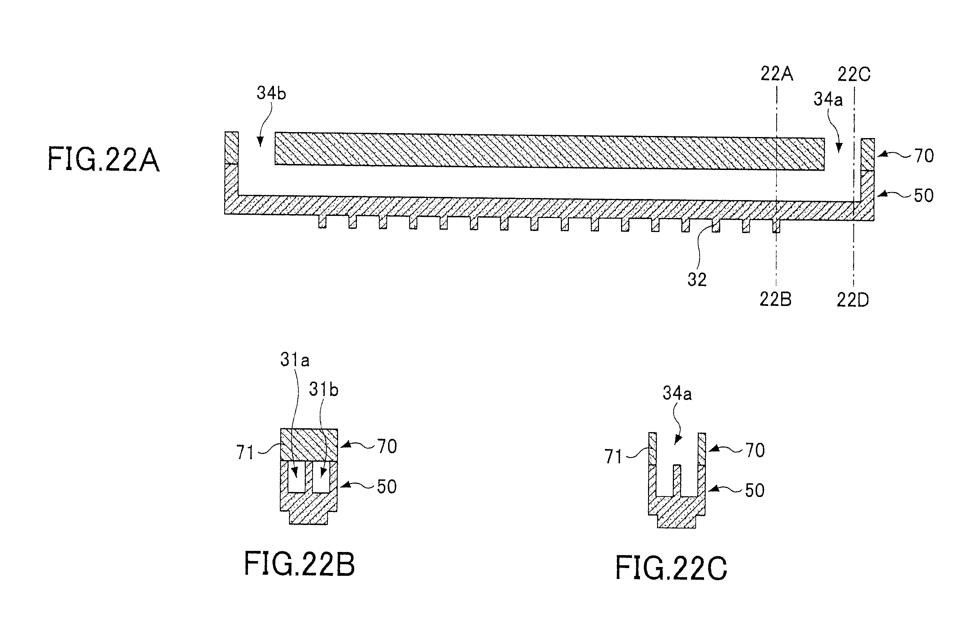

Next, the lower portion 50 and the upper portion 70 of the microchannel heat sink 30 are bonded as illustrated in FIGS. 22A to 22C. The lower portion 50 and the upper portion 70 of the microchannel heat sink 30 may be bonded by direct bonding. For example, the lower portion 50 and the upper portion 70 of the microchannel heat sink 30 are heated at approximately 100°C to directly bond the lower portion 50 and the upper portion 70 of the microchannel heat sink 30. Alternatively, surfaces of the lower portion 50 and the upper portion 70 of the microchannel heat sink 30 may be plasma-treated and then directly bond the lower portion 50 and the upper portion 70 of the microchannel heat sink 30. As a result, the opening regions 56 formed in the lower portion 50 of the microchannel heat sink 30 are enclosed with the lower portion 50 and the upper portion 70, thereby forming the channels 31a and 31b serving as the flow paths. Note that FIG. 22A is a sectional view in a direction of the channels to be formed, FIG. 22B is a sectional view taken along a dash-dot line 22A-22B of FIG. 22A, and FIG. 22C is a sectional view taken along a dash-dot line 22C-22D of FIG. 22A.

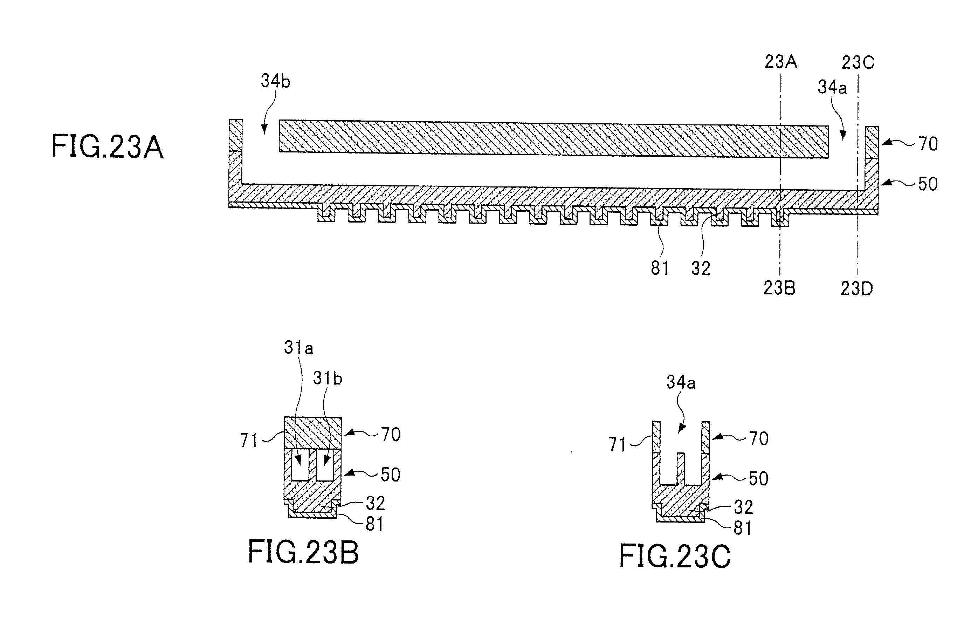

Next, a gold-plated layer 81 serving as a metallic plated layer is formed on a surface the lower portion 50 of the microchannel heat sink 30 on which the projections 32 are formed (i.e., the gold-plated layer is formed on the projection formed surface of the microchannel heat sink) as illustrated in FIGS. 23A to 23C. As a result, the surface the lower portion 50 of the microchannel heat sink 30 on which the projections 32 are formed has electrical conductivity. With this configuration, when the fore-ends of the projections 32 of the microchannel heat sink 30 are brought into contact with the source electrodes 11 formed on the semiconductor chip 10, the fore-ends of the projections 32 of the microchannel heat sink 30 and the grounding terminal 25 provided on the package 25 are electrically coupled via the gold-plated layer 81. Specifically, the gold-plated layer 81 is formed by initially depositing gold (Au) by sputtering on a surface the lower portion 50 of the microchannel heat sink 30 on which the projections 32 are formed and then carrying out electroless gold plating. The thus formed gold-plated layer 81 includes a thickness range of 2 to 205 $\mu$m. Note that FIG. 23A is a sectional view in a direction of the channels to be formed, FIG. 23B is a sectional view taken along a dash-dot line 23A-23B of FIG. 23A, and FIG. 23C is a sectional view taken along a dash-dot line 23C-23D of FIG. 23A.

Thus, the microchannel heat sink 30 serving as the cooling device according to the first embodiment is formed in the above-described manner. Thereafter, the projections 32 of the microchannel heat sink 30 serving as the cooling device according to the first embodiment are aligned corresponding to the source electrodes 11 of the semiconductor chip 10 and the microchannel heat sink 30 is then flip-chip mounted on the semiconductor chip 10 as illustrated in FIG. 2. The thus flip-chip mounted microchannel heat sink 30 and semiconductor chip 10 are fixed to the package 21 at a predetermined position, and then covered with the lid 22 as illustrated in FIG. 1, thereby forming the semiconductor device according to the first embodiment.

[SECOND EMBODIMENT]

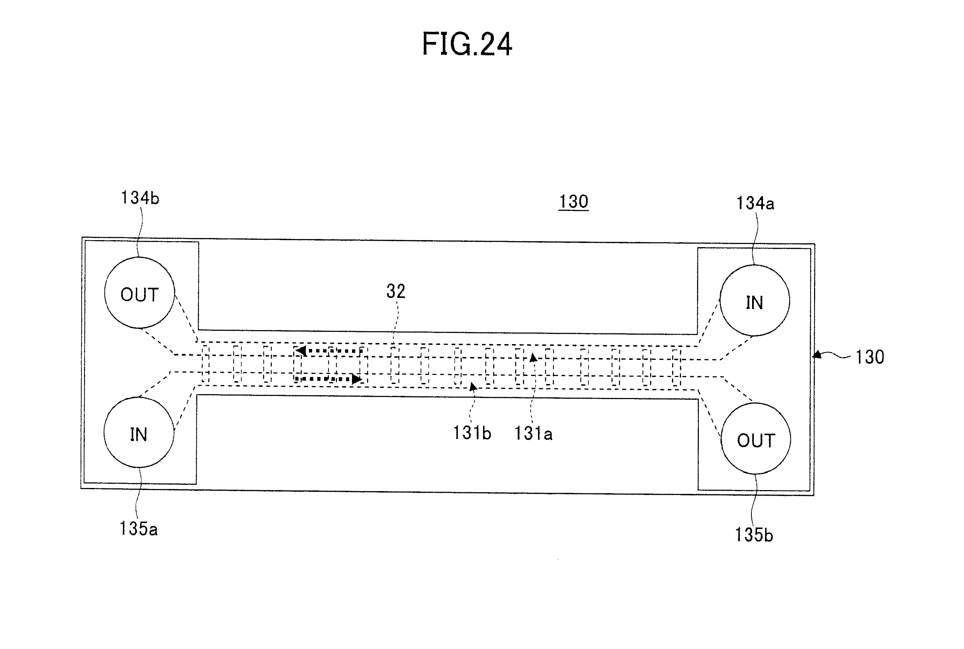

Next, a semiconductor device and a cooling device according to a second embodiment are described. As illustrated in FIG. 24, a microchannel heat sink 130 serving as the cooling device according to the second embodiment includes two channels 131a and 131b. The channel 131a includes a channel inlet 134a and a channel outlet 134b arranged one on each end such that coolant such as water is supplied from the channel inlet 134a, flows through the channel 131a and is discharged from the channel outlet 134b. Likewise, the channel 131b includes a channel inlet 135a and a channel outlet 135b arranged one on each end such that the coolant such as water is supplied from the channel inlet 135a, flows through the channel 131b and is discharged from the channel outlet 135b.

The channel inlets 134a and 135a are provided with the respective ends of the channels 131a and 131b located on the same first side of the microchannel heat sink 130, and the channel inlets 134b and 135b are provided with the respective ends of the channels 131a and 131b located on the same second side of the microchannel heat sink 130. Accordingly, in the microchannel heat sink 130, the coolant flows through the channel 131a in a direction opposite to a direction in which the coolant flows through the channel 131b as indicated by dashed arrows in FIG. 24.

Next, a result of simulation carried out on the semiconductor device according to the second embodiment is described. Note that in this simulation of the semiconductor device according to the second embodiment, the semiconductor chip 10 has an external shape of a width 420 $\mu$m * a length 7650 $\mu$m * a height 880 $\mu$m, and the amount of heat generated by the semiconductor chip 10 is 50 W. Further, the two channels 131a and 131b of the microchannel heat sink 130 each have a width of 60 $\mu$m and a height of 350 $\mu$m, and 61 projections 32 having a height of 20 $\mu$m are formed outside the microchannel heat sink 130. The projections 32 are brought into contact with the source electrodes 11 formed on the semiconductor chip 10, and water serving as the coolant is running through the channels 131a and 131b of the microchannel heat sink 130 at a flow rate of 150 ml/min. As a result, the lowest temperature obtained among the projections 32 of the microchannel heat sink 130 is 88°C and the highest temperature obtained is 110°C. Thus, the difference between the highest temperature and the lowest temperature obtained among the projections 32 of the microchannel heat sink 130 is 24°C

Further, when the amount of heat generated by the semiconductor chip 10 is 100 W, and water serving as the coolant is running through the channels 131a and 131b of the microchannel heat sink 130 at a flow rate of 227 ml/min, the lowest temperature obtained among the projections 32 of the microchannel heat sink 130 is 98°C and the highest temperature obtained among the projections 32 of the microchannel heat sink 130 is 212°C. Thus, the difference between the highest temperature and the lowest temperature obtained among the projections 32 of the microchannel heat sink 130 is 14°C.

In the cooling device according to the second embodiment, the semiconductor chip 10 may be cooled at a uniform temperature. For example, the semiconductor chip 10 generating heat at a temperature range of 50 to 100 W may be cooled to approximately 100°C. Note that as illustrated in FIG. 4, higher cooling effect may be obtained by increasing the flow rate of the coolant. Further, the microchannel heat sink 130 serving as the cooling device according to the second embodiment is flip-chip mounted on the semiconductor chip 10, the thus flip-chip mounted microchannel heat sink 130 and semiconductor chip 10 are fixed to the package 21 at a predetermined position, and then covered with the lid 22 in a similar manner as the first embodiment, thereby forming the semiconductor device according to the second embodiment. The configuration and a fabrication method of the semiconductor device and the cooling device according to the second embodiment other than those described above are similar to those of the semiconductor device and the cooling device according to the first embodiment.

[THIRD EMBODIMENT]

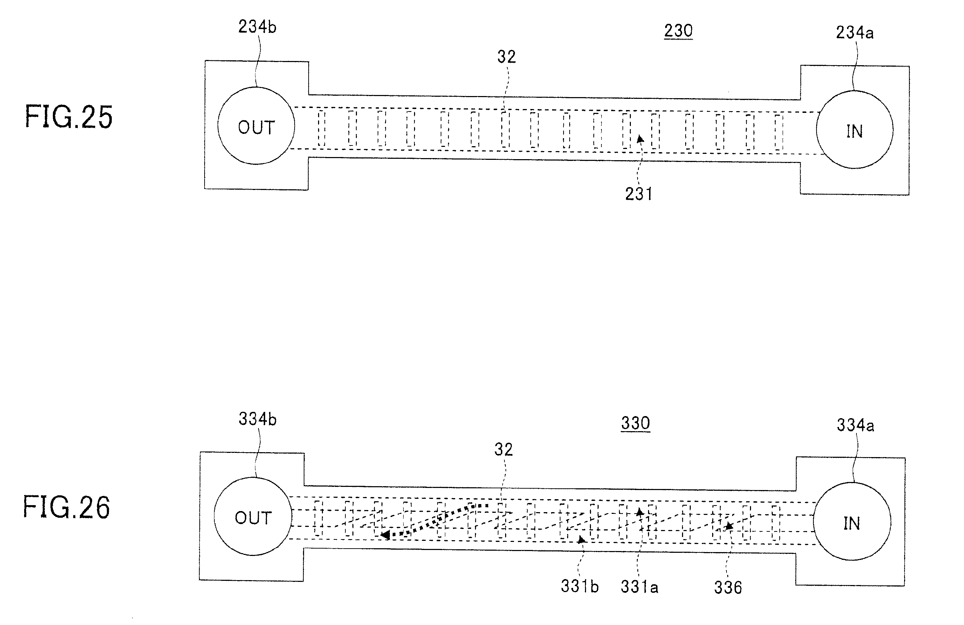

Next, a semiconductor device and a cooling device according to a third embodiment are described. As illustrated in FIG. 25, a microchannel heat sink 230 serving as the cooling device according to the third embodiment includes one channel 231. The channel 231 includes a channel inlet 234a and a channel outlet 234b arranged one on each end of the channel 231 such that coolant such as water is supplied from the channel inlet 234a, flows through the channel 231 and is discharged from the channel outlet 234b. Note that only one channel 231 may be provided in the microchannel heat sink 230 as described in the third embodiment insofar as the strength of the microchannel heat sink 230 is acquired. The semiconductor chip 10 may be sufficiently cooled in the microchannel heat sink 230 having this configuration.

Further, as illustrated in FIG. 26, another microchannel heat sink 330 serving as the cooling device according to the third embodiment includes two channels 331a and 331b, and a sub-microchannel 336 connecting the two channels 331a and 331b. The channels 331a and 331b include a channel inlet 334a and a channel outlet 334b arranged one on each end such that the coolant such as water is supplied from the channel inlet 334a, flows through the channels 131a and 131b and is discharged from the channel outlet 334b. With this configuration, the coolant may run through the sub-microchannel 336 that is connected between the channels 331a and 331b as indicated by dashed arrows in FIG. 26. Thus, the semiconductor chip 10 may be cooled to a more uniform temperature, thereby reducing the difference in the temperature distribution.

Further, the microchannel heat sink 330 serving as the cooling device according to the third embodiment is flip-chip mounted on the semiconductor chip 10, the thus flip-chip mounted microchannel heat sink 130 and semiconductor chip 10 are fixed to the package 21 at a predetermined position, and then covered with the lid 22 in a similar manner as the first embodiment, thereby forming the semiconductor device according to the third embodiment. Note that the configuration and a fabrication method of the semiconductor device and the cooling device according to the third embodiment other than those described above are similar to those of the semiconductor device and the cooling device according to the first embodiment.

[FOURTH EMBODIMENT]

Next, a semiconductor device and a cooling device according to a fourth embodiment are described.

(SEMICONDUCTOR DEVICE)

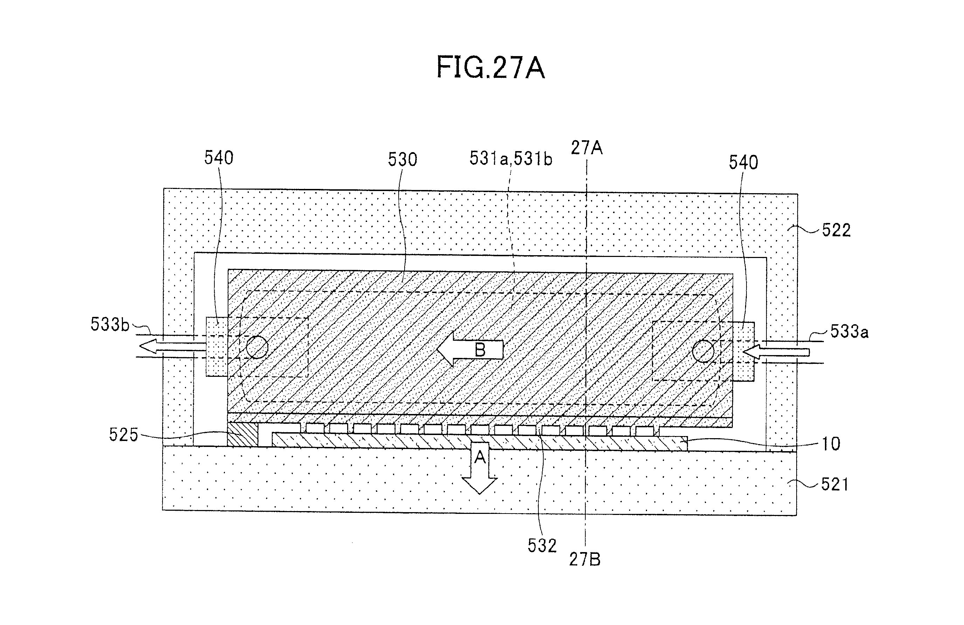

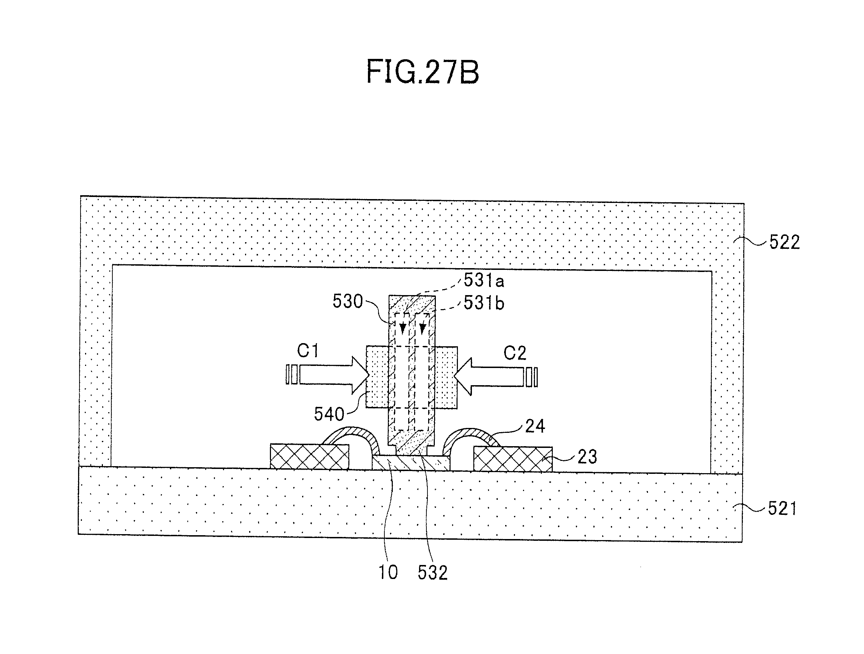

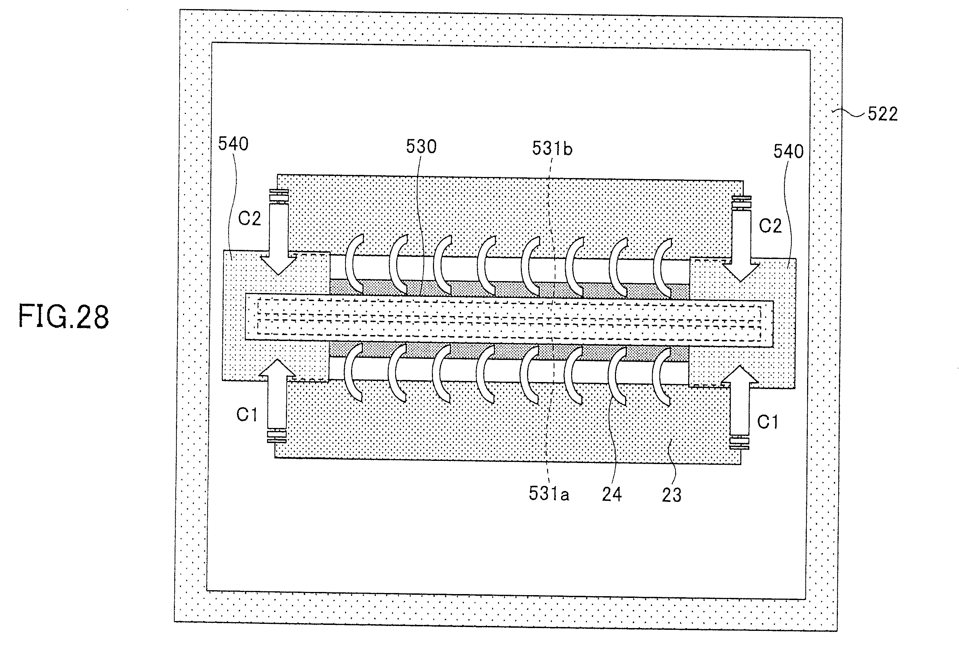

The semiconductor device and the cooling device according to the fourth embodiment are described with reference to FIGS. 27A and 27B and FIG. 28. FIG. 27A is a side view illustrating internal components of the semiconductor device according to the fourth embodiment, and FIG. 27B is a sectional view taken along a dash-dot line 27A-27B of FIG. 27A of the semiconductor device according to the fourth embodiment. Further, FIG. 28 is a top view illustrating the internal components of the semiconductor device according to the fourth embodiment.

The semiconductor device according to the fourth embodiment includes a semiconductor chip 10 covered with a package 521 and a lid 522 such that one surface of the semiconductor chip 10 comes into contact with a bottom of the package 521. The package 521 is formed of a metallic material having a three-layered structure (i.e., a Cu-Mo-Cu (copper-molybdenum-copper) layered structure) such that heat generated by the semiconductor chip 10 is partially transferred via the package 521 in a direction indicated by an arrow "A" of FIG. 27A. Note that since the semiconductor chip 10 includes an electronic circuit (not illustrated), the semiconductor chip 10 generates heat when the electronic circuit operates. Note also that although the package 521 and the lid 522 serve in a manner similar to those in the first embodiment, the package 521 and the lid 522 have different shapes from those in the first embodiment.

A microchannel heat sink 530 serving as a cooling device according to the fourth embodiment is arranged on the other surface of the semiconductor chip 10. The microchannel heat sink 530 includes flow paths formed of two channels 531a and 531b configured to allow the coolant, such as water, having fluidity to flow in a direction indicated by an arrow B of FIG. 27A inside the semiconductor device according to the fourth embodiment. The coolant flowing through the two channels 531a and 531b is supplied from a supply port 533a provided outside the lid 522, flows through the channels 531a and 531b provided in the microchannel heat sink 530, and is then discharged from a discharge port 533b provided outside the lid 522. Further, the microchannel heat sink 530 includes a surface that comes into contact with the semiconductor chip 10, and the projections 532 are formed at positions on the surface that comes into contact with the semiconductor chip 10 of the microchannel heat sink 530 corresponding to later-described source electrodes of the semiconductor chip 10. Moreover, a gold-plated layer (not illustrated) is formed on the surface of the microchannel heat sink 530 where the projections 532 are formed such that the gold-plated layer is in contact with a grounding terminal 525 arranged on the package 521.

Note that in the semiconductor device according to the fourth embodiment, the package 521 includes matching circuits 23 such that electrode terminals (not illustrated) provided on the other surface of the semiconductor chip 10 and electrode terminals (not illustrated) provided on the matching circuits 23 are connected with bonding wires 24.

In the semiconductor device according to the fourth embodiment, the microchannel heat sink 530 is fixed by pressure-fixing fixtures 540 that apply pressure to the microchannel heat sink 530 from directions indicated by arrows C1 and C2 as illustrated in FIG. 27B and FIG. 28.

(COOLING DEVICE)

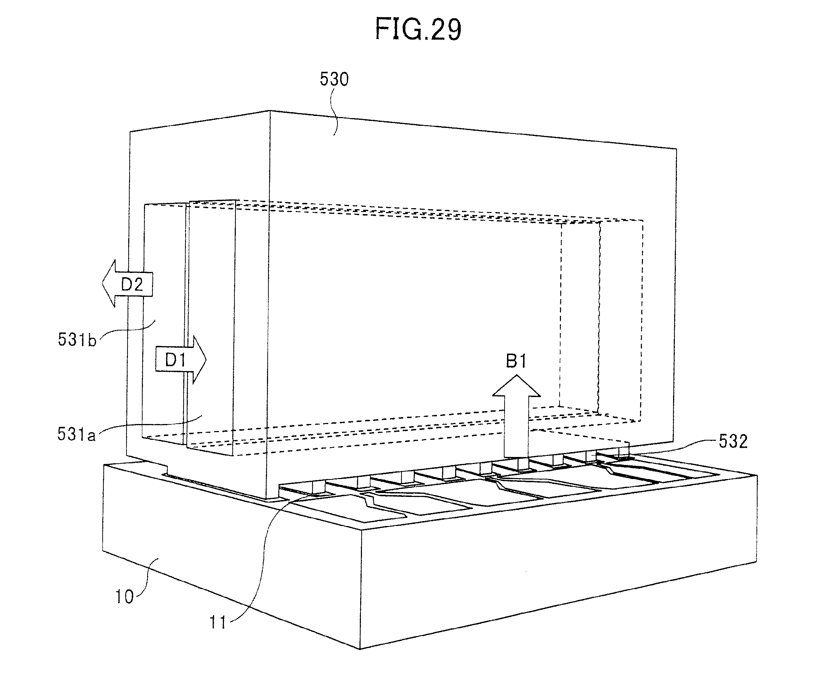

Next, a cooling device according to a fourth embodiment is described. As illustrated in FIG. 29, the microchannel heat sink 530 utilized as the cooling device according to the fourth embodiment is formed by processing a silicon substrate. As described earlier, the microchannel heat sink 530 includes the surface that comes into contact with the semiconductor chip 10, and plural projections 532 are formed on that surface of the microchannel heat sink 530. The projections 532 are formed on the surface of the microchannel heat sink 530 at the positions corresponding to electrodes 11 formed on the semiconductor chip 10 in the following manner. The projections 532 are initially aligned with the source electrodes 11 formed on the semiconductor chip 10, and the projections 532 of the microchannel heat sink 530 and the source electrodes 11 formed on the semiconductor chip 10 are then brought into contact with one another. With this configuration, heat generated by the semiconductor chip 10 is transferred from the source electrodes 11 via the projections 532 of the microchannel heat sink 530 to the interior of the microchannel heat sink 530 as indicated by an arrow B1 in FIG. 29. The heat transferred to the interior of the microchannel heat sink 530 is then further transferred to the coolant flowing through the channels 531a and 531b of the microchannel heat sink 530. The heated coolant is discharged from the discharge port 533b, and at this time, the heat transferred to the coolant is also discharged together with the coolant, thereby effectively cooling the semiconductor chip 10. As illustrated in FIG. 29, the channels 531a and 531b are formed such that the coolant flows through the channel 531a in a direction indicated by an arrow D1 and the coolant flows through the channel 531b in a direction indicated by an arrow D1 that is opposite to the direction indicated by an arrow D1. In the cooling device according to the fourth embodiment, since the projections 532 are formed as part of the microchannel heat sink 530, there are no blocking layers to heat transfer formed between the projections 532 and the microchannel heat sink 530. Accordingly, the semiconductor chip 10 may be effectively and efficiently cooled.

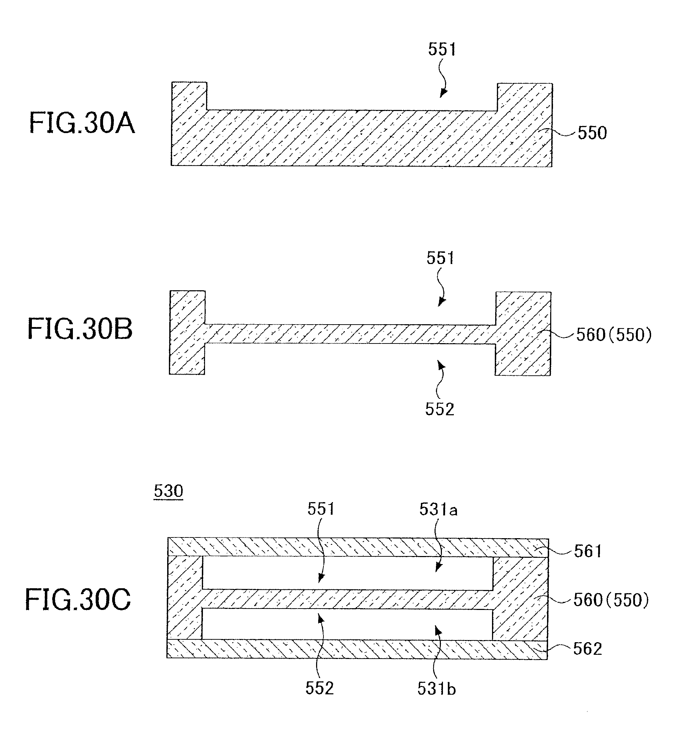

Next, the microchannel heat sink 530 serving as the cooling device according to the fourth embodiment is described in more detail with reference to FIGS. 30A to 30C. As described earlier, the microchannel heat sink 530 utilized as the cooling device according to the fourth embodiment is formed by processing a silicon substrate 550. A specific process for fabricating the microchannel heat sink 530 serving as the cooling device according to the fourth embodiment is described in more detail below.

Initially, a predetermined portion of one surface of the silicon substrate 550 is removed by etching such as deep reactive ion etching (DRIE), thereby forming a recess 551 as illustrated in FIG. 30A.

Next, a predetermined portion of the other surface of the silicon substrate 550 is removed by etching such as deep reactive ion etching (DRIE), thereby forming a recess 552 as illustrated in FIG. 30B. The silicon substrate 550 having two recesses one in each surface is called a central substrate 560.

Next, a side substrate 561 made of another silicon substrate is attached to the central substrate 560 such that the side substrate 561 covers the recess 551 formed on one surface of the central substrate 561 as illustrated in FIG. 30C. Likewise, a side substrate 562 made of another silicon substrate is attached to the central substrate 560 such that the side substrate 562 covers the recess 552 formed on the other surface of the central substrate 561 as illustrated in FIG. 30C. Accordingly, the channel 531a is formed between the recess 551 and the side substrate 561 and the channel 531b is formed between the recess 552 and the side substrate 562. Thus, the microchannel heat sink 530 serving as the cooling device according to the fourth embodiment is formed. Further, although not illustrated in FIGS. 30A to 30C, the projections 532 are formed by processing a portion corresponding to a side surface of the silicon substrate 550. Thus, the surface that comes into contact with the semiconductor chip 10 is obtained by processing the side surface of the silicon substrate 550.

In the thus formed microchannel heat sink 530, the channels 531a and 531b through which the coolant flows may have large cross sections by utilizing the large silicon substrate 550. With this configuration, more of the coolant may be allowed to flow through the channels 531a and 531b. Thus, the cooling efficiency may further be increased.

(FABRICATION METHOD)

Next, a method for fabricating the cooling device according to the fourth embodiment is described. The microchannel heat sink 530 serving as the cooling device according to the fourth embodiment may be formed by fabricating a silicon (Si) substrate or the like in a surface direction.

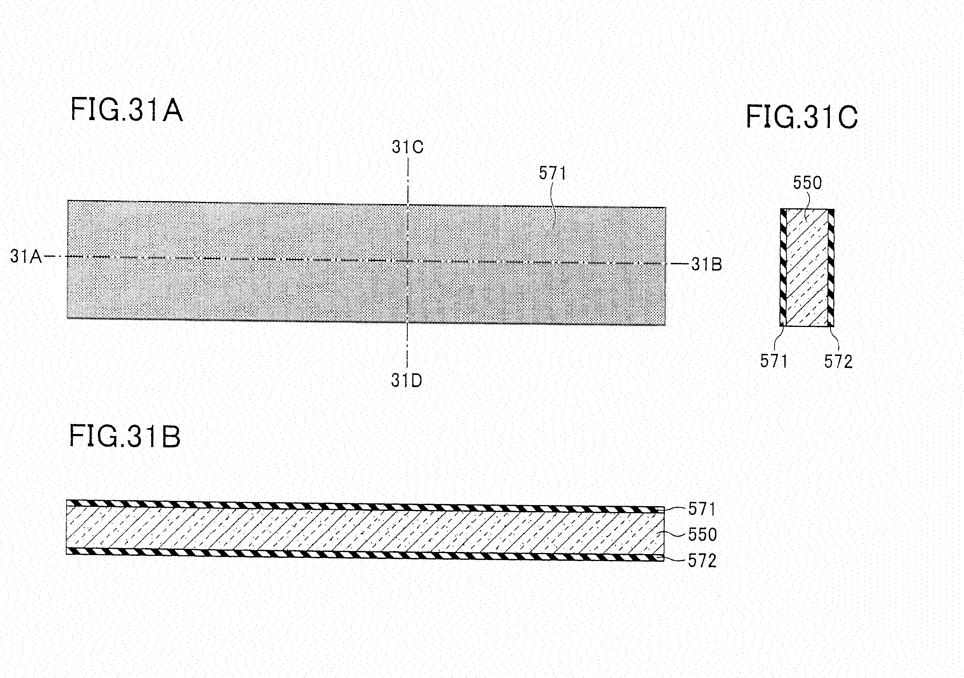

Initially, oxide films 571 and 572 are formed one on each surface of the silicon substrate 550 as illustrated in FIGS. 31A to 31C. Specifically, the oxide films 571 and 572 are respectively formed on a surface and a rear surface of the silicon substrate 550 by chemical vapor deposition (CVD) or thermal oxidation. The silicon substrate may be doped with various impurity elements so that the silicon substrate may have conductivity. Examples of the impurity elements include p-type impurity elements such as boron (B) or n-type impurity elements such as phosphorus (P) or antimony (Sb). A frequently used thickness of the silicon substrate 550 may be in a range of 200 to 525 $\mu$m in general; however, the thickness of the silicon substrate 550 may preferably vary with the width or the size of the semiconductor chip 10. Further, since the microchannel heat sink 530 is formed by forming a pattern on the surface of the silicon substrate 550 or etching the surface of the silicon substrate 550, the surface of the silicon substrate 550 may preferably be flat. Thus, the surface and the rear surface of the silicon substrate 550 may preferably be mirror finished. In the microchannel heat sink 530 according to the fourth embodiment, the silicon substrate 550 has a thickness of approximately 200 $\mu$m, and the oxide films 571 and 572 are formed by plasma CVD such that the oxide films 571 and 572 have a thickness range of 1 to 2 $\mu$m. Note that FIG. 31A is a top view illustrating the silicon substrate undergoing the above-described fabrication process, FIG. 31B is a sectional view taken along a dash-dot line 31A-31B of FIG. 31A, and FIG. 31C is a sectional view taken along a dash-dot line 31C-31D of FIG. 31A.

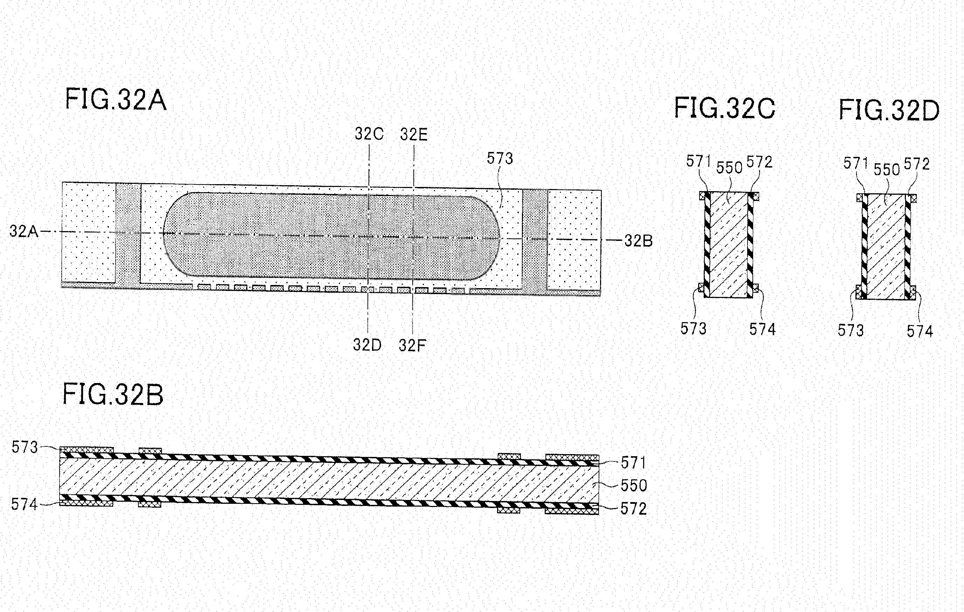

Next, respective resist patterns 573 and 574 are formed on the surfaces of the oxide films 571 and 572 as illustrated in FIGS. 32A to 32D. Specifically, after a photoresist is applied to the surface of the oxide film 571 and the photoresist applied surface of the oxide film 571 is prebaked, the prebaked oxide film 571 is exposed to light for performing the development utilizing an exposure device, thereby forming a resist pattern 573 having openings corresponding to regions from which the oxide film 571 is removed. Likewise, a photoresist is applied to the surface of the oxide film 572, and the photoresist applied oxide film 572 is then exposed to light for performing the development utilizing an exposure device, thereby forming a resist pattern 574 having openings corresponding to regions from which the oxide film 572 is removed. Note that FIG. 32A is a top view illustrating the silicon substrate undergoing the above-described fabrication process, FIG. 32B is a sectional view taken along a dash-dot line 32A-32B of FIG. 32A, FIG. 32C is a sectional view taken along a dash-dot line 32C-32D of FIG. 32A, and FIG. 32D is a sectional view taken along a dash-dot line 32E-32F of FIG. 32A.

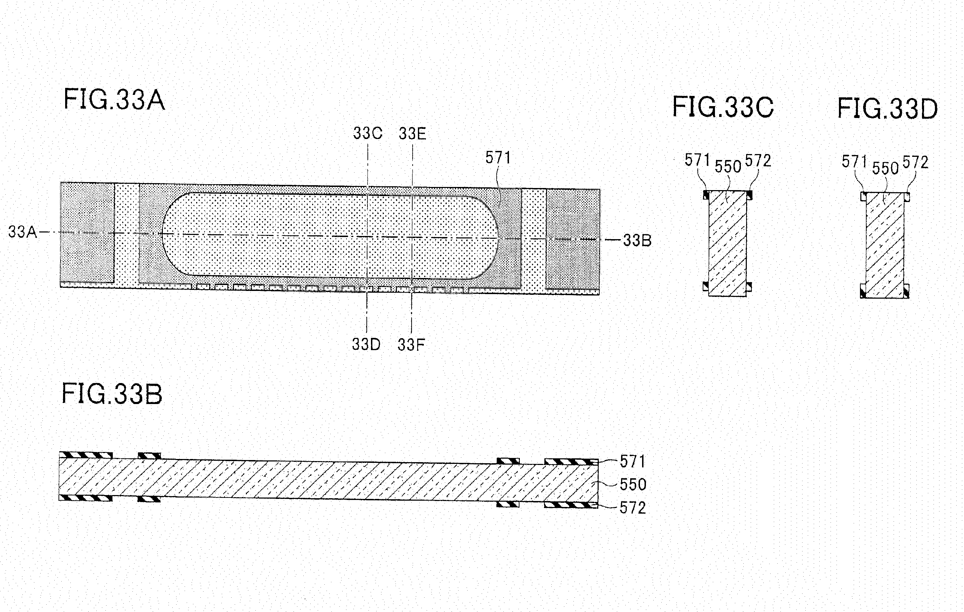

Next, the oxide film 571 formed in regions where the resist pattern 573 is not formed is removed by reactive ion etching (RIE) or wet etching as illustrated in FIGS. 32A to 32D. Likewise, the oxide film 572 formed in regions where the resist pattern 574 is not formed is removed by reactive ion etching (RIE) or wet etching as illustrated in FIGS. 32A to 32D. Specifically, the oxide films 571 and 572 are removed from respective regions where the resist patterns 573 and 574 are not formed by carrying out buffered hydrofluoric acid (BHF) etching. Thereafter, the resist patterns 573 and 574 are removed with an organic solvent, or the like. FIGS. 33A to 33D illustrate a case where the exposed oxide films 571 and 572 are removed simultaneously; however, the exposed oxide films 571 and 572 may be sequentially removed from a corresponding one of the silicon substrate 550 sides. For example, the resist pattern 573 is formed on the oxide film 571 formed surface of the silicon substrate 55 and a (not-illustrated) resist pattern covers an entire oxide film 571 formed surface of the silicon substrate 550. Thereafter, the oxide film 571 is removed from regions where the resist pattern 573 is not formed by wet etching or the like. Next, after the resist pattern 573 is removed with an organic solvent or the like, the resist pattern 574 is formed on the oxide film 572 formed surface of the silicon substrate 550, and a (not-illustrated) resist pattern is formed such that the resist pattern covers the entire oxide film 571 formed surface of the silicon substrate 550. Thereafter, the oxide film 572 is removed from the regions where the resist pattern 574 is not formed by wet etching or the like. A mask formed of the oxide film 571 and a mask formed of the oxide film 572 are formed in this manner. Note that FIG. 33A is a top view illustrating the silicon substrate undergoing the above-described fabrication process, FIG. 33B is a sectional view taken along a dash-dot line 33A-33B of FIG. 33A, FIG. 33C is a sectional view taken along a dash-dot line 33C-33D of FIG. 33A, and FIG. 33D is a sectional view taken along a dash-dot line 33E-33F of FIG. 33A.

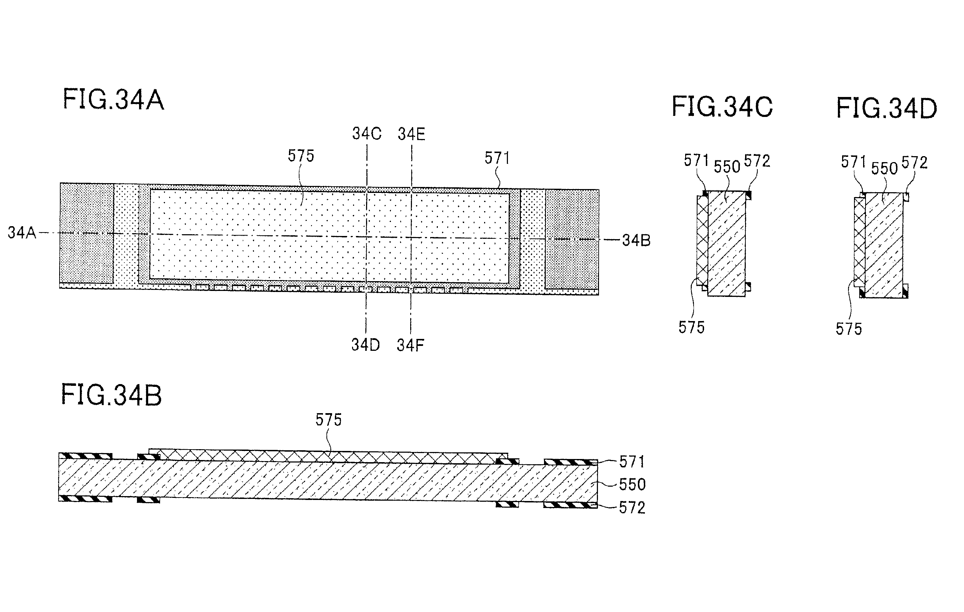

Next, a resist pattern 575 is formed in a region on the surface of the silicon substrate 550 from which oxide film 571 is removed and a recess 551 (not-illustrated) will be formed later in that region such that the resist pattern 575 covers the recess 551 (not-illustrated) as illustrated in FIGS. 34A to 34D. Specifically, a photoresist is applied to the partially removed oxide film 571 formed surface of the silicon substrate 550, and the photoresist applied partially removed oxide film 571 surface of the silicon substrate 550 is then exposed to light for performing the development utilizing the exposure device, thereby forming the resist pattern 575. Note that FIG. 34A is a top view illustrating the silicon substrate undergoing the above-described fabrication process, FIG. 34B is a sectional view taken along a dash-dot line 34A-34B of FIG. 34A, FIG. 34C is a sectional view taken along a dash-dot line 34C-34D of FIG. 34A, and FIG. 34D is a sectional view taken along a dash-dot line 34E-34F of FIG. 34A.

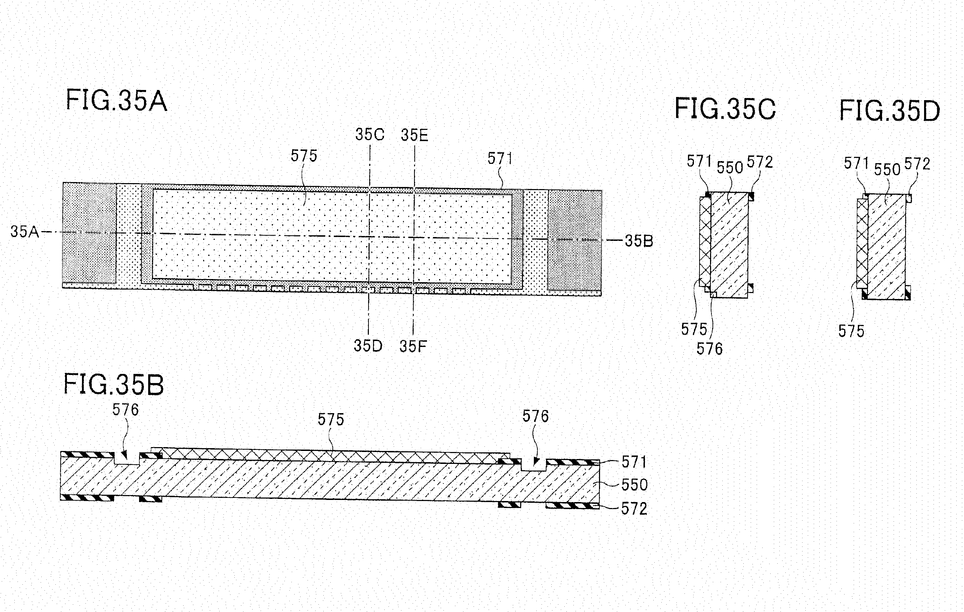

Next, in the surface of the silicon substrate 550 on which the resist pattern 575 is formed, silicon is selectively removed by deep reactive ion etching (DRIE) as illustrated in FIGS. 35A to 35D. The grooves 576 are formed in the surface of the silicon substrate 550. The grooves 576 are formed by removing portions of the silicon substrate 550 to a predetermined depth in respective regions where the oxide film 571 and the resist pattern 575 are not formed. Specifically, in the deep reactive ion etching (DRIE) in the fourth embodiment, an etching process in which the etching is carried out by introducing sulfur hexafluoride ($SF_6$), and a protecting process in which side surfaces of the etched region is protected by introducing octafluorocyclobutane ($C_4F_8$) gas are repeatedly carried out. Such a deep reactive ion etching (DRIE) process is generally called a Bosch process. The grooves 576 having walls perpendicular to the surface of the silicon substrate 550 are thus formed by carrying out such a deep reactive ion etching (DRIE) (i.e., Bosch process). In the fourth embodiment, the grooves 576 having a depth of approximately 20 $\mu$m are formed in the silicon substrate 550 by the deep reactive ion etching (DRIE). Note that FIG. 35A is a top view illustrating the silicon substrate undergoing the above-described fabrication process, FIG. 35B is a sectional view taken along a dash-dot line 35A-35B of FIG. 35A, FIG. 35C is a sectional view taken along a dash-dot line 35C-35D of FIG. 35A, and FIG. 35D is a sectional view taken along a dash-dot line 35E-35F of FIG. 35A.

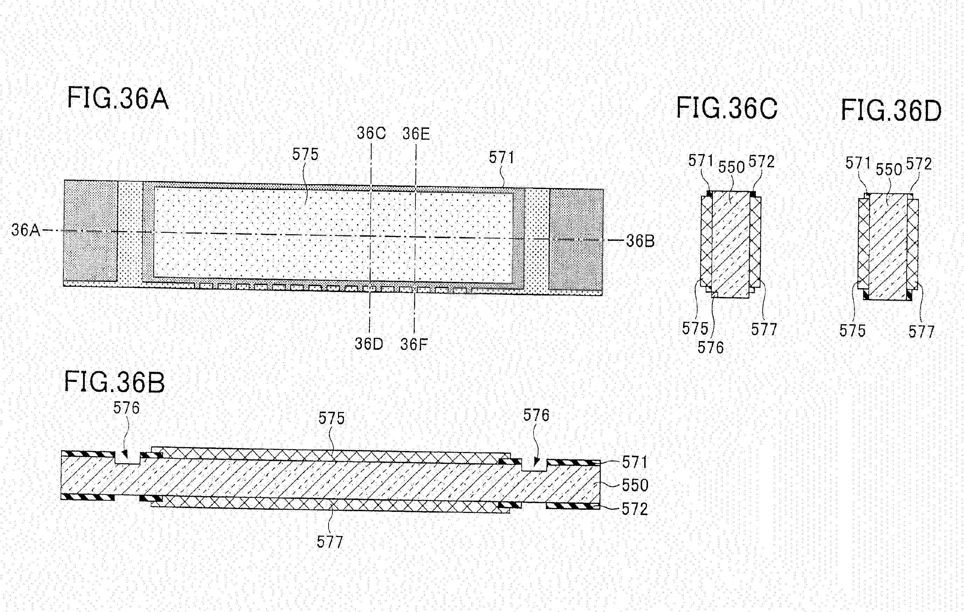

Next, a resist pattern 577 is formed on the partially removed oxide film 572 surface of the silicon substrate 550 such that the resist pattern 577 covers a recess 552 that will be formed later as illustrated in FIGS. 36A to 36D. Specifically, a photoresist is applied to the partially removed oxide film 572 formed surface of the silicon substrate 550, and the photoresist applied to the partially removed oxide film 572 surface of the silicon substrate 550 is then exposed to light for performing the development utilizing the exposure device, thereby forming the resist pattern 577. Note that FIG. 36A is a top view illustrating the silicon substrate undergoing the above-described fabrication process, FIG. 36B is a sectional view taken along a dash-dot line 36A-36B of FIG. 36A, FIG. 36C is a sectional view taken along a dash-dot line 36C-36D of FIG. 36A, and FIG. 36D is a sectional view taken along a dash-dot line 36E-36F of FIG. 36A.

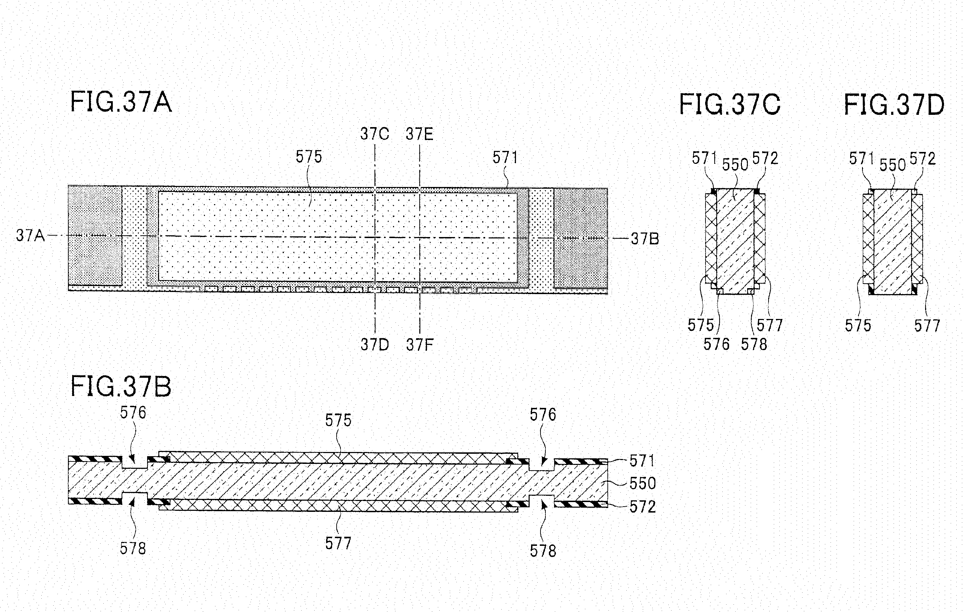

Next, silicon is selectively removed by deep reactive ion etching (DRIE) in the surface of the silicon substrate 550 on which the resist pattern 577 is formed, thereby forming grooves 578 as illustrated in FIGS. 37A to 37D. The grooves 578 are formed by removing portions of the silicon substrate 550 to a predetermined depth in respective regions where the oxide film 572 and the resist pattern 577 are not formed. In this case, the grooves 576 are already formed in a surface of the silicon substrate 550 opposite to the surface of the silicon substrate 550 on which the resist pattern 577 is formed. Accordingly, the portions of the silicon substrate 500 may be removed to the predetermined depth by attaching a (not-illustrated) support substrate via a thermal ablation sheet to the groove 576 formed surface of the silicon substrate 550 for protecting the grooves 576. Note that the support substrate attached to the groove 576 formed surface of the silicon substrate 550 via the thermal ablation sheet may be optionally detached by the application of heat in the later process, and the detached support substrate may be attached again to the groove 576 formed surface of the silicon substrate 550 via the thermal ablation sheet. In the fourth embodiment, the grooves 578 having a depth of approximately 20 $\mu$m are formed in the silicon substrate 550 by the deep reactive ion etching (DRIE). Note that FIG. 37A is a top view illustrating the silicon substrate undergoing the above-described fabrication process, FIG. 37B is a sectional view taken along a dash-dot line 37A-33B of FIG. 37A, FIG. 37C is a sectional view taken along a dash-dot line 37C-37D of FIG. 37A, and FIG. 37D is a sectional view taken along a dash-dot line 37E-37F of FIG. 37A.

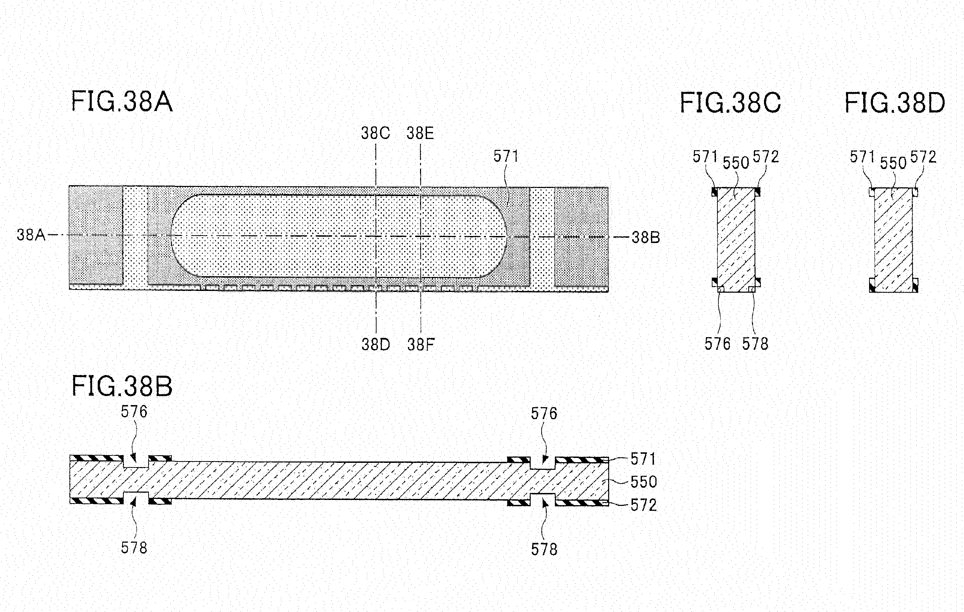

Next, the resist patterns 575 and 577 are removed as illustrated in FIGS. 38A to 38D. Specifically, the resist patterns 575 and 577 are immersed in an organic solvent or the like, thereby removing the resist patterns 575 and 577. Note that FIG. 38A is a top view illustrating the silicon substrate undergoing the above-described fabrication process, FIG. 38B is a sectional view taken along a dash-dot line 38A-38B of FIG. 38A, FIG. 38C is a sectional view taken along a dash-dot line 38C-38D of FIG. 38A, and FIG. 38D is a sectional view taken along a dash-dot line 38E-38F of FIG. 38A.

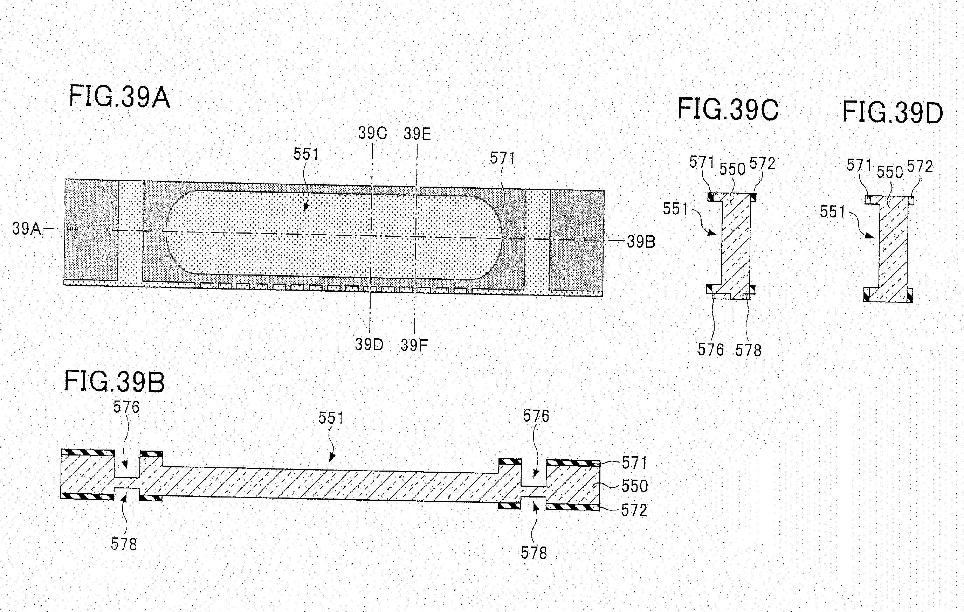

Next, a recess 551 is formed in the oxide film 571 formed surface of the silicon substrate 550 as illustrated in FIGS. 39A to 39D. Specifically, silicon is selectively removed by deep reactive ion etching (DRIE) in the oxide film 571 formed surface of the silicon substrate 550, thereby forming the recess 551. The recess 551 is formed by removing an exposed portion of the silicon substrate 550 to a predetermined depth in a region where the oxide film 571 is not formed. Simultaneously, the grooves 576 are further etched in a depth direction such that the grooves 576 have a depth of approximately half of the thickness of the silicon substrate 550. In the fourth embodiment, the portions of the silicon substrate 550 are etched approximately 80 $\mu$m in depth by carrying out the deep reactive ion etching (DRIE) for a predetermined time. That is, while the recess 551 having a depth of approximately 80 $\mu$m is formed, the grooves 576 already having a depth of approximately 20 $\mu$m are further etched to a depth of approximately 80 $\mu$m. Thus, the resulting grooves 576 have a depth of approximately 100 $\mu$m. Note that FIG. 39A is a top view illustrating the silicon substrate undergoing the above-described fabrication process, FIG. 39B is a sectional view taken along a dash-dot line 39A-39B of FIG. 39A, FIG. 39C is a sectional view taken along a dash-dot line 39C-39D of FIG. 39A, and FIG. 39D is a sectional view taken along a dash-dot line 39E-39F of FIG. 39A.

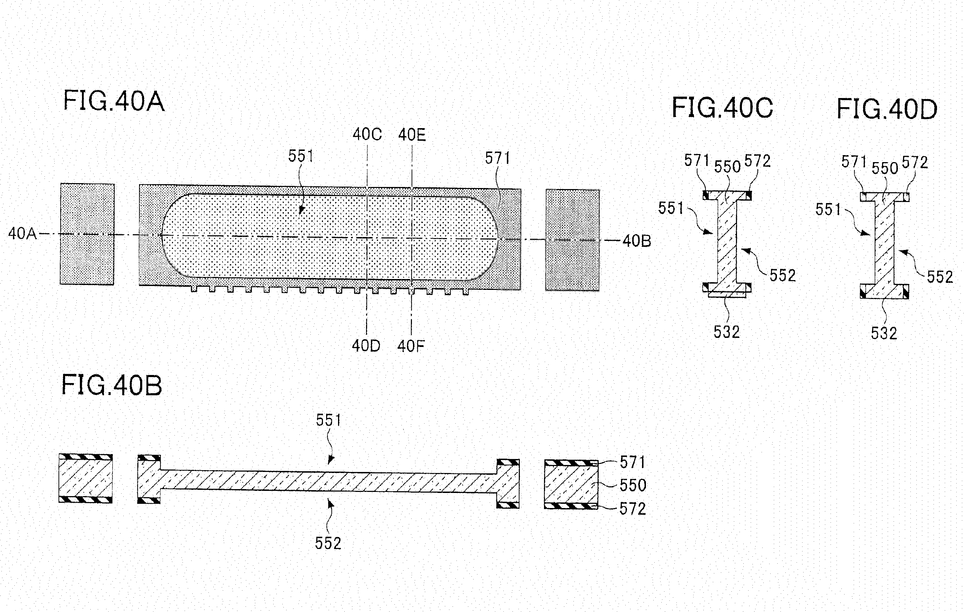

Next, a recess 552 is formed in the oxide film 572 formed surface of the silicon substrate 550 as illustrated in FIGS. 40A to 40D. Specifically, silicon is selectively removed by deep reactive ion etching (DRIE) in the oxide film 572 formed surface of the silicon substrate 550, thereby forming the recess 552. The recess 552 is formed by removing an exposed silicon portion of the silicon substrate 550 to a predetermined depth in a region where the oxide film 572 is not formed. Simultaneously, the grooves 578 are further etched in a depth direction such that the grooves 578 penetrate the silicon substrate 550 to connect with the grooves 576. Accordingly, the silicon substrate 550 is divided into separate regions that form microchannel heat sinks 530. Further, the projections 532 may be formed by simultaneously removing peripheral portions of silicon around the projections 532 while forming the grooves 576 and 578. In the fourth embodiment, the silicon is etched to a depth of approximately 80 $\mu$m by carrying out the deep reactive ion etching (DRIE) for a predetermined time. That is, while the recess 552 having a depth of approximately 80 $\mu$m is formed, the grooves 578 already having a depth of approximately 20 $\mu$m are further etched to a depth of approximately 80 $\mu$m. As a result, the resulting grooves 578 have a depth of approximately 100 $\mu$m. Accordingly, the grooves 578 penetrate the silicon substrate 550 to connect the grooves 576, thereby forming separate microchannel heat sinks 530. Note that FIG. 40A is a top view illustrating the silicon substrate undergoing the above-described fabrication process, FIG. 40B is a sectional view taken along a dash-dot line 40A-40B of FIG. 40A, FIG. 40C is a sectional view taken along a dash-dot line 40C-40D of FIG. 40A, and FIG. 40D is a sectional view taken along a dash-dot line 40E-40F of FIG. 40A.

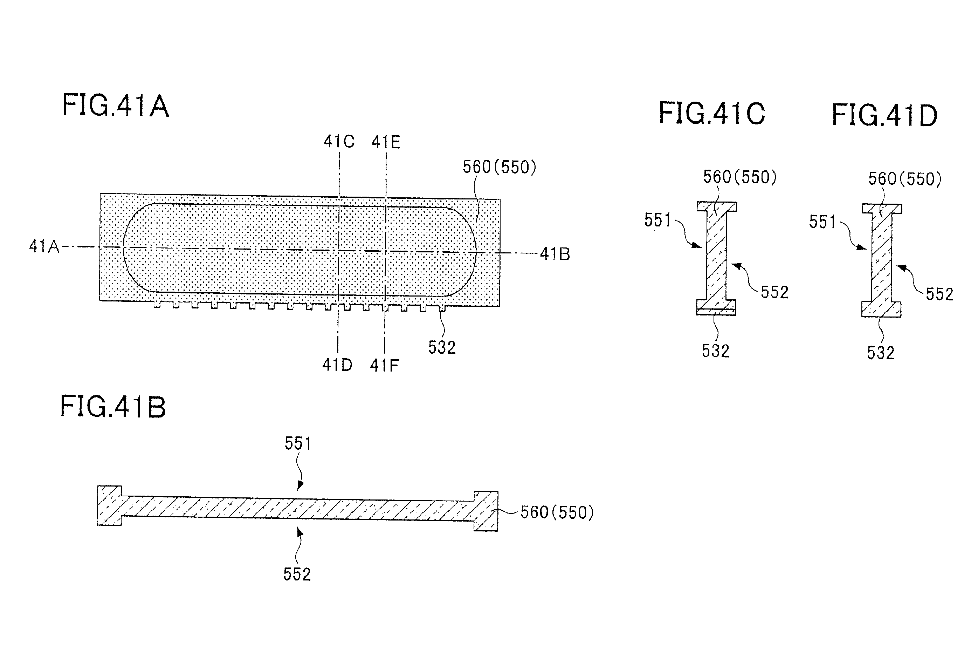

Next, the oxide films 571 and 572 are removed as illustrated in FIGS. 41A to 41D. Specifically, the oxide films 571 and 572 are removed by wet etching such as buffered hydrofluoric acid (BHF) etching. A central substrate 560 is formed by processing the silicon substrate 550 in this manner. Note that FIG. 41A is a top view illustrating the silicon substrate undergoing the above-described fabrication process, FIG. 41B is a sectional view taken along a dash-dot line 41A-41B of FIG. 41A, FIG. 41C is a sectional view taken along a dash-dot line 41C-41D of FIG. 41A, and FIG. 41D is a sectional view taken along a dash-dot line 41E-41F of FIG. 41A.

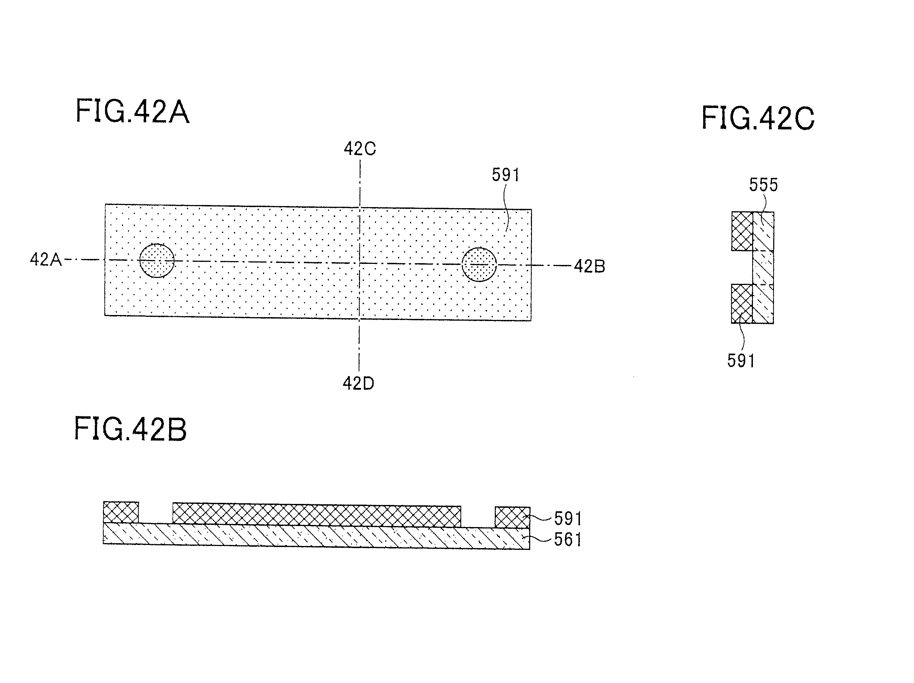

Next, side substrates 561 and 562 are formed such that the side substrates 561 and 562 will be respectively connected to recesses 551 and 552 formed surfaces of the central substrate 560. Specifically, a resist pattern 591 is formed on a silicon substrate 555 serving as the side substrate 561 as illustrated in FIGS. 42A to 42C. Specifically, a photoresist is applied to the silicon substrate 555, and the photoresist applied silicon substrate 555 is then exposed to light for performing the development utilizing the exposure device, thereby forming a resist pattern 591. The thus formed resist pattern 591 includes later described openings serving as holes formed in respective regions of the side substrate 561. A process similar to the above-described one carried out on the side substrate 561 is conducted on the side substrate 562. In the fourth embodiment, the silicon base 555 is formed of a silicon substrate having a thickness of approximately 100 $\mu$m. Note that FIG. 42A is a top view illustrating the silicon substrate undergoing the above-described fabrication process, FIG. 42B is a sectional view taken along a dash-dot line 42A-42B of FIG. 42A, and FIG. 42C is a sectional view taken along a dash-dot line 42C-42D of FIG. 42A.

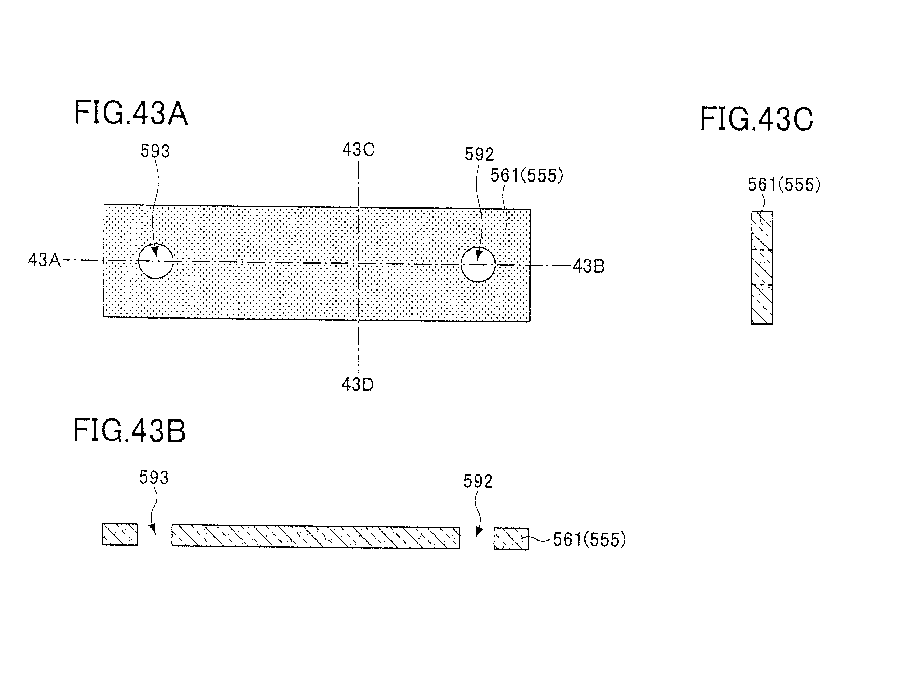

Next, portions of silicon is removed by deep reactive ion etching (DRIE) in regions of the silicon substrate 555 where the resist pattern 591 is not formed, thereby allowing the regions to penetrate the silicon substrate 555 as illustrated in FIGS. 43A to 43C. Thus, two holes 592 and 593 are formed in the silicon substrate (see FIGS. 43A and 43B). The holes 592 and 593 are utilized as a channel inlet or a channel outlet. The holes 592 and 593 are configured to introduce the coolant into the channels 531a and 531b or discharge the coolant from the channels 531a and 531b. The holes 592 and 593 are formed in the side substrate 561 one near each end of the side substrate 561 in a longitudinal direction. Thereafter, the resist pattern 591 is removed with an organic solvent, or the like. The side substrate 561 is thus formed by processing the silicon substrate 550 in this manner. The side substrate 562 is formed in a similar manner as that of the side substrate 561. Note that FIG. 43A is a top view illustrating the silicon substrate undergoing the above-described fabrication process, FIG. 43B is a sectional view taken along a dash-dot line 43A-43B of FIG. 43A, and FIG. 43C is a sectional view taken along a dash-dot line 43C-43D of FIG. 43A.

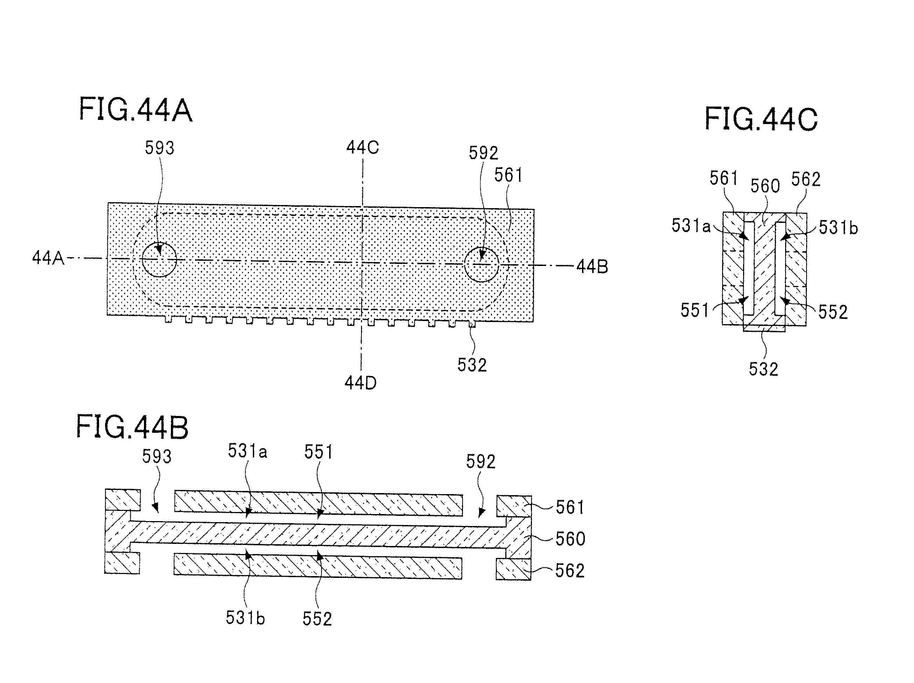

Next, the side substrate 561 is bonded with a recess 551 formed side of the central substrate 560 such that the recess 551 is enclosed with the side substrate 561, thereby forming the channel 531a as illustrated in FIGS. 44A to 44C. Likewise, the side substrate 562 is bonded with a recess 552 formed side of the central substrate 560 such that the recess 552 is enclosed with the side substrate 562, thereby forming the channel 531b. In the fourth embodiment, examples of the bonding method of the central substrate 560 with the side substrates 561 and 562 include a direct bonding where the central substrate 560 is directly bonded with the side substrates 561 and 562, a eutectic bonding where the central substrate 560 is bonded with the side substrates 561 and 562 via a metallic film formed in bonding parts between the central substrate 560 and a corresponding one of the side substrates 561 and 562, or a bonding method utilizing a bonding material. Note that FIG. 44A is a top view illustrating the silicon substrate undergoing the above-described fabrication process, FIG. 44B is a sectional view taken along a dash-dot line 44A-44B of FIG. 44A, and FIG. 44C is a sectional view taken along a dash-dot line 44C-44D of FIG. 44A.

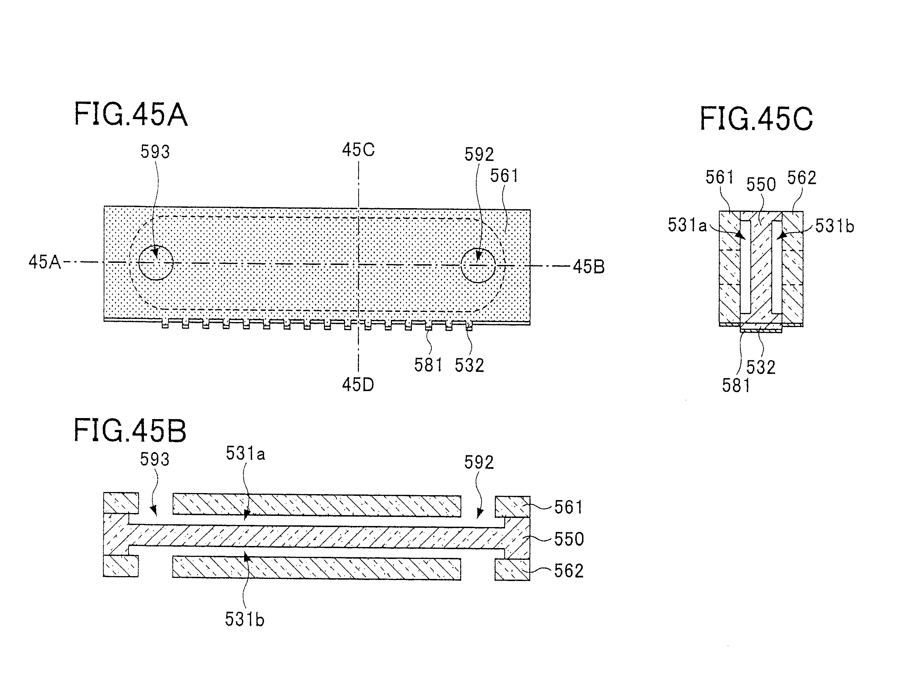

Next, a gold-plated layer 581 is formed on the projection 532 formed surface of the silicon substrate 550 (or 560) as illustrated in FIGS. 45A to 45C. As illustrated in FIG. 45A, the gold-plated layer 581 is formed over the entire surface of the silicon substrate 550 on which projections 532 are formed (i.e., the gold-plated layer is formed over the projection formed surface of the silicon substrate). Specifically, after a Ti/Au film (Ti: 50 nm/Au: 200 nm) is deposited by sputtering on the projection 532 formed surface of the silicon substrate 550, the projection 532 formed surface of the silicon substrate 550 deposited with the Ti/Au film is subjected to electroless plating, thereby forming the gold-plated layer 581 having a thickness range of 2 to 2.5 $\mu$m over the entire projection 532 formed surface of the silicon substrate 550. The microchannel heat sink 530 serving as the cooling device according to the fourth embodiment is formed in this manner. Note that FIG. 45A is a top view illustrating the silicon substrate undergoing the above-described fabrication process, FIG. 45B is a sectional view taken along a dash-dot line 45A-45B of FIG. 45A, and FIG. 45C is a sectional view taken along a dash-dot line 45C-45D of FIG. 45A.

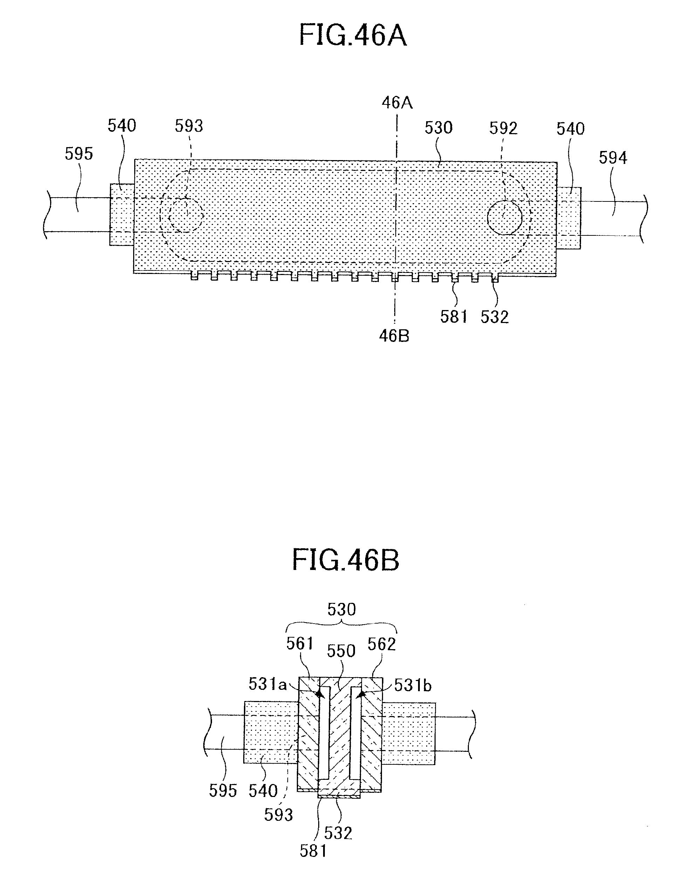

Next, tubes 594 and 595 are fixed by pressure-fixing fixtures 540 in the holes 592 and 593 serving as a channel inlet and a channel outlet and respectively formed in the side substrates 561 and 562 as illustrated in FIGS. 46A and 46B. In the fourth embodiment, the tube 594 integrally formed with the pressure-fixing fixture 540 and the tube 595 integrally formed with the pressure-fixing fixture 540 are utilized. Thus, the tube 594 is connected to the hole 592 and the tube 595 is connected to the hole 593 by allowing the microchannel heat sink 530 to be sandwiched between the pressure-fixing fixtures 540 attached one on each end of the microchannel heat sink 530. The pressure-fixing fixtures 540 in this embodiment are formed of resin materials; however, the pressure-fixing fixtures 540 may be formed of metallic materials. Note that FIG. 46A is a side view illustrating the silicon substrate undergoing the above-described fabrication process, and FIG. 46B is a sectional view taken along a dash-dot line 46A-46B of FIG. 46A.

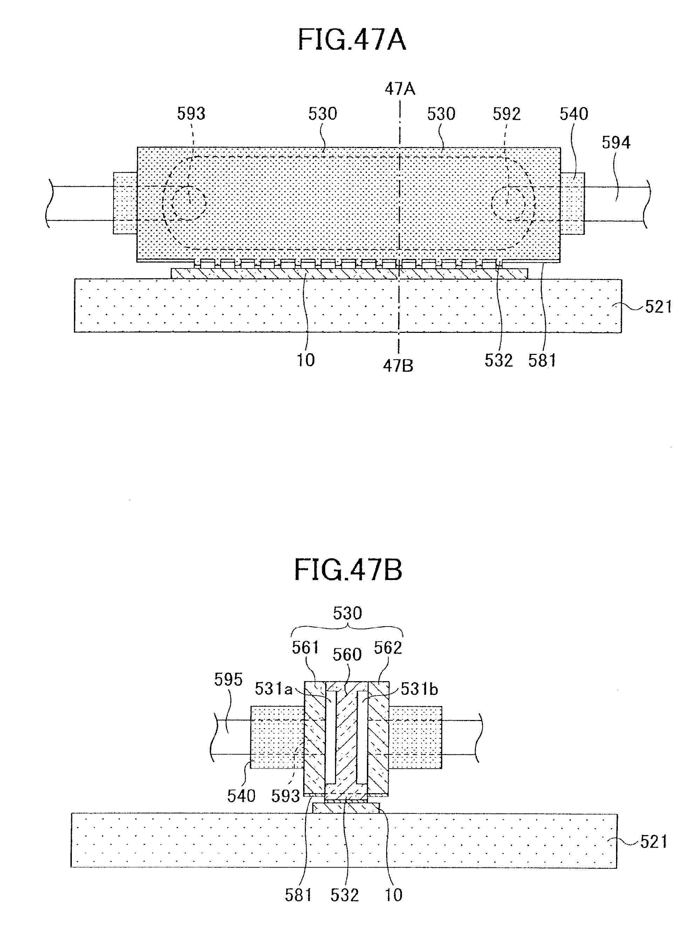

Next, the microchannel heat sink 530 is bonded to the semiconductor chip 10 mounted on the package 521 as illustrated in FIGS. 47A and 47B. Specifically, the microchannel heat sink 530 is bonded to the semiconductor chip 10 by bringing the projections 532 of the microchannel heat sink 530 into contact with an exposed surface of the semiconductor chip 10 via the gold-plated layer 581. In this case, the microchannel heat sink 530 is bonded to the semiconductor chip 10 such that the projections 532 of the microchannel heat sink 530 are brought into contact with electrodes 11 (not illustrated in FIGS. 47A and 47B) formed on the exposed surface of the semiconductor chip 10 via the gold-plated layer 581 formed on surfaces of the projections 532. The semiconductor chip 10 includes a high-power transistor and is configured to generate heat when the high-power transistor operates. Note that FIG. 47A is a side view illustrating the silicon substrate undergoing the above-described fabrication process, and FIG. 47B is a sectional view taken along a dash-dot line 47A-47B of FIG. 47A.

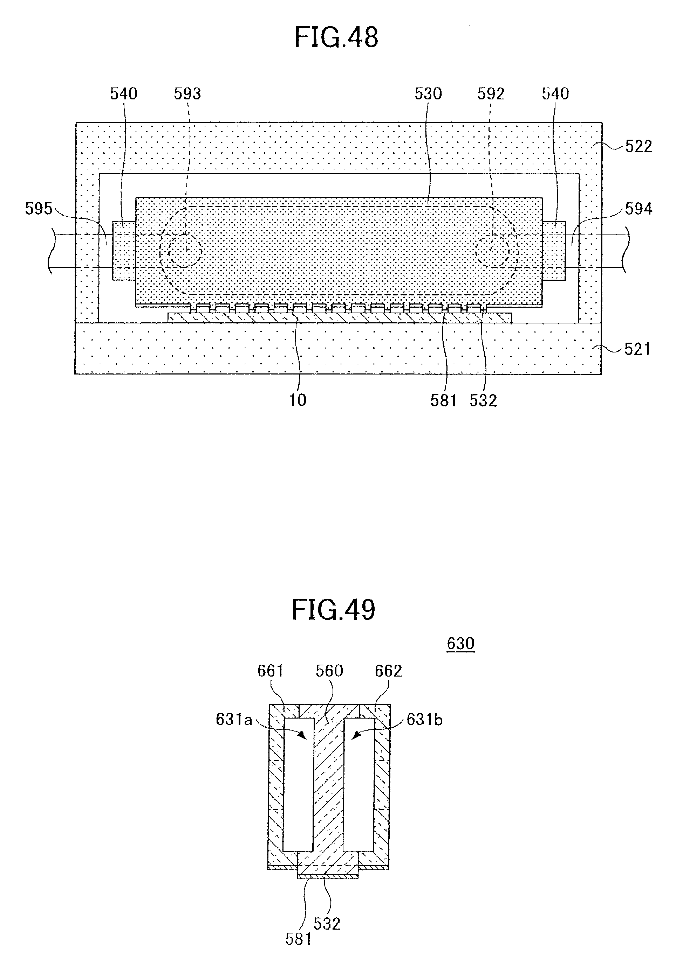

Next, a lid 522 is attached to an upper part of the package 521 such that the semiconductor chip 10 and the microchannel heat sink 530 are enclosed with the package 521 and the lid as illustrated in FIG. 48. The lid 522 is configured such that the tubes 594 and 595 are taken out from the inside of the lid 522 attached to the package 521 to the outside. That is, the lid 522 and the package 521 are sealed such that the inside of the lid 522 and the package 521 is hermetic. Although the tubes 594 and 595 configured to supply or discharge the coolant are exposed to the outside in this case, the content enclosed with the package 521 and the lid 522, in which the semiconductor chip 10 and the microchannel heat sink 530 are situated, is hermetically sealed. The semiconductor device according to the fourth embodiment is thus formed in the above-described manner.

[FIFTH EMBODIMENT]

(COOLING DEVICE)

Next, a semiconductor device and a cooling device according to a fifth embodiment are described. The semiconductor device according to the fifth embodiment is fabricated by processing the silicon substrate in a similar manner as that of the semiconductor device according to the fourth embodiment; however, the semiconductor device according to the fifth embodiment includes channels of a microchannel heat sink having a shape differing from the shape of the channels of the microchannel heat sink according to the fourth embodiment.

A microchannel heat sink 630 serving as the cooling device according to the fifth embodiment is described in more detail with reference to FIG. 49. The microchannel heat sink 630 serving as the cooling device according to the fifth embodiment is fabricated by processing the silicon substrate such that the microchannel heat sink 630 includes side substrates 661 and 662 bonded one with each surface of a central substrate 560. Note that the side substrates 661 and 662 each include a recess that faces a corresponding one of the recesses formed in the central substrate 560. Accordingly, the recess formed in a first surface of the central substrate 560 and the recess formed in the side substrate 661 form a channel 631a, and the recess formed in a second surface of the central substrate 560 and the recess formed in the side substrate 662 form a channel 631b. With this configuration, the channels 631a and 631b may have large cross sections in a direction perpendicular to a direction in which the coolant is running, which may allow more of the coolant to run through the channels 631a and 631b. As a result, the microchannel heat sink 630 having the channels 331a and 631b may exhibit an increased cooling efficiency.

(FABRICATION METHOD)

Next, a method for fabricating the cooling device according to the fifth embodiment is described. The microchannel heat sink 630 serving as the cooling device according to the fourth embodiment may be formed by fabricating a silicon (Si) substrate or the like in a substrate surface direction in a similar manner as the fabrication of the cooling device according to the fourth embodiment. Note that the central substrate 560 of the microchannel heat sink 630 according to the fifth embodiment is fabricated in a similar manner as the fabrication of the central substrate 560 of the microchannel heat sink 530 according to the fourth embodiment (see FIG. 48). Specifically, the central substrate 560 of the microchannel heat sink 630 according to the fifth embodiment is fabricated by the processes illustrated in FIGS. 31A to 41D.

Below, a method for fabricating side substrates 661 and 662 of the microchannel heat sink 630 serving as the cooling device according to the first embodiment is described with the side substrate 661 as an example. Note that the side substrate 662 may be fabricated in the same fabrication process as that of the side substrate 661.

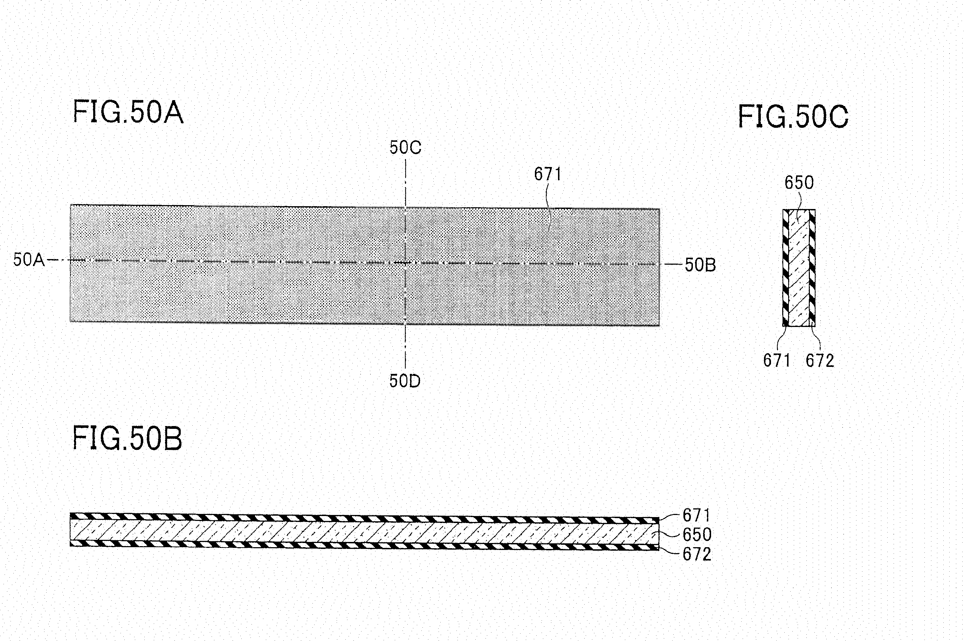

Initially, oxide films 671 and 672 are formed one on each surface of a silicon substrate 650 as illustrated in FIGS. 50A to 50C. Specifically, the oxide films 671 and 672 are respectively formed on a surface and a rear surface of the silicon substrate 650 by chemical vapor deposition (CVD) or thermal oxidation. The silicon substrate may be doped with various impurity elements so that the silicon substrate may have conductivity. Examples of the impurity elements include p-type impurity elements such as boron (B) or n-type impurity elements such as phosphorus (P) or antimony (Sb). Further, since the microchannel heat sink 630 is formed by forming a pattern on a surface of the silicon substrate 650 or etching the surface of the silicon substrate 650, the surface of the silicon substrate 650 may preferably be flat. Thus, the surface and the rear surface of the silicon substrate 650 may preferably be mirror finished. In the fifth embodiment, the oxide films 671 and 672 are formed on the silicon substrate 650 by plasma chemical vapor deposition (plasma CVD) such that the oxide films 671 and 672 include a thickness range of 1 to 2 $\mu$m. Note that FIG. 50A is a top view illustrating the silicon substrate (the surface of the silicon substrate 650 in which a recess will be formed; that is, the surface of the silicon substrate 650 on which the oxide film 671 is formed) undergoing the above-described fabrication process, FIG. 50B is a sectional view taken along a dash-dot line 50A-50B of FIG. 50A, and FIG. 50C is a sectional view taken along a dash-dot line 50C-50D of FIG. 50A.

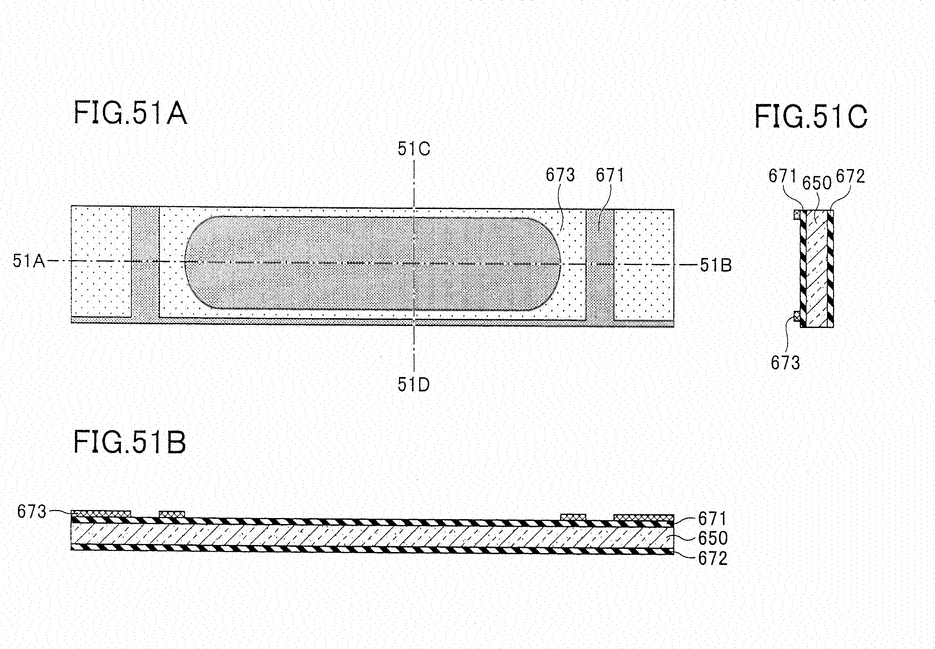

Next, a resist pattern 673 is formed on the surface of the oxide film 671 as illustrated in FIGS. 51A to 51C. Specifically, after a photoresist is applied to the surface of the oxide film 671 and the photoresist applied surface of the oxide film 671 is prebaked, the prebaked oxide film 671 is exposed to light for performing the development utilizing an exposure device, thereby forming the resist pattern 673 having openings corresponding to regions from which the oxide film 671 is removed. In this case, the resist may optionally be applied to the entire surface of the silicon substrate 650 on which an oxide film 672 is formed. Note that FIG. 51A is a top view illustrating the silicon substrate undergoing the above-described fabrication process, FIG. 51B is a sectional view taken along a dash-dot line 51A-51B of FIG. 51A, and FIG. 51C is a sectional view taken along a dash-dot line 51C-51D of FIG. 51A.

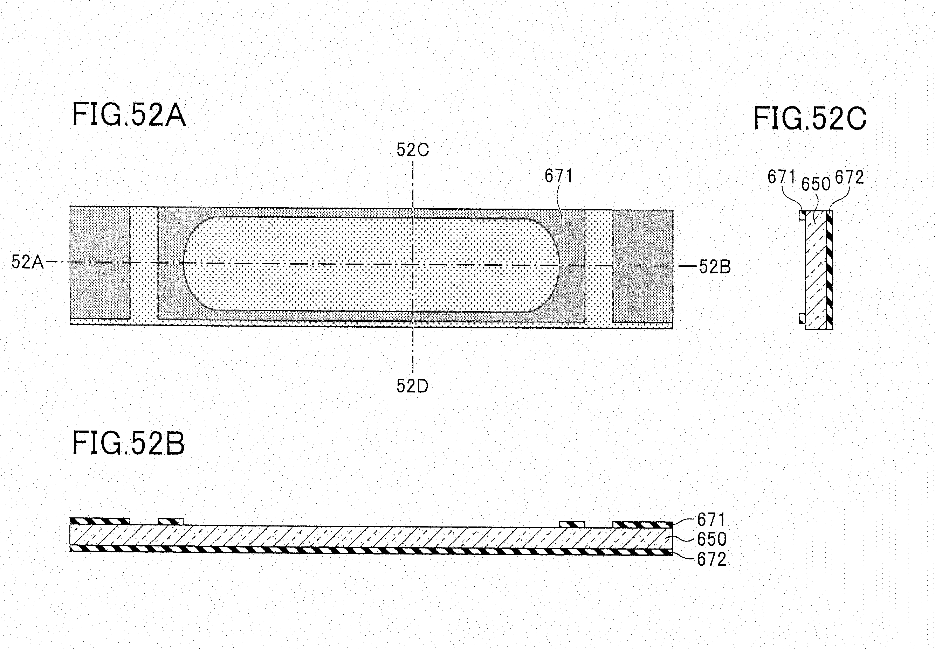

Next, the oxide film 671 in regions where the resist pattern 673 is not formed is removed by reactive ion etching (RIE) or wet etching as illustrated in FIGS. 52A to 52D. Specifically, the oxide film 671 is removed from the regions where the resist pattern 673 is not formed by carrying out buffered hydrofluoric acid (BHF) etching for a predetermined time. Thereafter, the resist pattern 673 is removed with an organic solvent, or the like. A mask formed of the oxide film 671 is formed in this manner. Note that FIG. 52A is a top view illustrating the silicon substrate undergoing the above-described fabrication process, FIG. 52B is a sectional view taken along a dash-dot line 52A-52B of FIG. 52A, and FIG. 52C is a sectional view taken along a dash-dot line 52C-52D of FIG. 52A.

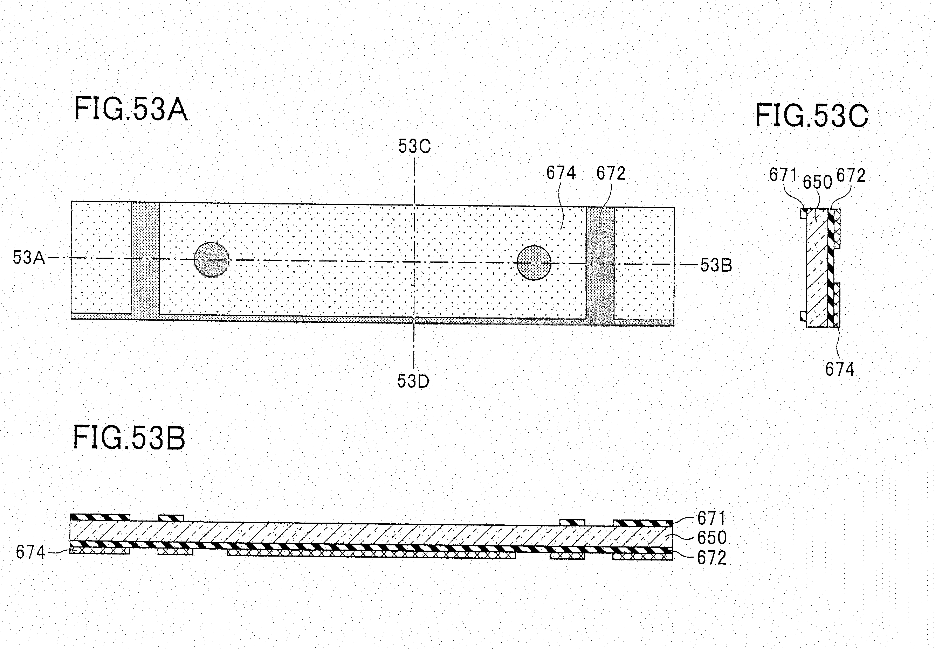

Next, a resist pattern 674 is formed on the surface of the oxide film 672 as illustrated in FIGS. 53A to 53C. Specifically, after a photoresist is applied to the surface of the oxide film 672 and the photoresist applied surface of the oxide film 672 is prebaked, the prebaked oxide film 672 is exposed to light for performing the development utilizing an exposure device, thereby forming the resist pattern 674 having openings corresponding to regions from which the oxide film 672 is removed. Note that FIG. 53A is a bottom view illustrating the silicon substrate (a surface the silicon substrate 650 opposite to the surface in which a recess will be formed; that is, the surface of the silicon substrate 650 on which the oxide film 672 is formed) undergoing the above-described fabrication process, FIG. 53B is a sectional view taken along a dash-dot line 53A-53B of FIG. 53A, and FIG. 53C is a sectional view taken along a dash-dot line 53C-53D of FIG. 53A.

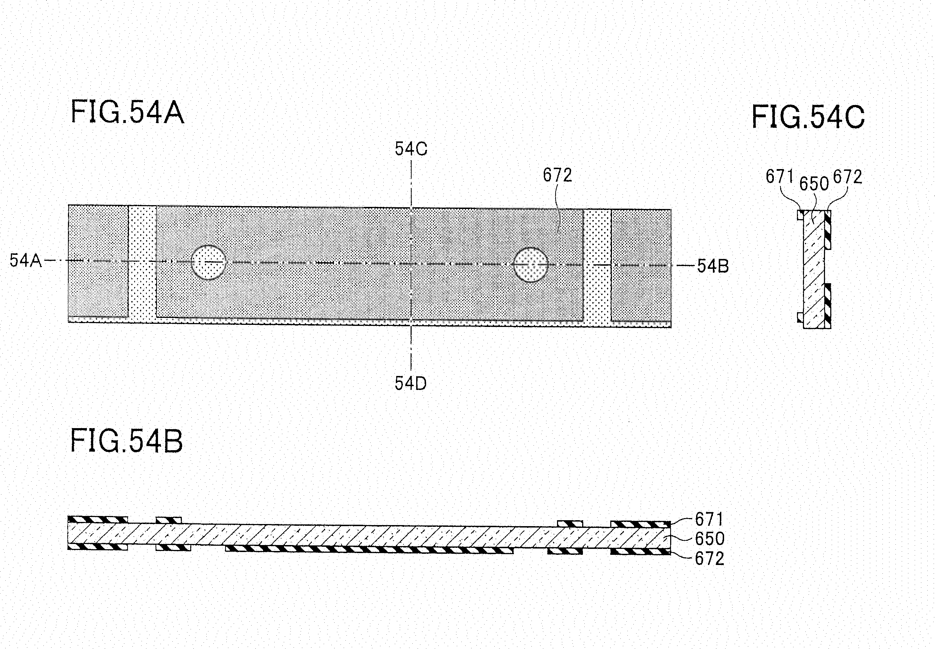

Next, the oxide film 672 formed in regions where the resist pattern 674 is not formed is removed by reactive ion etching (RIE) or wet etching as illustrated in FIGS. 54A to 54C. Specifically, the oxide film 672 is removed from the regions where the resist pattern 674 is not formed by carrying out buffered hydrofluoric acid (BHF) etching for a predetermined time. Thereafter, the resist pattern 674 is removed with an organic solvent, or the like. A mask formed of the oxide film 672 is formed in this manner. Note that FIG. 54A is a top view illustrating the silicon substrate undergoing the above-described fabrication process, FIG. 54B is a sectional view taken along a dash-dot line 54A-54B of FIG. 54A, and FIG. 54C is a sectional view taken along a dash-dot line 54C-54D of FIG. 54A.

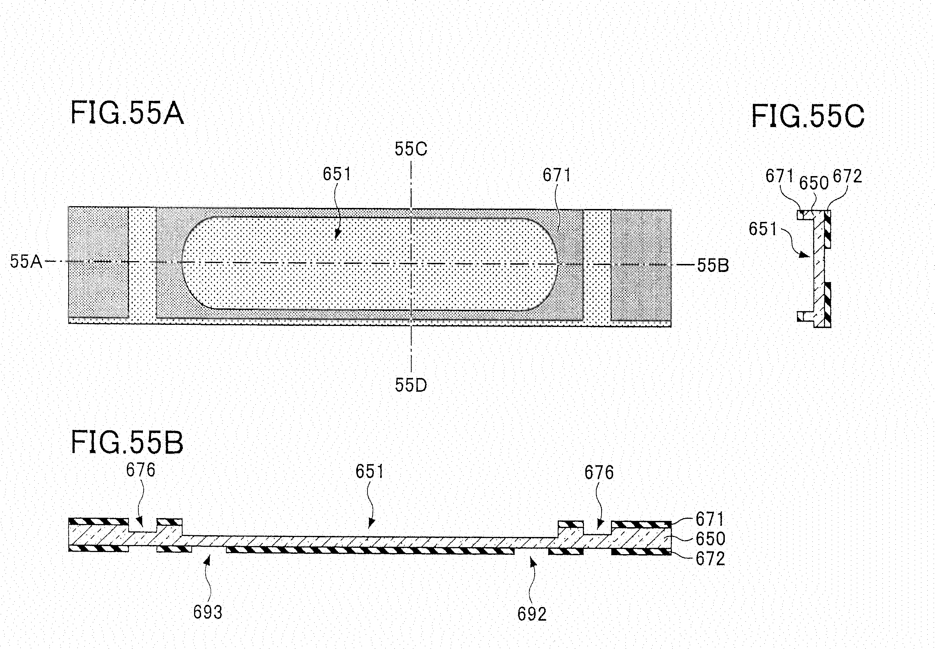

Next, a recess 651 is formed in the oxide film 671 formed surface of the silicon substrate 650 as illustrated in FIGS. 55A to 55C. Specifically, silicon is selectively removed by deep reactive ion etching (DRIE) in the oxide film 671 formed surface of the silicon substrate 650, thereby forming the recess 651. The recess 651 is formed by removing a portion of the silicon substrate 650 to a predetermined depth in a region where the oxide film 671 is not formed. At this time, grooves 676 are formed simultaneously with the formation of the recess 651. Note that FIG. 55A is a top view illustrating the silicon substrate undergoing the above-described fabrication process, FIG. 55B is a sectional view taken along a dash-dot line 55A-55B of FIG. 55A, and FIG. 55C is a sectional view taken along a dash-dot line 55C-55D of FIG. 55A.

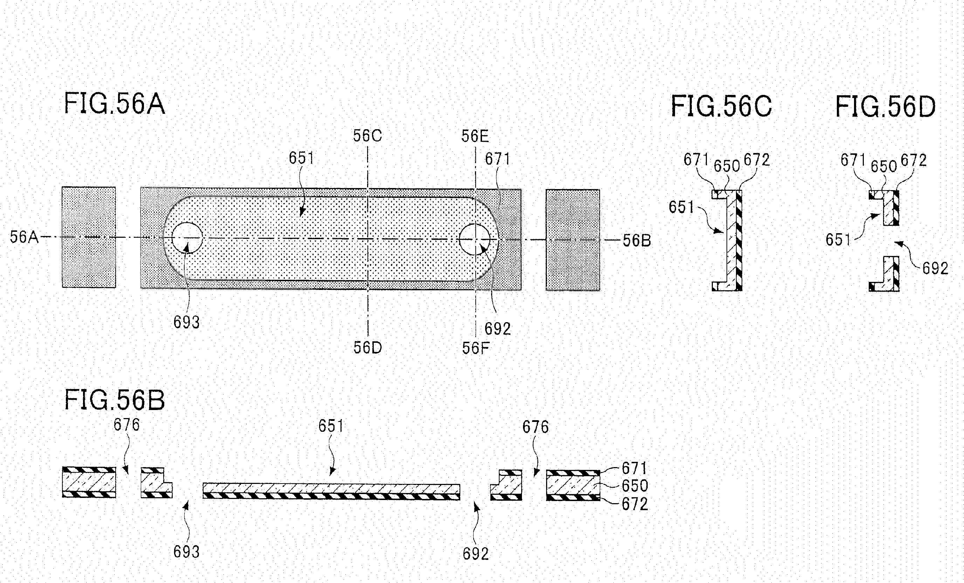

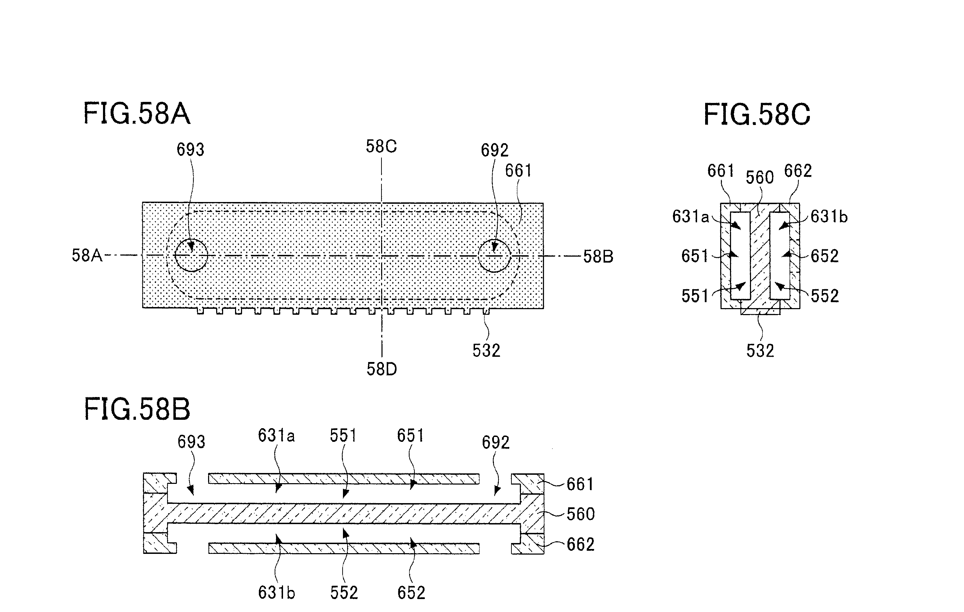

Next, portions of the silicon substrate 650 are removed by carrying out deep reactive ion etching (DRIE) in a direction from the oxide film 672 formed surface of the silicon substrate 650, thereby forming holes 692 and 693, as illustrated in FIGS. 56A to 56D. Specifically, portions of the silicon substrate 650 where the oxide film 672 is not formed are removed by deep reactive ion etching (DRIE), thereby allowing the holes 692 and 693 to penetrate the silicon substrate 65. Thus, two holes (i.e., through-holes) 692 and 693 are formed in the silicon substrate 650 (see FIGS. 56A to 56D). The holes 692 and 693 are utilized as a channel inlet or a channel outlet. The holes 692 and 693 are configured to introduce the coolant into channels 631a and 631b (see FIGS. 58A to 58C) or discharge the coolant from the channels 631a and 631b. The holes 692 and 693 are formed in the side substrate 661 one near each end of the side substrate 661 in a longitudinal direction. At this time, bottom portions of the silicon substrate corresponding to the grooves 676 are simultaneously removed by carrying out deep reactive ion etching (DRIE) in a direction from a bottom side to a top side of the silicon substrate 650, thereby allowing the grooves 676 to penetrate the silicon substrate 650. Accordingly, the silicon substrate 650 is divided into separate regions that form the side substrates 661 of the microchannel heat sinks 630. Note that FIG. 56A is a top view illustrating the silicon substrate undergoing the above-described fabrication process, FIG. 56B is a sectional view taken along a dash-dot line 56A-56B of FIG. 56A, FIG. 56C is a sectional view taken along a dash-dot line 56C-56D of FIG. 56A, and FIG. 56D is a sectional view taken along a dash-dot line 56E-56F of FIG. 56A.

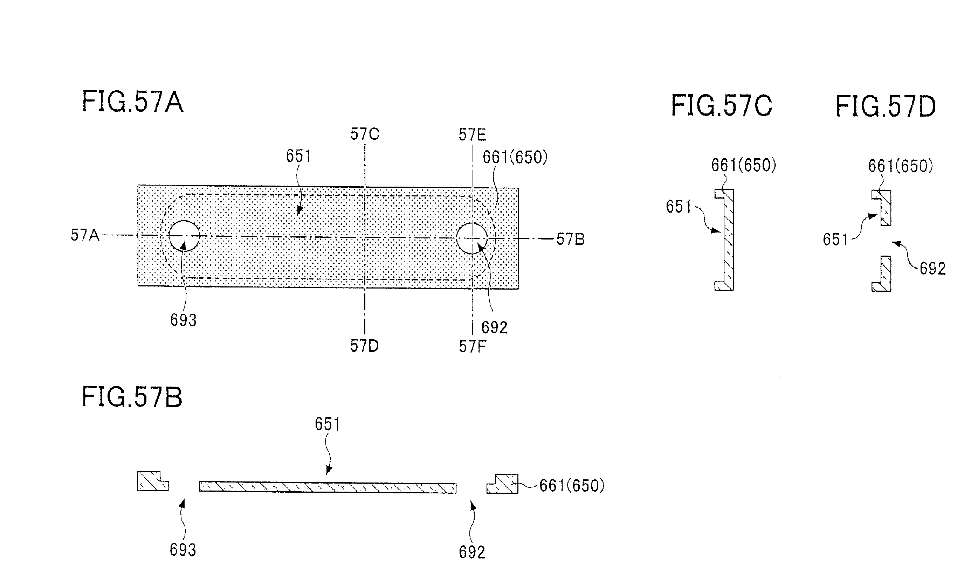

Next, the oxide films 671 and 672 are removed as illustrated in FIGS. 57A to 57D. Specifically, the oxide films 671 and 672 are removed by wet etching such as buffered hydrofluoric acid (BHF) etching. The side substrate 661 is formed by processing the silicon substrate 650 in this manner. Note that the side substrate 662 may be formed in a similar manner as the formation of the side substrate 661. Note that FIG. 57A is a top view illustrating the silicon substrate undergoing the above-described fabrication process, FIG. 57B is a sectional view taken along a dash-dot line 57A-57B of FIG. 57A, FIG. 57C is a sectional view taken along a dash-dot line 57C-57D of FIG. 57A, and FIG. 57D is a sectional view taken along a dash-dot line 57E-57F of FIG. 57A.

Next, the recess 551 formed surface of the central substrate 560 is bonded with the recess 651 formed surface of the side substrate 661 such that the recess 551 formed surface of the central substrate 560 faces the recess 651 formed surface of the side substrate 661. As a result, the channel 631a is formed between the recess 551 of the central substrate 560 and the recess 651 of the side substrate 661 as illustrated in FIGS. 58A to 58C. Likewise, the recess 552 formed surface of the central substrate 560 is bonded with the recess 652 formed surface of the side substrate 662 such that the recess 552 formed surface of the central substrate 560 faces the recess 652 formed surface of the side substrate 662. As a result, the channel 631b is formed between the recess 552 of the central substrate 560 and the recess 652 of the side substrate 662. In the fifth embodiment, examples of the bonding method of the central substrate 560 with the side substrates 661 and 662 include a direct bonding where the central substrate 560 is directly bonded with the side substrates 661 and 662, a eutectic bonding where the central substrate 560 is bonded with the side substrates 661 and 662 via a metallic film formed in bonding parts between the central substrate 560 and a corresponding one of the side substrates 661 and 662, or a bonding method utilizing a bonding material. Note that FIG. 58A is a top view illustrating the silicon substrate undergoing the above-described fabrication process, FIG. 58B is a sectional view taken along a dash-dot line 58A-58B of FIG. 58A, and FIG. 58C is a sectional view taken along a dash-dot line 58C-58D of FIG. 58A.

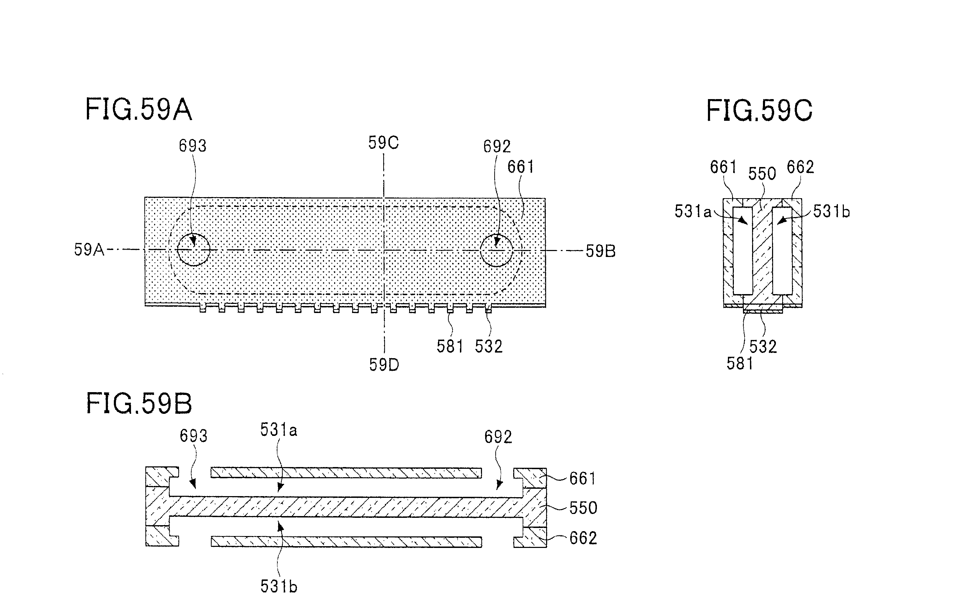

Next, a gold-plated layer 581 is formed on the projection 532 formed surface of the silicon substrate 550 (or central substrate 560) as illustrated in FIGS. 59A to 59C. As illustrated in FIG. 59A, the gold-plated layer 581 is formed over the entire surface of the silicon substrate 550 on which projection 532 are formed (i.e., the gold-plated layer is formed over the projection formed surface of the silicon substrate). Specifically, after a Ti/Au film (Ti: 50 nm/Au: 200 nm) is deposited by sputtering on the projection 532 formed surface of the silicon substrate 550, the projection 532 formed surface of the silicon substrate 550 having deposited the Ti/Au film is subjected to electroless plating, thereby forming the gold-plated layer 581 having a thickness range of 2 to 2.5 $\mu$m over the entire projection 532 formed surface of the silicon substrate 550. The microchannel heat sink 630 serving as the cooling device according to the fifth embodiment is formed in this manner. Note that FIG. 59A is a top view illustrating the silicon substrate undergoing the above-described fabrication process, FIG. 59B is a sectional view taken along a dash-dot line 59A-59B of FIG. 59A, and FIG. 59C is a sectional view taken along a dash-dot line 59C-59D of FIG. 59A.

Thus, the microchannel heat sink 630 serving as the cooling device according to the fifth embodiment is formed in the above-described manner.

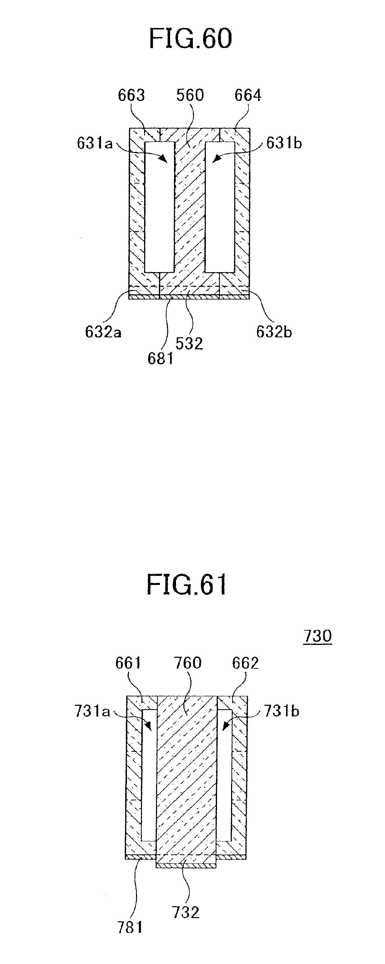

In the cooling device according to the fifth embodiment, the example of the microchannel heat sink 630 having the side substrates on which a projection is not formed is illustrated; however, the microchannel heat sink 630 may have the side substrates on which the projection is formed. Specifically, projections similar to the projection 532 formed in the central substrate 560 may be formed on the respective side substrates 663 and 664 as illustrated in FIG. 60 (i.e., modification of the cooling device according to the fifth embodiment). That is, the projection 632a is formed on the side substrate 663 corresponding to the projection 532 formed on the central substrate 560, and the projection 632b is formed on the side substrate 664 corresponding to the projection 532 formed on the central substrate 560. The central substrate 560 is then bonded with the side substrates 663 and 664 one on each surface of the central substrate 560.

Thereafter, a gold-plated layer 681 may be formed one on each surface of the central substrate 560 and the side substrates 663 and 664 on which the projections 532, 632a and 632b are formed.

The configuration and a fabrication method of the semiconductor device and the cooling device according to the fifth embodiment other than those described above are similar to those of the semiconductor device and the cooling device according to the fourth embodiment. Further, the microchannel heat sink 630 serving as the cooling device according to the fifth embodiment may be incorporated into a semiconductor device similar to the semiconductor device according to the fourth embodiment, and hence, the semiconductor device having the cooling device according to the fifth embodiment may be fabricated in this manner.

[SIXTH EMBODIMENT]

(COOLING DEVICE)

Next, a semiconductor device and a cooling device according to a sixth embodiment are described. The semiconductor device including the cooling device according to the sixth embodiment is fabricated by processing the silicon substrate in a similar manner as that of the fourth embodiment; however, the semiconductor device including the cooling device according to the sixth embodiment includes channels having a shape differing from the shape of the channels in the cooling device (i.e., microchannel heat sink 530) according to the fourth embodiment.

A microchannel heat sink 730 serving as the cooling device according to the sixth embodiment is described in more detail with reference to FIG. 61. The microchannel heat sink 730 serving as the cooling device according to the fifth embodiment is fabricated by processing the silicon substratesuch that the microchannel heat sink 730 includes side substrates 661 and 662 bonded one with each surface of a central substrate 760. The side substrates 661 and 662 each include a recess, and the recess formed surfaces of the side substrates 661 and 662 are bonded one with each surface of the central substrate 760. Accordingly, a channel 731a is formed between the recess formed in the side substrate 661 and one surface of the central substrate 760, and a channel 731b is formed between the recess formed in the side substrate 662 and the other surface of the central substrate 760. Note that a projection 732 is formed on an end surface of the central substrate 760 and a gold-plated layer 781 is formed over the respective end surfaces of the side substrates 661 and 662 on the projection 732 formed end surface of the central substrate 760.

(FABRICATION METHOD)

Next, a method for fabricating the cooling device according to the sixth embodiment is described. The microchannel heat sink 730 serving as the cooling device according to the sixth embodiment may be formed by fabricating a silicon (Si) substrate or the like in a substrate surface direction in a similar manner as the fabrication of the cooling device according to the fourth embodiment. Note that the side substrates 661 and 662 of the microchannel heat sink 730 according to the sixth embodiment are fabricated in a similar manner as the fabrication of the side substrates of the microchannel heat sink 630 according to the fifth embodiment. Specifically, the side substrates 661 and 662 of the microchannel heat sink 730 according to the sixth embodiment are fabricated by the processes illustrated in FIGS. 50A to 57D.

Below, the method for fabricating the central substrate 760 of the microchannel heat sink 730 serving as the cooling device according to the sixth embodiment is illustrated.

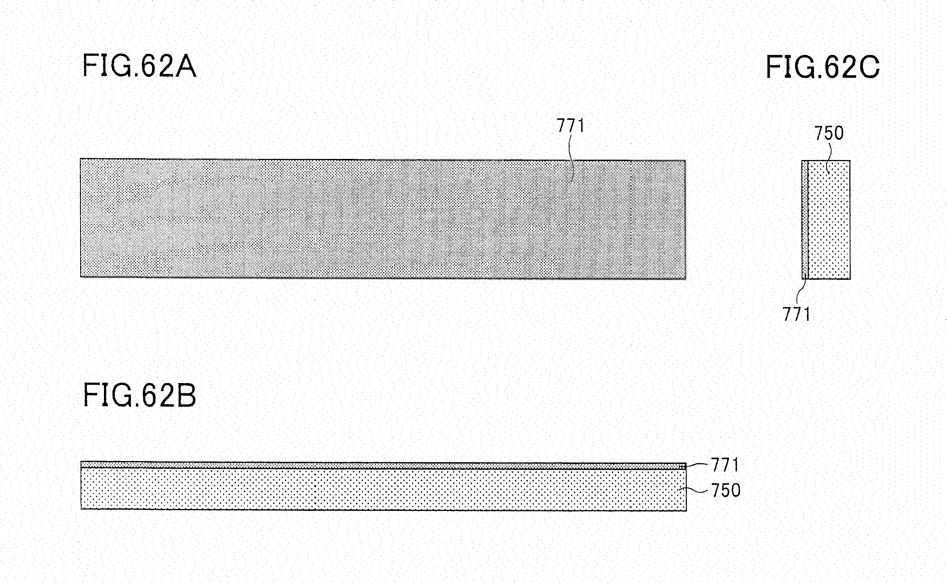

Initially, an oxide film 771 is formed on one surface of a silicon substrate 750 as illustrated in FIGS. 62A to 62C. Specifically, the oxide film 771 is formed on the surface of the silicon substrate 750 by chemical vapor deposition (CVD) or thermal oxidation. The silicon substrate 750 may be doped with various impurity elements so that the silicon substrate 750 may have conductivity. Examples of the impurity elements include p-type impurity elements such as boron (B) or n-type impurity elements such as phosphorus (P) or antimony (Sb). A frequently used thickness of the silicon substrate 750 may be in a range of 200 to 525 $\mu$m in general; however, the thickness of the silicon substrate 750 may preferably vary with the width or the size of the semiconductor chip 10. In the sixth embodiment, the silicon substrate 750 is formed of a silicon substrate having a thickness of approximately 200 $\mu$m. Further, since the microchannel heat sink 730 is formed by forming a pattern on a surface of the silicon substrate 750 or etching the surface of the silicon substrate 750, the surface of the silicon substrate 750 may preferably be flat. Thus, the two surfaces of the silicon substrate 750 may preferably be mirror finished. In the sixth embodiment, the oxide film 771 is formed on the silicon substrate 750 by plasma chemical vapor deposition (plasma CVD) such that the oxide film 771 includes a thickness range of 1 to 2 $\mu$m. Note that FIG. 62A is a top view illustrating the silicon substrate undergoing the above-described fabrication process, FIG. 62B is a side view of the silicon substrate viewed from a lateral direction, and FIG. 62C is a side view of the silicon substrate viewed from a longitudinal direction.

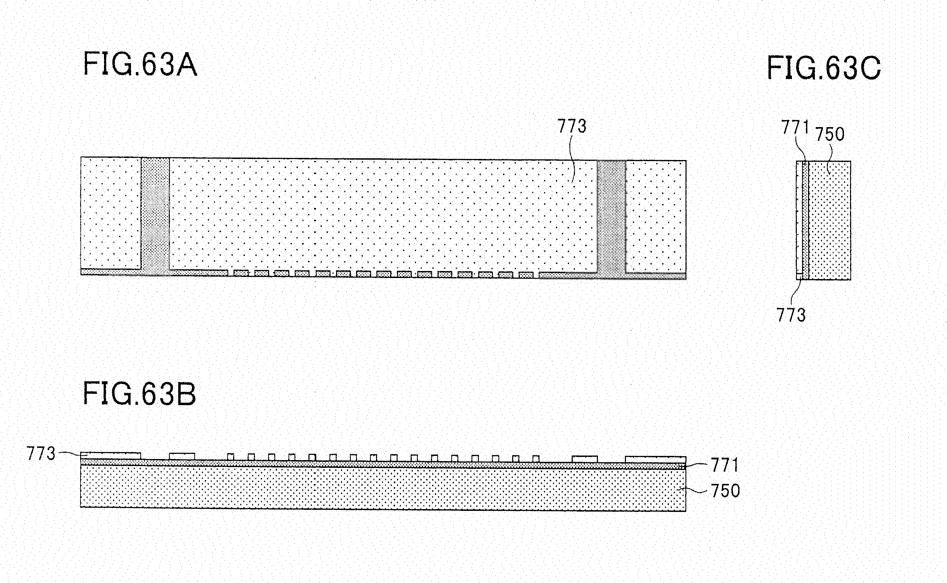

Next, a resist pattern 773 is formed on a surface of the oxide film 771 as illustrated in FIGS. 63A to 63C. Specifically, after a photoresist is applied to the surface of the oxide film 771 and the photoresist applied surface of the oxide film 771 is prebaked, the prebaked oxide film 771 is exposed to light for performing the development utilizing an exposure device, thereby forming the resist pattern 773 having openings corresponding to regions from which the oxide film 771 is removed. Note that FIG. 63A is a top view illustrating the silicon substrate 750 undergoing the above-described fabrication process, and FIG. 63B is a side view of the silicon substrate 750 viewed from a lateral direction, and FIG. 63C is a side view of the silicon substrate 750 viewed from a longitudinal direction.

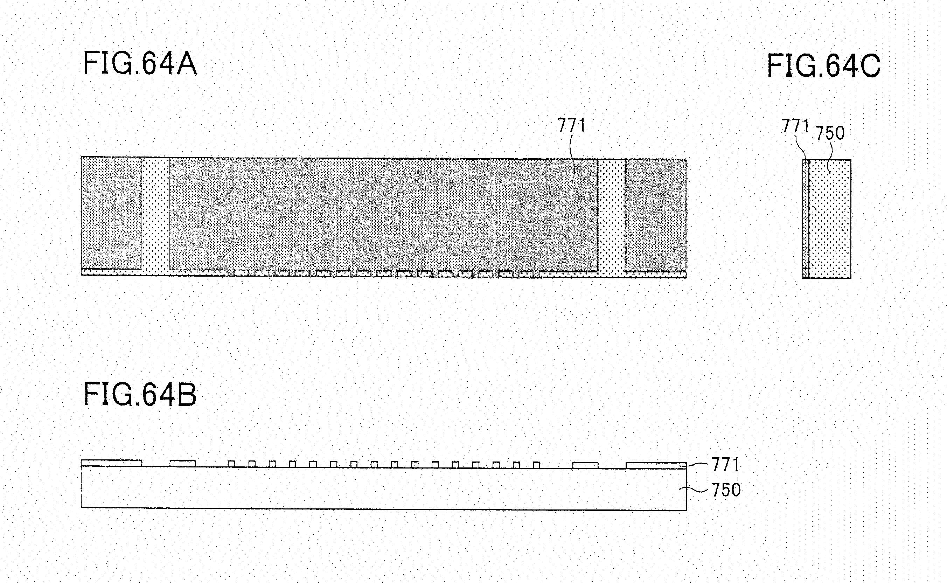

Next, the oxide film 771 formed in regions where the resist pattern 773 is not formed is removed by reactive ion etching (RIE) or wet etching as illustrated in FIGS. 64A to 64C. Specifically, the oxide film 771 is removed from the regions where the resist pattern 773 is not formed by carrying out buffered hydrofluoric acid (BHF) etching for a predetermined time. Thereafter, the resist pattern 773 is removed with an organic solvent, or the like. Note that FIG. 64A is a top view illustrating the silicon substrate 750 undergoing the above-described fabrication process, and FIG. 64B is a side view of the silicon substrate 750 viewed from a lateral direction, and FIG. 64C is a side view of the silicon substrate 750 viewed from a longitudinal direction.

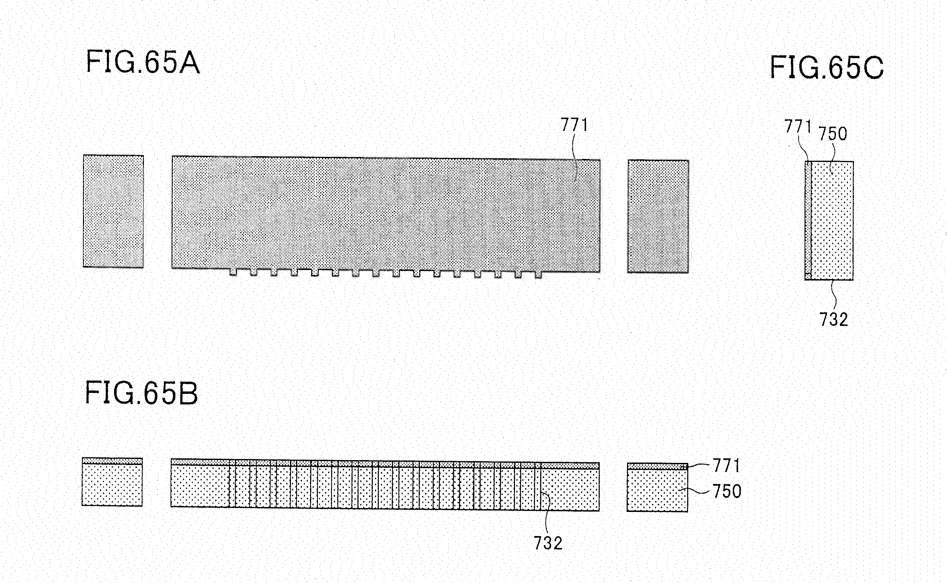

Next, portions of silicon are removed by deep reactive ion etching (DRIE) in regions of the silicon substrate 750 where the oxide film 771 is not formed as illustrated in FIGS. 65A to 65C. Accordingly, projections 732 are formed by eliminating a portion of silicon around the projections 732. Note that FIG. 65A is a top view illustrating the silicon substrate undergoing the above-described fabrication process, FIG. 65B is a side view of the silicon substrate viewed from a lateral direction, and FIG. 65C is a side view of the silicon substrate viewed from a longitudinal direction.

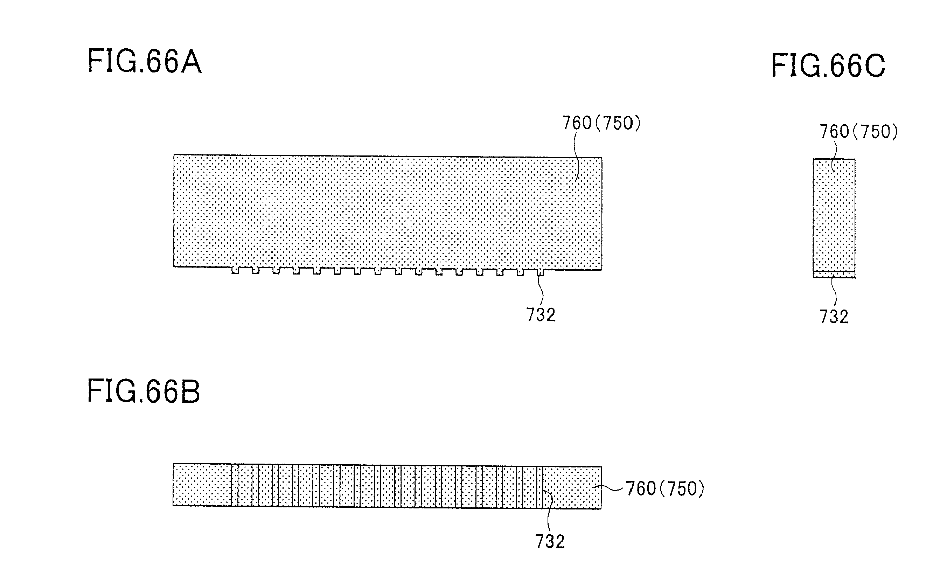

Next, the oxide film 771 is removed as illustrated in FIGS. 66A to 66C. Specifically, the oxide film 771 is removed by wet etching such as buffered hydrofluoric acid (BHF) etching. A central substrate 760 is formed by processing the silicon substrate 750 in this manner. Note that FIG. 66A is a top view illustrating the silicon substrate 750 undergoing the above-described fabrication process, FIG. 66B is a side view of the silicon substrate 750 viewed from a lateral direction, and FIG. 66C is a side view of the silicon substrate 750 viewed from a longitudinal direction.

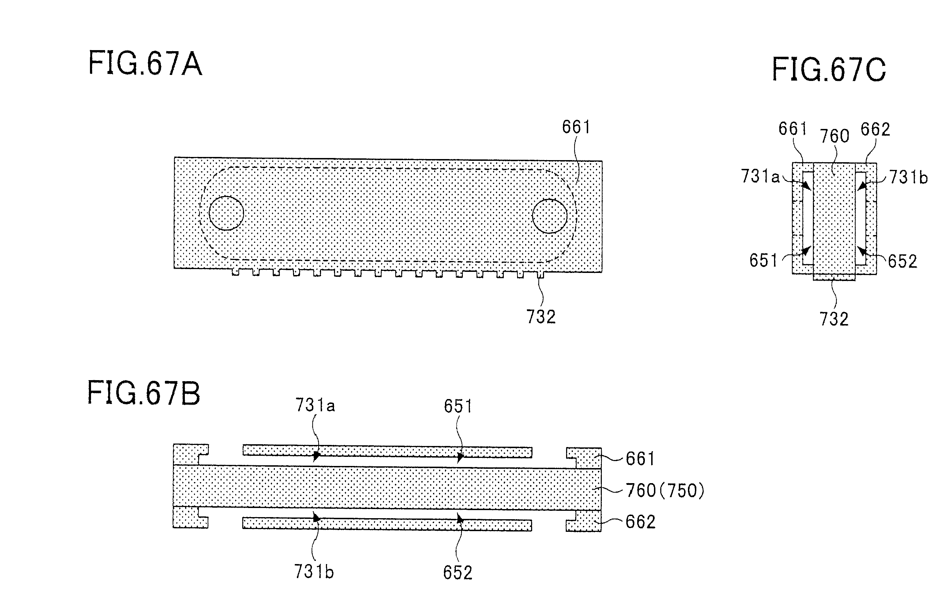

Next, the central substrate 760 is bonded with the side substrates 661 and 662 one on each surface of the central substrate 760 as illustrated in FIGS. 67A to 67C. Note that the side substrates 661 and 662 have configurations illustrated in FIGS. 57A to 57D, and the side substrate 661 is bonded with one surface of the central substrate 760 and the side substrate 662 is bonded with the other surface of the central substrate 760, thereby forming channels 731a and 731b. Specifically, the channel 731a is formed between the recess 651 formed surface of the side substrate 661 and the central substrate 760 (i.e., the channel 731a is formed by being enclosed with the recess 651 formed surface of the side substrate 661 and the central substrate 760). Further, the channel 731b is formed between the recess 652 formed surface of the side substrate 662 and the other surface of the central substrate 760 (i.e., the channel 731b is formed by being enclosed with the recess 652 formed surface of the side substrate 662 and the central substrate 760). In the sixth embodiment, examples of the bonding method of the central substrate 760 with the side substrates 661 and 662 include a direct bonding where the central substrate 760 is directly bonded with the side substrates 661 and 662, a eutectic bonding where the central substrate 760 is bonded with the side substrates 661 and 662 via a metallic film formed in bonding parts between the central substrate 760 and a corresponding one of the side substrates 661 and 662, or a bonding method utilizing a bonding material. Note that FIG. 67A is a top view illustrating the silicon substrate undergoing the above-described fabrication process, and FIG. 67B is a side view of the silicon substrate viewed from a lateral direction, and FIG. 67C is a side view of the silicon substrate viewed from a longitudinal direction.

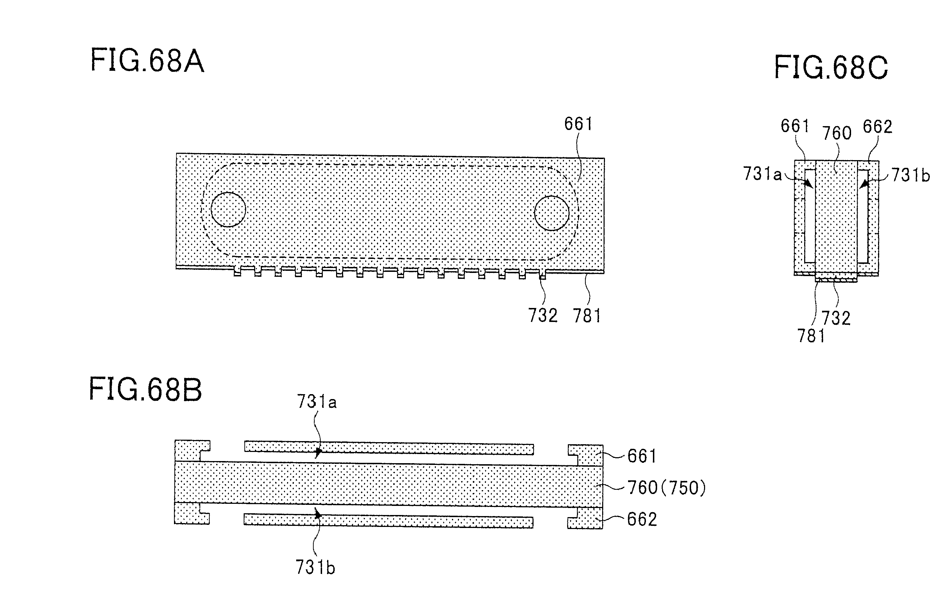

Next, a gold-plated layer 781 is formed on the projection 732 formed surface of the central substrate (silicon substrate) 760 as illustrated in FIGS. 68A to 68C. As illustrated in FIG. 68A, the gold-plated layer 781 is formed over the entire surface of the central substrate 760 on which projections 732 are formed (i.e., the gold-plated layer is formed over the projection formed surface of the central substrate 760). Specifically, after a Ti/Au film is deposited by sputtering on the projection 732 formed surface of the central substrate 760, the projection 732 formed surface of the central substrate 760 having deposited the Ti/Au film is subjected to electroless plating, thereby forming the gold-plated layer 781 having a thickness range of 2 to 2.5 $\mu$m over the entire projection 732 formed surface of the central substrate 760. The microchannel heat sink 730 serving as the cooling device according to the sixth embodiment is formed in this manner. Note that FIG. 68A is a top view illustrating the central substrate 760 undergoing the above-described fabrication process, and FIG. 68B is a side view of the central substrate 760 viewed from a lateral direction, and FIG. 68C is a side view of the central substrate 760 viewed from a longitudinal direction.

Thus, the microchannel heat sink 730 serving as the cooling device according to the sixth embodiment is formed in the above-described manner.

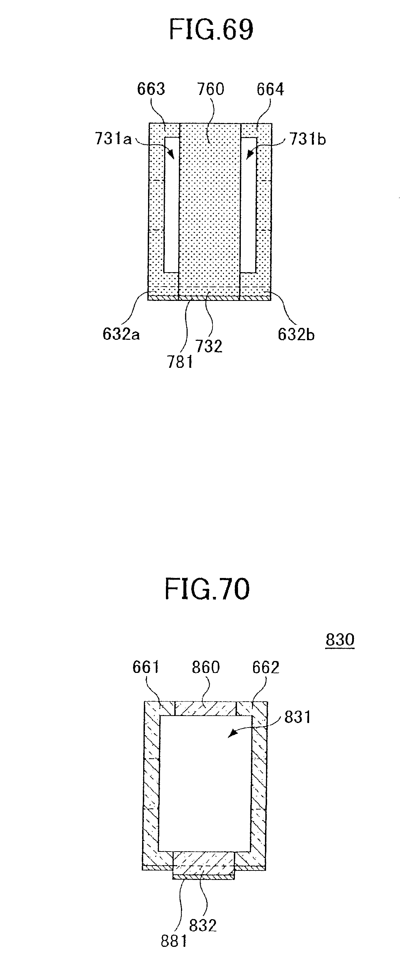

In the cooling device according to the sixth embodiment, the example of the microchannel heat sink 730 having the side substrates on which projections are not formed is illustrated; however, the microchannel heat sink 730 may have the side substrates on which the projections are not formed. Specifically, projections similar to the projections 732 formed in the central substrate 760 may be formed on the respective side substrates 663 and 664 as illustrated in FIG. 69 (i.e. , modification of the cooling device according to the sixth embodiment). That is, the projections 632a may be formed on the side substrate 663 while the projections 632b may be formed on the side substrate 664 in a similar manner as that the projections 732 are formed on the central substrate 760, and the gold-plated layer 781 may be formed over the respective end surfaces of the central substrate 760 and the side substrates 603 and 604 on which the projections 732, 632a and 632b are formed.

The configuration and a fabrication method of the semiconductor device and the cooling device according to the sixth embodiment other than those described above are similar to those of the semiconductor device and the cooling device according to the fourth or fifth embodiment. Further, the microchannel heat sink 730 serving as the cooling device according to the fifth embodiment may be incorporated into a semiconductor device similar to the semiconductor device according to the fourth embodiment, and hence, the semiconductor device having the cooling device according to the sixth embodiment may be fabricated in this manner.

[SEVENTH EMBODIMENT]

(COOLING DEVICE)

Next, a semiconductor device and a cooling device according to a seventh embodiment are described. The semiconductor device including the cooling device according to the seventh embodiment is fabricated by processing the silicon substrate in a similar manner as that of the fourth embodiment; however, the semiconductor device including the cooling device according to the seventh embodiment includes one channel in place of the two channels in the cooling device (i.e., microchannel heat sink ) according to the above-described embodiments.

A microchannel heat sink 830 serving as the cooling device according to the seventh embodiment is described in more detail with reference to FIG. 70. The microchannel heat sink 830 serving as the cooling device according to the seventh embodiment is fabricated by processing the silicon substrate such that the microchannel heat sink 830 includes side substrates 661 and 662 bonded one with each surface of a central substrate 860. Each of the side substrates 661 and 662 includes a recess, and the recess formed surfaces of the side substrates 661 and 662 are bonded with the central substrate 860. Accordingly, a channel 831 is formed of the recesses formed in the side substrates 661 and 662 and the central substrate 860. Note that a projections 832 are formed on an end surface of the central substrate 860 and a gold-plated layer 881 is formed over the end surfaces of the respective central substrate 860 and the side substrates 661 and 662 having the projections 832 formed on the surface of the central substrate 860.

(FABRICATION METHOD)

Next, a method for fabricating the cooling device according to the seventh embodiment is described. The microchannel heat sink 830 serving as the cooling device according to the seventh embodiment may be formed by fabricating a silicon (Si) substrate or the like in a substrate surface direction in a similar manner as the fabrication of the cooling device according to the fourth embodiment. Note that the side substrates 661 and 662 of the microchannel heat sink 830 according to the seventh embodiment are fabricated in a similar manner as the fabrication of the side substrates of the microchannel heat sink 630 according to the fifth embodiment. Specifically, the side substrates 661 and 662 of the microchannel heat sink 730 according to the sixth embodiment are fabricated by the processes illustrated in FIGS. 50A to 57D.

Below, the method for fabricating the central substrate 860 of the microchannel heat sink 830 serving as the cooling device according to the seventh embodiment is illustrated.

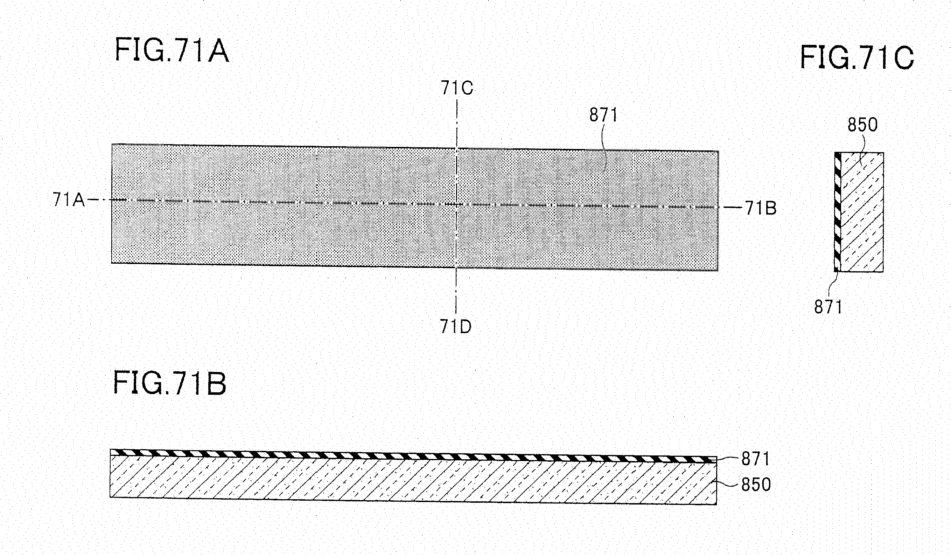

Initially, an oxide film 871 is formed on one surface of a silicon substrate 850 as illustrated in FIGS. 71A to 71C. Specifically, the oxide film 871 is formed on the surface of the silicon substrate 850 by chemical vapor deposition (CVD) or thermal oxidation. The silicon substrate 850 may be doped with various impurity elements so that the silicon substrate 850 may have conductivity. Examples of the impurity elements include p-type impurity elements such as boron (B) or n-type impurity elements such as phosphorus (P) or antimony (Sb). A frequently used thickness of the silicon substrate 850 may be in a range of 200 to 525 $\mu$m in general; however, the thickness of the silicon substrate 850 may preferably vary with the width or the size of the semiconductor chip 10. In the seventh embodiment, the silicon substrate 850 is formed of a silicon substrate having a thickness of approximately 200 $\mu$m. Further, since the microchannel heat sink 830 is formed by forming a pattern on a surface of the silicon substrate 850 or etching the surface of the silicon substrate 850, the surface of the silicon substrate 850 may preferably be flat. Thus, the two surfaces of the silicon substrate 850 may preferably be mirror finished. In the seventh embodiment, the oxide film 871 is formed on the silicon substrate 850 by plasma chemical vapor deposition (plasma CVD) such that the oxide film 871 includes a thickness range of 1 to 2 $\mu$m. Note that FIG. 71A is a top view illustrating the silicon substrate undergoing the above-described fabrication process, FIG. 71B is a sectional view taken along a dash-dot line 71A-71B of FIG. 71A, and FIG. 71C is a sectional view taken along a dash-dot line 71C-71D of FIG. 71A.

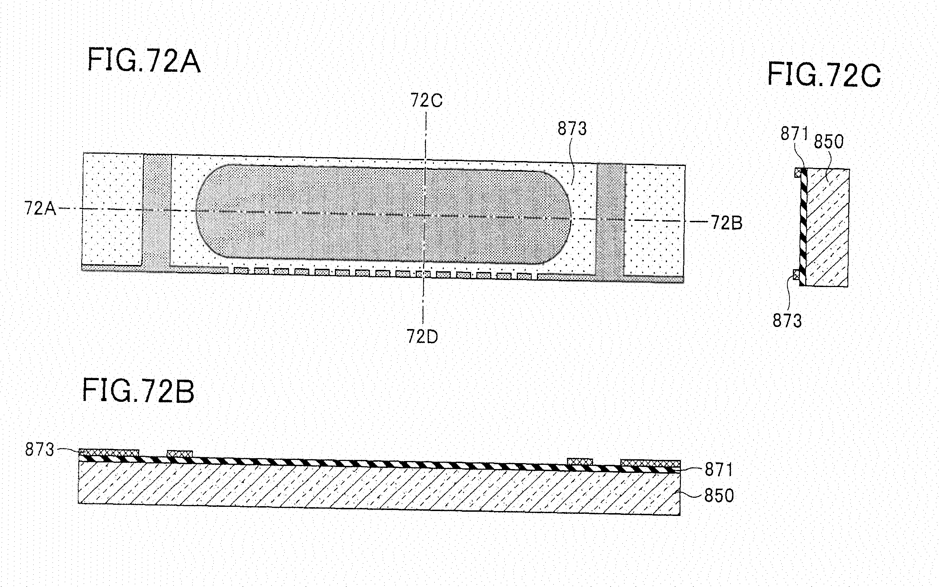

Next, a resist pattern 873 is formed on a surface of the oxide film 871 as illustrated in FIGS. 72A to 72C.

Specifically, after a photoresist is applied to the surface of the oxide film 871 and the photoresist applied surface of the oxide film 871 is prebaked, the prebaked oxide film 871 is exposed to light for performing the development utilizing an exposure device, thereby forming the resist pattern 873 having openings corresponding to regions from which the oxide film 871 is removed. Note that FIG. 72A is a top view illustrating the silicon substrate 850 undergoing the above-described fabrication process, FIG. 72B is a sectional view taken along a dash-dot line 72A-72B of FIG. 72A, and FIG. 72C is a sectional view taken along a dash-dot line 72C-72D of FIG. 72A.

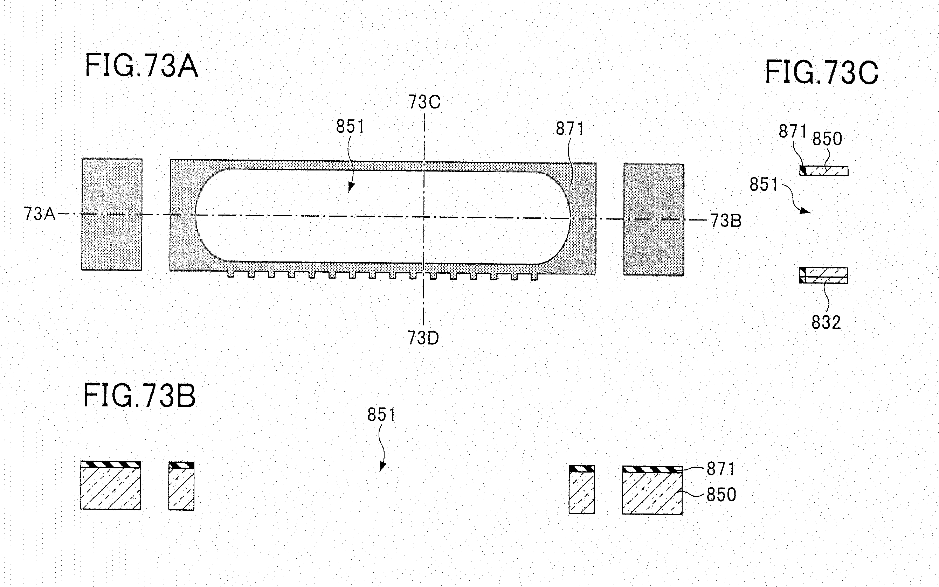

Next, portions of silicon are removed by deep reactive ion etching (DRIE) in regions of the silicon substrate 850 where the oxide film 871 is not formed as illustrated in FIGS. 73A to 73C. Accordingly, a hollow 851 is formed inside the silicon substrate 850, and simultaneously, projections 832 are formed by eliminating portions of silicon around the projections 832. Note that FIG. 73A is a top view illustrating the silicon substrate undergoing the above-described fabrication process, FIG. 73B is a sectional view taken along a dash-dot line 73A-73B of FIG. 73A, and FIG. 73C is a sectional view taken along a dash-dot line 73C-73D of FIG. 73A.

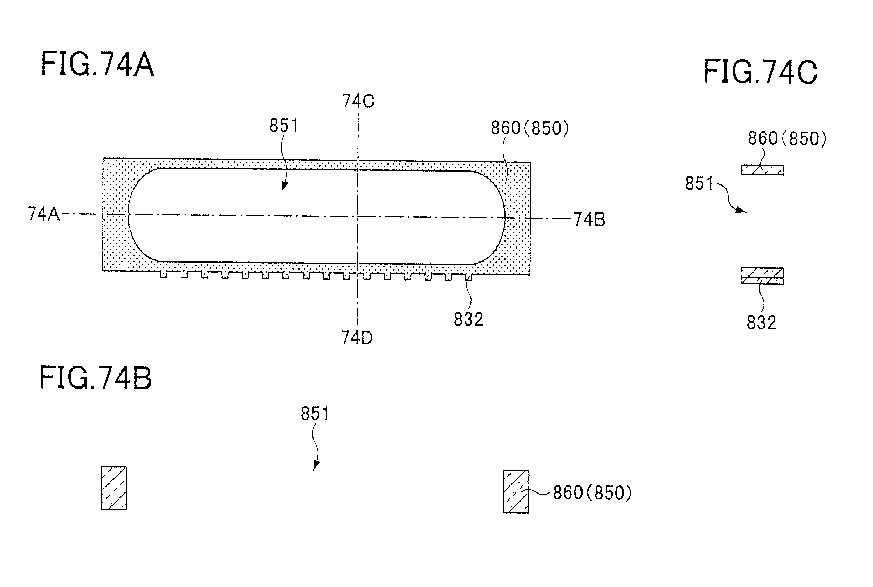

Next, the oxide film 871 is removed as illustrated in FIGS. 74A to 74C. Specifically, the oxide film 871 is removed by wet etching such as buffered hydrofluoric acid (BHF) etching. A central substrate 860 is thus formed by processing the silicon substrate 850 in this manner. Note that FIG. 74A is a top view illustrating the silicon substrate 850 undergoing the above-described fabrication process, FIG. 74B is a sectional view taken along a dash-dot line 74A-74B of FIG. 74A, and FIG. 74C is a sectional view taken along a dash-dot line 74C-74D of FIG. 74A.

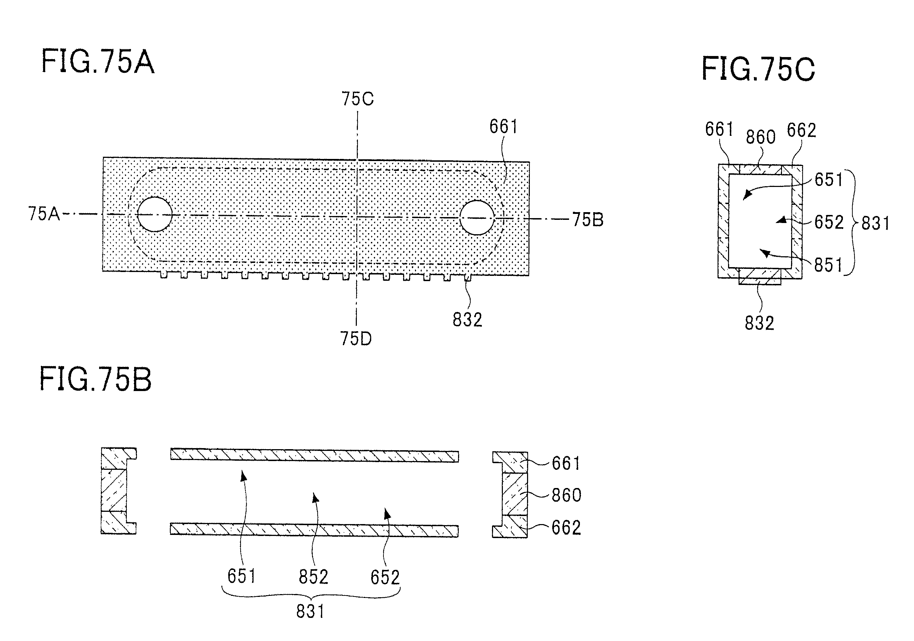

Next, the central substrate 860 is bonded with the side substrates 661 and 662 one on each surface of the central substrate 860 as illustrated in FIGS. 75A to 75C. Note that the side substrates 661 and 662 have configurations illustrated in FIGS. 57A to 57D, and the side substrate 661 is bonded with one surface of the central substrate 860 and the side substrate 662 is bonded with the other surface of the central substrate 860, thereby forming the channel 831. Specifically, the channel 831 is formed by bonding the recess 651 formed surface of the side substrate 661 with the central substrate 860 and bonding the recess 652 formed surface of the side substrate 662 with the central substrate 860. Accordingly, the channel 831 is formed of the recesses formed in the side substrates 661 and 662 and the hollow 851 formed in the central substrate 860. In the seventh embodiment, examples of the bonding method of the central substrate 860 with the side substrates 661 and 662 include a direct bonding where the central substrate 661 is directly bonded with the side substrates 661 and 662, a eutectic bonding where the central substrate 662 is bonded with the side substrates 661 and 662 via a metallic film formed in bonding parts between the central substrate 860 and a corresponding one of the side substrates 661 and 662, or a bonding method utilizing a bonding material. Note that FIG. 75A is a top view illustrating the silicon substrate undergoing the above-described fabrication process, FIG. 75B is a sectional view taken along a dash-dot line 75A-75B of FIG. 75A, and FIG. 75C is a sectional view taken along a dash-dot line 75C-75D of FIG. 75A.

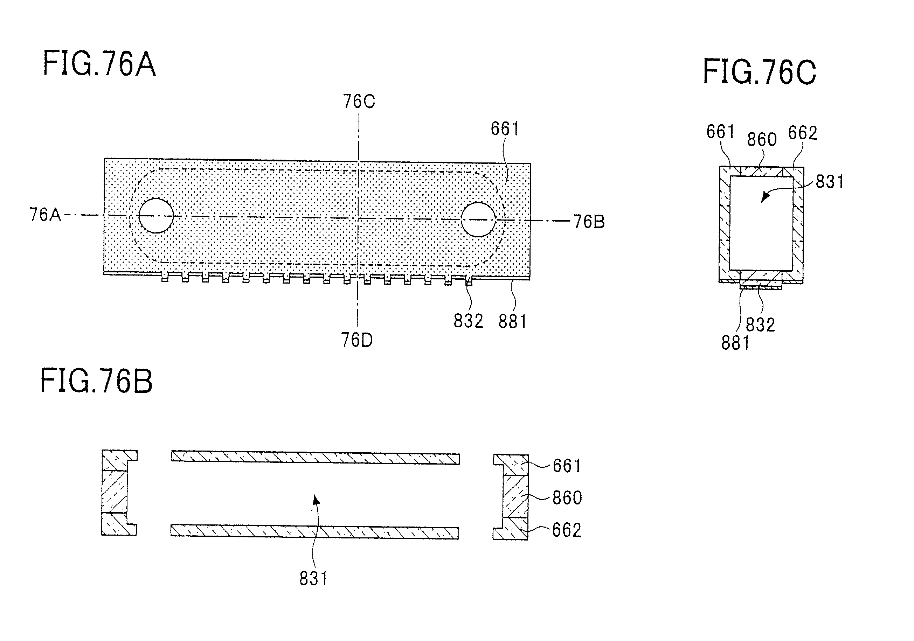

Next, a gold-plated layer 881 is formed on the projection 832 formed surface of the central substrate 860 as illustrated in FIGS. 76A to 76C. As illustrated in FIG. 76A, the gold-plated layer 881 is formed over the entire surface of the central substrate 860 on which projections 832 are formed. Specifically, after a Ti/Au film is deposited by sputtering on the projection 832 formed surface of the central substrate 860, the projection 832 formed surface of the central substrate 860 having deposited the Ti/Au film is subjected to electroless plating, thereby forming the gold-plated layer 881 having a thickness range of 2 to 2.5 $\mu$m over the entire projection 832 formed surface of the central substrate 860. The microchannel heat sink 830 serving as the cooling device according to the seventh embodiment is formed in this manner. Note that FIG. 76A is a top view illustrating the central substrate 860 undergoing the above-described fabrication process, FIG. 76B is a sectional view taken along a dash-dot line 76A-76B of FIG. 76A, and FIG. 76C is a sectional view taken along a dash-dot line 76C-76D of FIG. 76A.

Thus, the microchannel heat sink 830 serving as the cooling device according to the seventh embodiment is formed in the above-described manner.

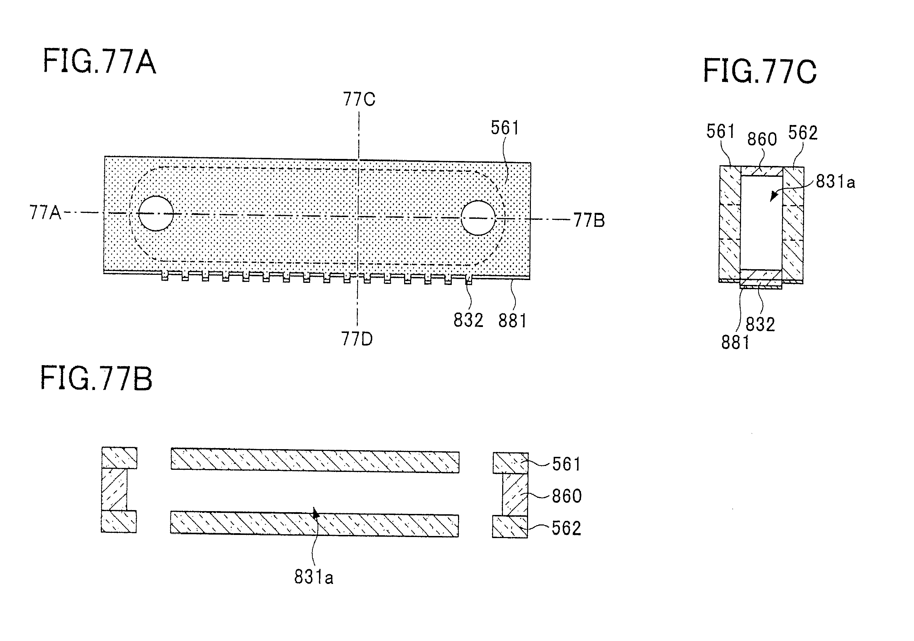

Further, the central substrate 860 may be bonded with the side substrates 561 and 562 illustrated in FIGS. 43A to 43C one on each surface of the central substrate 860 as illustrated in FIGS. 77A to 77C (i.e., another cooling device according to the seventh embodiment). With this configuration, a channel 831a formed may include a narrow cross section in a direction of which the coolant is running. However, since a fabrication method of the side substrates is simpler, the microchannel heat sink may be fabricated at low cost. Note that FIG. 77A is a top view illustrating the silicon substrate undergoing the above-described fabrication process, FIG. 77B is a sectional view taken along a dash-dot line 77A-77B of FIG. 77A, and FIG. 77C is a sectional view taken along a dash-dot line 77C-77D of FIG. 77A.

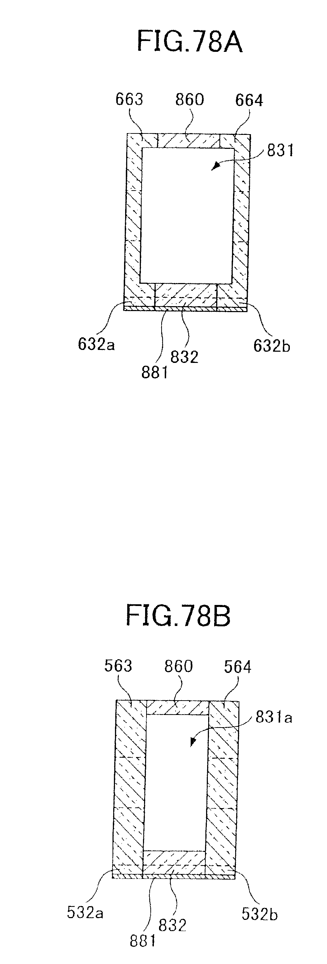

In the cooling device according to the modification of the seventh embodiment, the example of the microchannel heat sink 830 having the side substrates on which a projection is not formed is illustrated; however, the microchannel heat sink 830 may have the side substrates on which the projections are not formed, as illustrated in FIGS. 78A and 78B (i.e., another cooling device according to the seventh embodiment). Specifically, projections similar to the projections 832 formed in the central substrate 860 may be formed on the respective side substrates 663 and 664 as illustrated in FIG. 78A. That is, the side substrate 663 having projections 632a on its surface and the side substrate 664 having projections 632b on its surface may be formed corresponding to the projections 832 formed on the central substrate 860. The central substrate 860 is then bonded with the side substrates 663 and 664 one on each surface of the central substrate 860. Thereafter, a gold-plated layer 881 may be formed on surfaces of the central substrate 860 and the side substrates 663 and 664 on which the respective projections 832, 632a and 632b are formed. Thus, the microchannel heat sink 830 serving as the cooling device according to the seventh embodiment may also be formed in the above-described manner.

Further, projections similar to the projections 832 formed on the central substrate 860 may be formed on the respective side substrates 563 and 564 as illustrated in FIG. 78B. That is, the side substrate 563 having projections 532a on its surface and the side substrate 564 having projections 532b on its surface may be formed corresponding to the projections 832 formed on the central substrate 860. The central substrate 860 is then bonded with the side substrates 563 and 564 one on each surface of the central substrate 860. Thereafter, a gold-plated layer 881 may be formed one on each surface of the central substrate 860 and the side substrates 5563 and 564 on which the respective projections 832, 532a and 532b are formed. Thus, the microchannel heat sink 830 serving as the cooling device according to the seventh embodiment may also be formed in the above-described manner.

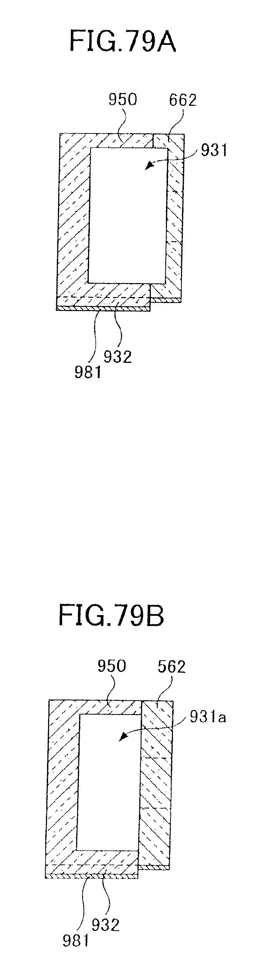

Further, the above example describes that one central substrate and two side substrates form one channel in the microchannel heat sink 830. However, the channel may include a central substrate 950 having a recess in its one side surface only as illustrated in FIGS. 79A and 79B. Specifically, a channel 931 may be formed by bonding a side substrate 662 with the recess formed surface of the central substrate 950 such that the recess formed surface of the central substrate 950 faces a recess formed surface of the side substrate 662 as illustrated in FIG. 79A. Alternatively, a channel 931a may be formed by bonding a side substrate 562 with the recess formed surface of the central substrate 950 such that the recess formed surface of the central substrate 950 faces a non-recess formed surface of the side substrate 562 as illustrated in FIG. 79B. Note that a projection 932 is formed on the central substrate 950 and a gold-plated layer 981 is formed over the respective surfaces of the central substrate 950 and the side substrate 562 on the projection 932 formed side of the central substrate 950.

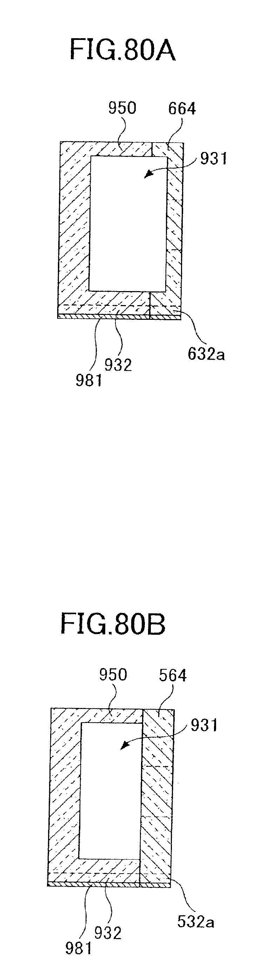

Further, in this case, a side substrate 664 including a recess 632a illustrated in FIG. 80A may be used as the side substrate , or a side substrate 564 including a recess 532a illustrated in FIG. 80B may be used as the side substrate. Note that, similarly, a projection 932 may be formed on the central substrate 950 and a gold-plated layer 981 may be formed over the respective surfaces of the central substrate 950 and the side substrate 632a (FIG. 80A) or 532a (FIG. 80B) on the projection 932 formed side of the central substrate 950 (i.e., another cooling device according to the seventh embodiment).

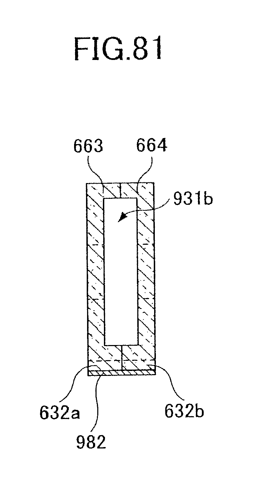

Alternatively, a channel 931b may be formed by bonding the side substrates 663 and 664 each having a recess such that the recesses of the side substrates 663 and 664 face each other as illustrated in FIG. 81. In this case, the channel 931b may be formed of the recess of the side substrate 663 and the recess of the side substrate 664. Further, since the side substrate 663 includes projections 632a and the side substrate 664 includes projections 632b, it may be possible to fabricate a microchannel heat sink similar to those described above. Note that after the side substrates 663 and 664 are bonded, a gold-plated layer 982 may be a gold-plated layer 982 may be formed over the respective end surfaces of the side substrates 663 and 664 on which the projections 632a and 632b are formed (i.e., another cooling device according to the seventh embodiment).

The configuration and a fabrication method of the semiconductor device and the cooling device according to the seventh embodiment other than those described above are similar to those of the semiconductor device and the cooling device according to the fourth to sixth embodiments. Further, the microchannel heat sink 830 serving as the cooling device according to the seventh embodiment may be incorporated into a semiconductor device similar to the semiconductor device according to the fourth embodiment, and hence, the semiconductor device having the cooling device according to the seventh embodiment may be fabricated in this manner.

In the semiconductor device and the cooling device according to the above-described embodiments, the semiconductor device including the semiconductor chip that generates a large amount of heat may be effectively cooled, which may prevent the semiconductor chip temperature from rising. Further, in the method for fabricating the cooling device according to the above-described embodiments, the cooling device may be fabricated in an uncomplicated manner.

The embodiments described so far are not limited thereto. Various modifications or alterations may be made within the scope of the inventions described in the claims.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority or inferiority of the invention. Although the embodiments of the present invention have been described in detail, it should be understood that the various changes, substitutions, and alterations could be made hereto without departing from the spirit and scope of the invention.

**Claims**

1. A semiconductor device comprising:

   a semiconductor chip including an electric circuit; and
   a cooling device including at least one channel serving as a flow path through which coolant flows, an external surface including a plurality of projections and a metallic layer formed over the external surface including the projections, **characterized in that**
   the projections of the external surface of the cooling device are brought into contact with a first surface of the semiconductor chip via the metallic layer such that the semiconductor chip is cooled by allowing the coolant to flow through the channel formed inside the cooling device.

**2.** The semiconductor device as claimed in claim 1, **characterized in that**
the cooling device includes two or more of the channels that are aligned in parallel with one another.

**3.** The semiconductor device as claimed in claim 2, **characterized in that**
the cooling device further includes a common channel inlet configured to supply the coolant into the channels and a common channel outlet configured to discharge the coolant from the channels, the common channel inlet and the common channel outlet being shared by the channels, and
the common channel inlet is arranged on a first end of the channels and the common channel outlet is arranged on a second end of the channels.

**4.** The semiconductor device as claimed in claim 2, **characterized in that**
the cooling device further includes channel inlets configured to supply the coolant into the respective channels and channel outlets configured to discharge the coolant from the respective channels, the channel inlets being arranged on respective first ends of the channels and the channel outlets being arranged on respective second ends of the channels, and
the coolant inside one of the channels and the coolant inside the other one of the channels flow in opposite directions.

**5.** The semiconductor device as claimed in claim 2 or 3, **characterized in that**
the cooling device further includes a sub-channel via which the channels are connected.

**6.** The semiconductor device as claimed in any one of claims 1 to 4, **characterized in that**
the cooling device includes two or more substrates at least one of which includes a recess, and
the substrates are bonded in surface directions of the substrates such that the at least one channel is formed between the recess formed in one of the substrates and the other one of the substrates facing the recess.

**7.** The semiconductor device as claimed in claim 6, **characterized in that**
the cooling device further includes channel inlets configured to supply the coolant into the respective channels and channel outlets configured to discharge the coolant from the respective channels, the channel inlets being arranged on respective first ends of the channels and the channel outlets being arranged on respective second ends of the channels, and
the channel inlets and the channel outlets are formed of holes formed in at least one of the substrates in directions perpendicular to the surface directions of the substrates.

**8.** The semiconductor device as claimed in any one of claims 1 to 7, **characterized in that**
a second surface of the semiconductor chip comes into contact with a package made of metal.

**9.** The semiconductor device as claimed in any one of claims 1 to 8, **characterized in that**
the projections of the external surface of the cooling device are arranged at positions corresponding to electrodes formed on the first surface of the semiconductor chip.

**10.** The semiconductor device as claimed in claim 9, **characterized in that**
the electrodes formed on the first surface of the semiconductor chip serve as source electrodes,
the source electrodes formed on the first surface of the semiconductor chip are electrically coupled with the metallic layer formed over the projections of the external surface of the cooling device, and
the metallic layer formed over the projections of the external surface of the cooling device is grounded.

**11.** A cooling device comprising:

a channel formed as a flow path through which coolant having fluidity flows;
an external surface including a plurality of projections; and
a metallic layer formed over the external surface including the projections, **characterized in that**
a component attached to the projections of the external surface of the cooling device via the metallic layer is cooled by allowing the coolant to flow through the channel formed thereinside.

**12.** A method for fabricating a cooling device, the method comprising:

forming a lower part of the cooling device by forming a first surface including an opening region serving as a channel along a longitudinal direction of a substrate having an approximately quadrangular prism configuration and forming a second surface including a plurality of projections opposite to the first surface of the substrate; forming an upper part of the cooling device by forming a first opening region and a second opening region in a substrate respectively serving as a channel inlet configured to supply coolant into the channel and a channel outlet configured to discharge the coolant from the channel; bonding the formed lower part of the cooling device with the formed upper part thereof; and forming a metallic layer over the second surface including the projections of the substrate.

13. A method for fabricating a cooling device, the method comprising:

forming a recess serving as a channel in one of a first surface of a central substrate and a surface of a first side substrate, the first surface of the central substrate being bonded with the surface of the first side substrate; forming a side surface including a plurality of projections of the central substrate; and forming a first hole for supplying coolant into the channel and a second hole for discharging the coolant from the channel in the first side substrate; bonding the first surface of the central substrate and the surface of the first side substrate such that the channel is formed by the recess formed in the one of the first surface of the central substrate and the surface of the first side substrate and the other one of the first surface of the central substrate and the surface of the first side substrate that faces the recess; and forming a metallic layer over the side surface including the projections of the central substrate and a side surface of the first side substrate on a same side as the side surface including the projections of the central substrate.

14. The method as claimed in claim 13, further comprising:

bonding a second side substrate with a second surface of the central substrate while bonding the first side substrate with the first surface of the central substrate, **characterized in that** the recess is formed both in the surface of the first side substrate and a surface of the second side substrate, and a first channel is formed by the recess formed in the surface of the first side substrate and the first surface of the central substrate that faces the recess formed in the surface of the first side substrate, and a second channel is formed by the recess formed in the surface of the second side substrate and the second surface of the central substrate that faces the recess formed in the surface of the second side substrate.

15. The method as claimed in claim 13, further comprising:

bonding a second side substrate with a second surface of the central substrate while bonding the first side substrate with the first surface of the central substrate, **characterized in that** the recess is formed both in the surface of the first side substrate and a surface of the second substrate, and a hollow is formed by penetrating a region of the central substrate corresponding to the recess formed in the surface of the first side substrate and the recess formed in the surface of the second side substrate, and the channel is formed of the hollow formed in the region of the central substrate, the recess formed in the surface of the first side substrate and the recess formed in the surface of the second side substrate.

# FIG.1A

EP 2 466 637 A2

FIG.1B

# FIG.2

EP 2 466 637 A2

FIG.3

# FIG.4

EP 2 466 637 A2

EP 2 466 637 A2

FIG.5A

FIG.5B

FIG.6A

6A

51a

52

51

53

51b

6B

FIG.6B

51a

52

51

51b

53

EP 2 466 637 A2

FIG.7A

54

7A

51a

54
52
51

53

51b

55

7B

FIG.7B

51a

54
52
51

51b

53
55

EP 2 466 637 A2

FIG.8A

FIG.8B

EP 2 466 637 A2

FIG.9A

52a

9A
51a
52a
51
51b
53a
9B

FIG.9B

51a
52a
51
51b
53a

EP 2 466 637 A2

**FIG.10A**

**FIG.10B**

FIG.11A

FIG.11B

FIG.12A

FIG.12B

EP 2 466 637 A2

FIG.13A

EP 2 466 637 A2

FIG.13B

EP 2 466 637 A2

FIG.14A

FIG.14B

FIG.15A

71a

15A

72
71

FIG.15B

72
71a      71

EP 2 466 637 A2

FIG.16A

FIG.16B

FIG.16C

FIG.17A

71a

17A    17C

73
72a
71

17B    17D

73
72a
71

71a

FIG.17B

73
72a
71

71a

FIG.17C

EP 2 466 637 A2

FIG.18A

FIG.18B

FIG.18C

71a

72a
71

18C

18A

18D

18B

71

71a

72a
71

71a

72a
71

FIG.19A

FIG.19B

FIG.19C

EP 2 466 637 A2

FIG.20A

20A   20C
          75
                                          72a
                                          71
                                          74

20B   20D

        75
              72a
              71
              74

FIG.20B

              72a
              71
              74

FIG.20C

EP 2 466 637 A2

EP 2 466 637 A2

FIG.21A

21A    21C    70
75
71

21B    21D

70

71

FIG.21B

75    70

71

FIG.21C

FIG.22A

FIG.22B

FIG.22C

EP 2 466 637 A2

FIG.23A

FIG.23B

FIG.23C

FIG.24

EP 2 466 637 A2

FIG.25

234b

230

32

234a

OUT

IN

231

FIG.26

334b

330

32

334a

OUT

IN

331b    331a    336

FIG.27A

EP 2 466 637 A2

# FIG.27B

FIG.28

EP 2 466 637 A2

FIG.29

FIG.30A

551

550

FIG.30B

551

560(550)

552

530

FIG.30C

551      531a

561

560(550)

562

552      531b

FIG.31C

FIG.31A

FIG.31B

FIG.32A

32C  32E

573

32A —

—32B

32D  32F

FIG.32C

571 550 572

573      574

FIG.32D

571 550 572

573      574

EP 2 466 637 A2

FIG.32B

573

574

571

550

572

FIG.33A

FIG.33C FIG.33D

FIG.33B

EP 2 466 637 A2

EP 2 466 637 A2

FIG.34A

FIG.34C FIG.34D

FIG.34B

FIG.35A

FIG.35C    FIG.35D

FIG.35B

EP 2 466 637 A2

FIG.36A

575　36C　36E　571

36A —

36C 36E
36D 36F

FIG.36B

576　575　576

571
550
572

577

FIG.36C

571 550 572

575　577
576

FIG.36D

571 550 572

575　577

EP 2 466 637 A2

FIG.37A

575    37C  37E    571

37A—    —37B

37D  37F

FIG.37B

576    575    576    571
550
572
578    577    578

FIG.37C

571 550 572

575    577
576  578

FIG.37D

571 550 572

575    577

EP 2 466 637 A2

FIG.38A

FIG.38C    FIG.38D

38C  38E

571

571 550 572    571 550 572

38A

38B

576 578

38D  38F

FIG.38B

576    576

571
550
572

578    578

EP 2 466 637 A2

FIG.39A

FIG.39B

FIG.39C

FIG.39D

EP 2 466 637 A2

FIG.40D

FIG.40C

FIG.40A

FIG.40B

## FIG.41A

## FIG.41B

## FIG.41C

## FIG.41D

EP 2 466 637 A2

FIG.42A

42C

591

42A

42B

42D

FIG.42B

591
561

FIG.42C

555

591

EP 2 466 637 A2

FIG.43A

FIG.43C

FIG.43B

EP 2 466 637 A2

FIG.44A

FIG.44B

FIG.44C

FIG.45C

FIG.45A

FIG.45B

# FIG.46A

# FIG.46B

# FIG.47A

# FIG.47B

# FIG.48

# FIG.49

FIG.50A

FIG.50C

FIG.50B

## FIG.51A

## FIG.51C

## FIG.51B

EP 2 466 637 A2

## FIG.52A

52C

671

52A

52B

52D

## FIG.52C

671 650 672

## FIG.52B

671
650
672

EP 2 466 637 A2

FIG.53A

FIG.53B

FIG.53C

## FIG.54A

## FIG.54B

## FIG.54C

# FIG.55A

# FIG.55C

# FIG.55B

EP 2 466 637 A2

FIG.56D

FIG.56C

FIG.56A

FIG.56B

671 650 672
692
651

671 650 672
651

56B

671
692
56E
56F
56C
56D
651
693
56A

671
650
672
676
692
651
693
676

81

FIG.57D

661(650)

692

651

FIG.57C

661(650)

651

FIG.57A

661(650)

57E

57B

692

57C

57D

651

693

57A

57F

FIG.57B

661(650)

692

651

693

FIG.58C

FIG.58A

FIG.58B

EP 2 466 637 A2

## FIG.59A

693    59C    692
                    661

59A                      59B

581  532
59D

## FIG.59C

661  550  662

531a          531b

532
581

## FIG.59B

693    531a              692

                          661
                          550
                          662

531b

# FIG.60

663    560    664

631a                    631b

632a                    632b

681    532

# FIG.61

<u>730</u>

661    760    662

731a                    731b

781    732

## FIG.62A

771

## FIG.62C

750

771

## FIG.62B

771

750

EP 2 466 637 A2

## FIG.63A

773

## FIG.63C

771 750

773

## FIG.63B

773

771

750

EP 2 466 637 A2

EP 2 466 637 A2

FIG.64A

771

FIG.64C

771 750

FIG.64B

771
750

FIG.65A

FIG.65C

FIG.65B

771

771 750

732

771
750

732

EP 2 466 637 A2

FIG.66A

760(750)

732

FIG.66C

760(750)

732

FIG.66B

760(750)

732

FIG.67A

661

732

FIG.67C

661 760 662

731a 731b

651 652

732

FIG.67B

731a 651

661

760(750)

662

731b 652

EP 2 466 637 A2

FIG.68A

FIG.68B

FIG.68C

# FIG.69

663    760    664

731a          731b

632a          632b

732
781

# FIG.70

830

661    860    662

831

832
881

# FIG.71A

# FIG.71C

71C

871

850

71A — 71B

871

71D

# FIG.71B

871

850

EP 2 466 637 A2

EP 2 466 637 A2

FIG.72A

FIG.72B

FIG.72C

95

FIG.73A

73A

851

871

73C

73D

73B

FIG.73B

851

871
850

FIG.73C

851

871 850

832

FIG.74A

FIG.74B

FIG.74C

FIG.75A

FIG.75B

FIG.75C

FIG.76A

FIG.76B

FIG.76C

EP 2 466 637 A2

FIG.77A

FIG.77B

FIG.77C

## FIG.78A

## FIG.78B

# FIG.79A

# FIG.79B

# FIG.80A

950    664

931

932

981

632a

# FIG.80B

950    564

931

932

981

532a

# FIG.81

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 7112036 A
- JP 7112036 B
- JP 2008160019 A
- JP 2009522808 A
- JP 2009522808 T